(19) Europäisches Patentamt
European Patent Office
Office européen des brevets

(11) EP 1 771 036 A2

(12) **EUROPEAN PATENT APPLICATION**

(43) Date of publication:
**04.04.2007 Bulletin 2007/14**

(51) Int Cl.:
***H04R 19/00*** *(2006.01)*

(21) Application number: **06020022.7**

(22) Date of filing: **25.09.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **26.09.2005 JP 2005277377**
**06.02.2006 JP 2006028439**
**29.03.2006 JP 2006089680**
**30.03.2006 JP 2006094414**
**22.08.2006 JP 2006224978**

(71) Applicant: **YAMAHA CORPORATION**
**Hamamatsu-shi**
**Shizuoka-ken (JP)**

(72) Inventors:
- **Suzuki, Yukitoshi**
**Hamamatsu-shi**
**Shizuoka-ken (JP)**
- **Hirade, Seiji**
**Hamamatsu-shi**
**Shizuoka-ken (JP)**
- **Suzuki, Tamito**
**Hamamatsu-shi**
**Shizuoka-ken (JP)**
- **Sakakibara, Shingo**
**Hamamatsu-shi**
**Shizuoka-ken (JP)**
- **Terada, Takahiro**
**Hamamatsu-shi**
**Shizuoka-ken (JP)**

(74) Representative: **Wagner, Karl H.**
**WAGNER & GEYER**
**Patentanwälte**
**Gewürzmühlstrasse 5**
**80538 München (DE)**

(54) **Capacitor microphone and diaphragm therefor**

(57) In a capacitor microphone, a diaphragm is positioned opposite to a fixed electrode for covering inner holes of a ring-shaped support, wherein when the diaphragm is deflected to approach the fixed electrode due to electrostatic attraction upon application of a bias voltage, internal stress that occurs on the diaphragm is canceled by compressive stress that is applied to the diaphragm in advance. The diaphragm is formed using a multilayered structure including a first thin film and a second thin film whose internal stress differs from the internal stress of the first thin film, thus adjusting the total internal stress thereof. The diaphragm can be formed in such a way that a center layer having a single-layered structure is sandwiched between first and second coating layers having controlled residual tensions and resistance against hydrofluoric acid.

FIG. 2

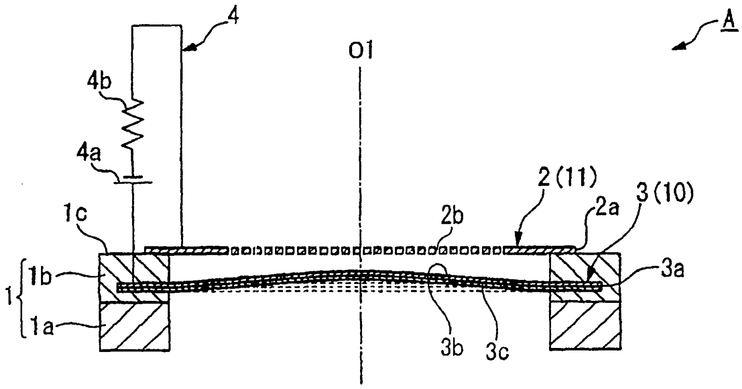


EP 1 771 036 A2

## Description

### BACKGROUND OF THE INVENTION

#### Field of the Invention

The present invention relates to capacitor microphones using diaphragms, which are produced by way of manufacturing processes of semiconductor devices. The present invention also relates to diaphragms and manufacturing methods of diaphragms.

This application claims priority on five Japanese patent applications, i.e., Japanese Patent Application No. 2006-89680, Japanese Patent Application No. 2005-277377, Japanese Patent Application No. 2006-28439, Japanese Patent Application No. 2006-94414, and Japanese Patent Application No. 2006-224978, the contents of which are incorporated herein by reference.

#### Description of the Related Art

Conventionally, a variety of capacitor microphones have been produced by way of manufacturing processes of semiconductor devices. For example, Japanese Patent Application Publication No. 2004-506394 and U.S. Patent No. 5,452,268 teach examples of capacitor microphones. These capacitor microphones are constituted using conductive diaphragms (or vibration sheets) and back plates having through holes (or bores), which are supported by way of substrates in parallel with diaphragms with air gaps therebetween. In this type of capacitor microphone, a bias voltage is applied between the diaphragm and back plate so that the diaphragm is electrically attracted toward the back plate, wherein the sensitivity is improved by maintaining a certain air gap between the diaphragm and back plate.

Due to the high-temperature formation of conductive films serving as diaphragms in capacitor microphones that are produced by way of manufacturing processes of semiconductor devices, internal stress acting as tensile stress may occur as conductive films are cooled down. For this reason, in this type of capacitor microphone, the diaphragm is attached to the substrate via a plurality of springs so as to mechanically separate the diaphragm from the substrate, wherein tensile stress applied to the diaphragm is reduced by means of springs.

Japanese Patent Application Publication No. 2002-325298 teaches a capacitor microphone in which corrugated portions are entirely formed on a diaphragm (or a vibration sheet) composed of a thermoplastic resin film, and the diaphragm has projections opposite to a back plate (or a back electrode plate) in the outer periphery thereof along the inner periphery of a support ring so as to realize flexibility in advance. Upon application of a bias voltage, the diaphragm is attracted to the back plate so that, due to tensile stress, the corrugated portions are stretched to be planar and thus disappear. Due to the stretching of the corrugated portions of the diaphragm, it is possible to reduce tensile stress applied to the diaphragm, which is attracted to the back plate, so that the diaphragm is installed in the capacitor microphone with relatively low stiffness. This improves vibration characteristics and sensitivity of the capacitor microphone.

In the capacitor microphone in which the diaphragm is attached to the substrate via a plurality of springs, it may be possible to reduce tensile stress applied to the diaphragm by way of elasticity of springs; however, it is very difficult to eliminate tensile stress. That is, when the diaphragm is attracted to the back plate upon application of a bias voltage, tensile stress may increase due to the deflection of the diaphragm so that the stiffness of the diaphragm becomes high. This degrades vibration characteristics and sensitivity of the capacitor microphone.

In the capacitor microphone in which the corrugated portions are formed on the diaphragm composed of the thermoplastic resin film, the corrugated portions are stretched and disappear so as to eliminate the tensile stress when deflection occurs in the diaphragm upon application of a bias voltage. However, since the diaphragm is composed of the thermoplastic resin film having a relatively high thermal expansion coefficient, there is a possibility that vibration characteristics may greatly alter in response to temperature variations. That is, when the capacitor microphone having the aforementioned diaphragm is subjected to reflow packaging, for example, heat at a temperature of about 250°C is exerted on the diaphragm so that the diaphragm composed of the thermoplastic resin film is deformed, thus degrading vibration characteristics and sensitivity. In addition, it is difficult to produce the diaphragm having the corrugated portions with a required precision. This makes it difficult to downsize the diaphragm and the capacitor microphone.

Capacitor microphones and acceleration sensors have been produced by way of manufacturing processes of semiconductor devices, wherein each of the capacitor microphones is designed such that a plate having an electrode is separated from a diaphragm, which can vibrate in response to sound waves, via an insulating spacer so as to convert capacitance variations (caused by the displacement of the diaphragm) into electric signals. For this reason, the internal stress of the diaphragm should be appropriately controlled in order to improve the sensitivity. In a capacitor microphone taught in the document entitled "MSS-01-34" published by the Institute of Electric Engineers in Japan, the sensitivity is degraded due to a reduction of the vibration amplitude of the diaphragm when tensile stress remains in the diaphragm, while the sensitivity is also degraded due to the deflection of the diaphragm when compressive stress remains in the diaphragm.

Conventionally, when the diaphragm is formed by way of deposition such as LPCVD (Low Pressure Chemical Vapor Deposition), the internal stress of the diaphragm is adjusted by appropriately setting conditions for annealing performed after deposition. However, a high precision cannot be always secured for the controlling of the internal stress upon setup of annealing conditions. For this reason, annealing conditions are set up in such a way that either the tensile stress or the compressive stress internally remains in the diaphragm.

In a capacitor microphone taught in Japanese Patent Application Publication No. 2004-506394 in which one end of a diaphragm is a free end, it is possible to reduce an effect of the internal stress of the diaphragm applied on the sensitivity. However, it needs a complicated support structure for the diaphragm; hence, the manufacturing yield is not so high, and the manufacturing cost is increased.

In the conventionally-known capacitor microphone, the plate and the diaphragm, which act as opposite electrodes of a capacitor, are positioned to directly face each other via an air space called a pressure chamber. When dewing occurs between the plate and the diaphragm, leak currents occur between the opposite electrodes, which may be short-circuited. Due to the short-circuiting, failure may occur in the circuitry, or the circuitry is destroyed by sparking.

In the manufacturing processes of diaphragms used for the Micro Electronics Mechanical System (MEMS) such as capacitor microphones and acceleration sensors, wet etching is performed to remove sacrificing layers composed of $SiO_2$ formed in the peripheral areas of diaphragms by use of hydrofluoric acid; hence, diaphragms are composed of prescribed materials having relatively high resistance against hydrofluoric acid. In other words, it is very difficult to improve mechanical characteristics or electric characteristics when diaphragms are composed of materials having relatively low resistance against hydrofluoric acid.

Japanese Patent Application Publication No. 2002-518913 teaches an electrostatic capacitance sensor, which is used for a pressure sensor and a microphone. The electrostatic capacitance sensor has a diaphragm and a plate, which act as opposite electrodes of a capacitor, wherein the displacement of the diaphragm due to a force applied thereto is converted into electric signals. That is, the electrostatic capacitance sensor operates upon application of a bias voltage, wherein variations of electrostatic capacitance due to the displacement of the diaphragm are output as variations of voltage.

When the diaphragm and plate are composed of doped polycrystal silicon, which is a generally-known material used for semiconductor manufacturing processes, relatively high tensile stress may be accumulated therein. Since the sensitivity increases as the displacement of the diaphragm increases, it is preferable that the tension depending on the internal stress of the diaphragm be reduced to as small as possible. In order to prevent the diaphragm and plate from being closely attracted to each other due to electrostatic attraction, it is preferable that the rigidity of the plate be increased to as high as possible because the rigidity may highly depend upon the internal stress of the plate.

SUMMARY OF THE INVENTION

It is an object of the present invention to provide a capacitor microphone having a diaphragm, in which tensile stress is eliminated so as to improve vibration characteristics and sensitivity, in which a satisfactory sensitivity is realized upon application of a relatively low bias voltage so as to save electricity and to reduce the manufacturing cost.

It is another object of the present invention to provide a capacitor microphone having a diaphragm whose internal stress is controlled at a high precision, wherein by avoiding the occurrence of leak currents and short-circuiting between opposite electrodes of a capacitor, the performance of the capacitor microphone is stabilized so as to provide a high sensitivity.

It is a further object of the present invention to provide a capacitor microphone having a diaphragm whose tension is controlled at a high precision and which is composed of a prescribed material having relatively high resistance against hydrofluoric acid.

It is a further object of the present invention to provide a electrostatic capacitance sensor in which a diaphragm and a plate are optimized in terms of internal stress.

In a first aspect of the present invention, a diaphragm is positioned opposite to a fixed electrode for covering a plurality of inner holes of a ring-shaped support with a prescribed air gap therebetween in a capacitor microphone, wherein compressive stress is applied to the diaphragm in advance, so that when the diaphragm is deflected to approach the fixed electrode due to the electrostatic attraction caused by applying a bias voltage between the fixed electrode and diaphragm, internal stress that occurs on the diaphragm is eliminated.

It is preferable that the diaphragm be formed by laminating a tensile stress film having tensile stress and a compressive stress film having compressive stress.

It is preferable that the tensile stress film be composed of a polycrystal silicon film, into which impurities are doped, and the compressive stress film be composed of a polycrystal silicon film or a non-crystal silicon film, into which no impurity is doped.

According to the manufacturing method for a capacitor microphone in which a diaphragm is positioned opposite to a fixed electrode for covering a plurality of inner holes of a ring-shaped support with a prescribed air gap therebetween, a conductive film serving as the diaphragm is subjected to annealing, and compressive stress is applied to the diaphragm in advance, wherein when the diaphragm is deflected to approach the fixed electrode due to the electrostatic attraction caused by applying a bias voltage between the fixed electrode and the diaphragm, internal stress that occurs on the diaphragm is eliminated.

In the above, annealing is performed independently on the impurities-doped polycrystal silicon film and is performed independently on the no-impurity-doped polycrystal silicon film or the no-impurity-doped non-crystal silicon film. Alternatively, annealing is performed on a laminated structure composed of the impurities-doped polycrystal silicon film and the no-impurity-doped polycrystal silicon film or the no-impurity-doped non-crystal silicon film.

A capacitor microphone is constituted using the fixed electrode and diaphragm described above, wherein compressive stress is applied to the diaphragm in advance, so that when the diaphragm is deflected to approach the fixed electrode due to the electrostatic attraction caused by applying a bias voltage between the fixed electrode and diaphragm, internal stress that occurs on the diaphragm is eliminated.

As described above, tensile stress that occurs on the diaphragm being deflected to approach the fixed electrode is canceled by the compressive stress applied to the diaphragm in advance. Therefore, it is possible to reduce the stiffness of the diaphragm; and it is possible to improve vibration characteristics of the diaphragm, thus improving the sensitivity of the capacitor microphone. Due to the compressive stress applied to the diaphragm in advance, it is possible to reduce the bias voltage, thus improving the sensitivity of the capacitor microphone. In addition, it is possible to save electric energy applied to the capacitor microphone and to reduce the manufacturing cost.

Since the compressive stress is applied to the diaphragm by way of annealing, it is possible to easily control the compressive stress by adjusting the annealing temperature. That is, it is possible to reliably reduce the stiffness of the diaphragm by realizing desired compressive stress of the diaphragm substantially matching the tensile stress that occurs on the diaphragm being deflected to approach the fixed electrode.

When the diaphragm is formed by combining the tensile stress film and the compressive stress film, it is possible to realize desired compressive stress of the diaphragm by adjusting the relationship between the tensile stress and compressive stress or by adjusting the thickness ratio between the tensile stress film and compressive stress film. This secures elimination of the internal stress that occurs on the diaphragm being attracted to the fixed electrode due to the electrostatic attraction upon application of the bias voltage.

In the above, the tensile stress film is composed of an impurities-doped polycrystal silicon film, and the compressive film is composed of a no-impurity-doped polycrystal silicon film or a no-impurity-doped non-crystal silicon film. That is, the diaphragm is formed using conductive films composed of silicon, which is superior in heat resistance and which exhibits small deformation irrespective of high temperature conditions. In reflow packaging, the diaphragm is not deformed at a heating temperature of 250°C. This reliably provides a high-sensitivity capacitor microphone. In addition, the aforementioned diaphragm can be produced by way of semiconductor manufacturing processes; hence, it is possible to downsize the capacitor microphone with ease. Herein, annealing is performed independently on the tensile stress film and the compressive stress film; or annealing is performed on the laminated structure of the tensile stress film and compressive stress film, whereby desired compressive stress is applied to the diaphragm in advance.

In a second aspect of the present invention, a first thin film is formed way of deposition, and then a second thin film whose internal stress differs from internal stress of the first thin film is formed, thus adjusting the total internal stress of a multilayered structure for use in a diaphragm composed of the first thin film and the second thin film.

A single-layered thin film can be adapted to the aforementioned diaphragm having desired functions, wherein it should have chemical, mechanical, and electric characteristics realizing desired functions. It is very difficult to determine processing conditions for controlling the internal stress of the single-layered thin film at a high precision; hence, the manufacturing yield must be reduced in order to form diaphragms having strict requirements and specifications in terms of the internal stress. Instead, a multilayered thin film adapted to the diaphragm is formed using a plurality of thin films, which compensate for each other in terms of the requirements and specifications. That is, it is preferable to form the diaphragm by use of a multilayered thin film, in which a first thin film realizing required electric characteristics is deposited, and then a second thin film for adjusting the total internal stress at a high precision is formed, thus improving mechanical characteristics regarding the internal stress while satisfying required electric characteristics.

In the above, the first thin film is subjected to annealing so as to reduce the internal stress thereof, and the total internal stress of the multilayered structure is adjusted by controlling the thickness of the second thin film deposited on the surface of the first thin film. It may be possible to reduce or substantially eliminate the internal stress of the first thin film subjected to annealing at a relatively low precision. The second thin film, which is specifically designed to adjust the total internal stress when being deposited on the surface of the first thin film, can sensitively adjust the total internal stress by controlling the thickness thereof. That is, the multilayered structure including the first and second thin films can substantially eliminate the internal stress of the diaphragm.

In manufacturing, the first thin film is subjected to annealing so as to reduce the internal stress thereof, and a part of the second thin film deposited on the surface of the first thin film is subjected to etching, thus adjusting the total internal stress of the multilayered structure.

Alternatively, after the second thin film is deposited on the surface of the first thin film, both of the first and second thin films are simultaneously subjected to annealing, thus adjusting the total internal stress of the multilayered structure.

A diaphragm includes the first thin film and the second thin film, which is attached onto the surface of the first thin film and whose internal stress differs from internal stress of the first thin film, wherein the multilayered structure whose periphery is completely fixed is formed using the first and second thin films.

In the above, the second thin film is narrower than the first thin film and is shaped in a radial manner. This realizes the uniform distribution of the internal stress in which the displacement is made uniform in the circumferential direction of the multilayered structure.

Incidentally, the first thin film is composed of polycrystal silicon, and the second thin film is composed of an insulating material such as a silicon oxide film ($SiO_2$), a silicon nitride film ($Si_3N_4$), a silicon oxide-nitride film (SiON), and an alumina film ($Al_2O_3$).

Alternatively, the first thin film is composed of impurities-doped polycrystal silicon, and the second thin film is composed of no-impurity-doped polysilicon or no-impurity-doped non-crystal silicon (or amorphous silicon).

Thus, a capacitor microphone is realized by combining a plate having a fixed electrode and a plurality of through holes, a diaphragm having a movable electrode, which vibrates in response to sound waves, and a spacer for supporting the plate and the diaphragm to be insulated from each other, thus forming an air gap between the fixed electrode and the movable electrode, wherein the diaphragm includes a first thin film and a second thin film that is attached onto the surface of the first thin film and whose internal stress differs from internal stress of the first thin film, and wherein a multilayered structure whose periphery is completely fixed is formed using the first and second thin films.

In a third aspect of the present invention, a diaphragm includes a center layer having a single-layered structure, a first coating layer attached to the surface of the center layer, and a second coating layer attached to the backside of the center layer. Herein, it is possible to form the diaphragm in a multilayered structure including first and second layers sandwiching a center layer, wherein the center layer realizing desired electric characteristics is sandwiched between the first and second coating layers whose directions of tensions are reverse to the direction of tension applied to the center layer, thus improving mechanical characteristics while satisfying desired electric characteristics. That is, even when a relatively high tension is applied to the center layer, it can be canceled by the tensions of the first and second coating layers, thus greatly reducing the total tension of the diaphragm. By controlling the total tension of the diaphragm at a high precision, it is possible to realize a relatively large displacement adapted to the diaphragm due to sound pressure. In addition, the center layer is sandwiched between the first and second coating layers whose exterior films have resistance against hydrofluoric acid; hence, it is possible to secure chemical characteristics in the diaphragm satisfying desired electric characteristics.

In the above, the direction of tension applied to each of the first and second coating layers is reverse to the direction of tension applied to the center layer. This reduces the total tension of the diaphragm while realizing a relatively large displacement of the diaphragm due to sound pressure. In addition, the sum of the absolute values of the tensions applied to the first and second coating layers is substantially identical to the absolute value of the tension applied to the center layer. This reduces the total tension of the diaphragm to become substantially zero; hence, it is possible to realize a relatively large displacement of the diaphragm due to sound pressure.

Each of the first and second coating layers differs from the center layer in terms of composition. This makes the directions of the tensions of the first and second coating layers to be reverse to the direction of the tension of the center layer. It is possible for both of the first and second coating layers to have the same composition. It is possible for each of the first and second coating layers to have a single-layered structure. This simplifies the overall structure of the diaphragm. In addition, it is possible for each of the first and second coating layers to have resistance against hydrofluoric acid. Since the center layer is sandwiched between the first and second coating layers, the center layer is simply required to have prescribed functions for improving mechanical characteristics and electric characteristics with respect to the diaphragm.

When each of the first and second coating layers is formed in a multilayered structure, it is possible to sensitively control the total tension of the diaphragm. Specifically, each of the first and second coating layers can be formed using a plurality of thin films having sensitively different variations of tensions due to the annealing temperature. This reduces the varying ratio of tension for the annealing temperature within a target range of tension of the diaphragm; thus, it is possible to sensitively adjust the total tension of the diaphragm by way of annealing. When the exterior films of the first and second coating layers sandwiching the center layer are composed of prescribed materials having resistance against hydrofluoric acid, other thin films of the first and second coating layers other than the exterior films are simply required to have functions of adjusting tensions with respect to the diaphragm.

In addition, a capacitor microphone includes a plate having a fixed electrode and a plurality of through holes, a diaphragm having a movable electrode, which vibrates due to sound waves, and a spacer for supporting the plate and the diaphragm with an air gap between the fixed electrode and the movable electrode, wherein the diaphragm has the aforementioned composition and structure.

Furthermore, the aforementioned diaphragm is manufactured in such a way that a first coating layer is formed by way of deposition; a center layer, which has a single-layered structure and in which the direction of the tension applied thereto is reverse to the direction of the tension applied to the first coating layer, is formed on the first coating layer; a second coating layer, in which the direction of the tension applied thereto is reverse to the direction of the tension applied to the center layer, is formed on the center layer, wherein the total tension is adjusted by the first coating layer and the second coating layer sandwiching the center layer. Herein, each of the first and second coating layers and the center layer is controlled in thickness so as to adjust the total tension of the diaphragm.

In the above, all of the first and second coating layers and the center layer are simultaneously subjected to annealing, thus adjusting the total tension of the diaphragm. This simplifies the manufacturing process of the diaphragm.

In a fourth aspect of the present invention, there is provided a manufacturing method for an electrostatic capacitance sensor in which a first film serving as a diaphragm having a movable electrode is deposited and is then subjected to annealing at a first temperature, thereafter, a second film serving as a plate having a fixed electrode positioned opposite to the movable electrode is deposited. Crystal defects inherently exist in deposited films to cause internal stresses, whereas they can be repaired by way of heating; hence, the internal stress can be controlled by controlling the heating temperature and heating time. In the above, the first and second films serving as the diaphragm and plate are processed by way of different annealing processes, thus producing a difference between the internal stresses of the diaphragm and plate. That is, the internal stress of the diaphragm is reduced to be lower than the internal stress of the plate.

In the above, after completion of the deposition of the second film serving as the plate, the first and second films are subjected to annealing at a second temperature, whereby the internal stress of the plate is controlled. In addition, the second temperature is lower than the first temperature. Generally speaking, the internal stress becomes lower as the annealing temperature becomes higher within a prescribed range of temperature. Since the plate is heated at a relatively low temperature in comparison with the diaphragm, which is heated twice, it is possible to increase the internal stress of the plate to be higher than the internal stress of the diaphragm.

In addition, a silicon oxide film is formed between the first and second films and is then divided into individual chips, thereafter, both of the first and second films are subjected to annealing at a second temperature, which is lower than the first temperature. When the silicon oxide film is heated at a high temperature, relatively high compressive stress is accumulated in the silicon oxide film. When relatively high compressive stress is accumulated in the silicon oxide film formed on the entire surface of a thin and large work, cracks may occur due to the compressive stress. However, the present invention is designed such that before the silicon oxide film lying between the diaphragm and plate is heated, the silicon oxide film is divided into individual chips; hence, it is possible to avoid the occurrence of cracks.

The silicon oxide film is processed at a third temperature, which is lower than the first temperature and the second temperature. In addition, both of the first and second films can be configured to have the same composition. Both of the first and second films are composed of impurities-diffused polycrystal silicon. For example, both of the first and second films are composed of phosphorus-doped polycrystal silicon.

Furthermore, an electrostatic capacitance sensor is constituted by a diaphragm having a movable electrode, which is formed by way of deposition of a first film, and a plate having a fixed electrode positioned opposite to the movable electrode, wherein the plate is formed by way of deposition of a second film and wherein the diaphragm and the plate are subjected to different heat treatments and are thus adjusted in internal stresses respectively.

## BRIEF DESCRIPTION OF THE DRAWINGS

These and other objects, aspects, and embodiments of the present invention will be described in more detail with reference to the following drawings, in which:

FIG. 1 is a plan view showing a capacitor microphone including a back plate and a diaphragm in accordance with a first embodiment of the present invention;

FIG. 2 is a cross-sectional view showing the constitution of the capacitor microphone;

FIG. 3 is a cross-sectional view showing a first step for manufacturing the capacitor microphone;

FIG. 4 is a cross-sectional view showing a second step for manufacturing the capacitor microphone;

FIG. 5 is a cross-sectional view showing a third step for manufacturing the capacitor microphone;

FIG. 6 is a cross-sectional view showing a fourth step for manufacturing the capacitor microphone;

FIG. 7 is a cross-sectional view showing a fifth step for manufacturing the capacitor microphone;

FIG. 8 is a cross-sectional view showing a sixth step for manufacturing the capacitor microphone;

FIG. 9 is a cross-sectional view showing a seventh step for manufacturing the capacitor microphone;

FIG. 10 is a cross-sectional view showing an eighth step for manufacturing the capacitor microphone;

FIG. 11 is a graph showing the relationship between a tensile stress film and a compressive stress film in terms of the annealing temperature and internal stress;

FIG. 12 is a graph showing the relationship between examples of a diaphragm composed of a compressive stress film and a tensile stress film whose thickness ratio is varied in terms of the annealing temperature and internal stress;

FIG. 13 is a graph showing the relationship between examples of a capacitor microphone using a diaphragm composed of a tensile stress film and a compressive stress film, the internal stress of which is varied, in terms of the bias voltage and sensitivity;

FIG. 14A is a cross-sectional view showing the constitution of a capacitor microphone in accordance with a second embodiment of the present invention;

FIG. 14B is a plan view diagrammatically showing the overall shape of a diaphragm incorporated into the capacitor microphone;

FIG. 15A is a cross-sectional view showing a first step for manufacturing the capacitor microphone in accordance with the second embodiment of the present invention;

FIG. 15B is a cross-sectional view showing a second step for manufacturing the capacitor microphone;

FIG. 15C is a cross-sectional view showing a third step for manufacturing the capacitor microphone;

FIG. 15D is a cross-sectional view showing a fourth step for manufacturing the capacitor microphone;

FIG. 15E is a cross-sectional view showing a fifth step for manufacturing the capacitor microphone;

FIG. 15F is a cross-sectional view showing a sixth step for manufacturing the capacitor microphone;

FIG. 15G is a cross-sectional view showing a seventh step for manufacturing the capacitor microphone;

FIG. 15H is a cross-sectional view showing an eighth step for manufacturing the capacitor microphone;

FIG. 15I is a cross-sectional view showing a ninth step for manufacturing the capacitor microphone;

FIG. 16 is a cross-sectional view showing the constitution of a capacitor microphone in accordance with a first variation of the second embodiment;

FIG. 17A is a cross-sectional view showing the constitution of a capacitor microphone in accordance with a second variation of the second embodiment;

FIG. 17B is a plan view showing an example of a diaphragm incorporated into the capacitor microphone shown in FIG. 17A;

FIG. 17C is a plan view showing an example of the diaphragm incorporated into the capacitor microphone shown in FIG. 17A;

FIG. 18A is a plan view showing an example of the diaphragm incorporated into the capacitor microphone shown in FIG. 17A;

FIG. 18B is a plan view showing an example of the diaphragm incorporated into the capacitor microphone shown in FIG. 17A;

FIG. 19A is a cross-sectional view showing the constitution of a capacitor microphone in accordance with a third variation of the second embodiment;

FIG. 19B is a plan view showing a diaphragm incorporated into the capacitor microphone shown in FIG. 19A;

FIG. 20 is a graph showing the relationship between the annealing temperature and internal stress with respect to silicon materials;

FIG. 21 is a graph showing the relationship between the annealing temperature and internal stress with respect to various phosphorus-doped polycrystal silicon films having different thickness ratios;

FIG. 22 is a graph showing the relationship between the annealing temperature and internal stress with respect to various phosphorus-doped polycrystal silicon films having different thickness ratios;

FIG. 23 is a cross-sectional view showing the constitution of a capacitor microphone in accordance with a third embodiment of the present invention;

FIG. 24A is a cross-sectional view showing a first step for manufacturing the capacitor microphone;

FIG. 24B is a cross-sectional view showing a second step for manufacturing the capacitor microphone;

FIG. 24C is a cross-sectional view showing a third step for manufacturing the capacitor microphone;

FIG. 24D is a cross-sectional view showing a fourth step for manufacturing the capacitor microphone;

FIG. 24E is a cross-sectional view showing a fifth step for manufacturing the capacitor microphone;

FIG. 24F is a cross-sectional view showing a sixth step for manufacturing the capacitor microphone;

FIG. 24G is a cross-sectional view showing a seventh step for manufacturing the capacitor microphone;

FIG. 24H is a cross-sectional view showing an eighth step for manufacturing the capacitor microphone;

FIG. 24I is a cross-sectional view showing a ninth step for manufacturing the capacitor microphone;

FIG. 24J is a cross-sectional view showing a tenth step for manufacturing the capacitor microphone;

FIG. 24K is a cross-sectional view showing an eleventh step for manufacturing the capacitor microphone;

FIG. 25 is a cross-sectional view showing the configuration of a diaphragm adapted to the capacitor microphone;

FIG. 26 is a cross-sectional view showing the constitution of a capacitor microphone in accordance with a third embodiment of the present invention;

FIG. 27A is a cross-sectional view showing a first step for manufacturing the capacitor microphone of the third embodiment;

FIG. 27B is a cross-sectional view showing a second step for manufacturing the capacitor microphone;

FIG. 27C is a cross-sectional view showing a third step for manufacturing the capacitor microphone;

FIG. 27D is a cross-sectional view showing a fourth step for manufacturing the capacitor microphone;

FIG. 27E is a cross-sectional view showing a fifth step for manufacturing the capacitor microphone;

FIG. 27F is a cross-sectional view showing a sixth step for manufacturing the capacitor microphone;

FIG. 27G is a cross-sectional view showing a seventh step for manufacturing the capacitor microphone;

FIG. 27H is a cross-sectional view showing an eighth step for manufacturing the capacitor microphone;
FIG. 27I is a cross-sectional view showing a ninth step for manufacturing the capacitor microphone;
FIG. 27J is a cross-sectional view showing a tenth step for manufacturing the capacitor microphone;
FIG. 27K is a cross-sectional view showing an eleventh step for manufacturing the capacitor microphone;
FIG. 27L is a cross-sectional view showing a twelfth step for manufacturing the capacitor microphone;
FIG. 27M is a cross-sectional view showing a thirteenth step for manufacturing the capacitor microphone;
FIG. 27N is a cross-sectional view showing a fourteenth step for manufacturing the capacitor microphone;
FIG. 270 is a cross-sectional view showing a fifteenth step for manufacturing the capacitor microphone;
FIG. 27P is a cross-sectional view showing a sixteenth step for manufacturing the capacitor microphone;
FIG. 27Q is a cross-sectional view showing a seventeenth step for manufacturing the capacitor microphone;
FIG. 27R is a cross-sectional view showing an eighteenth step for manufacturing the capacitor microphone;
FIG. 27S is a cross-sectional view showing a nineteenth step for manufacturing the capacitor microphone;
FIG. 27T is a cross-sectional view showing a twentieth step for manufacturing the capacitor microphone;
FIG. 27U is a cross-sectional view showing a twenty-first step for manufacturing the capacitor microphone;
FIG. 27V is a cross-sectional view showing a twenty-second step for manufacturing the capacitor microphone;
FIG. 27W is a cross-sectional view showing a twenty-third step for manufacturing the capacitor microphone;
FIG. 27X is a cross-sectional view showing a twenty-fourth step for manufacturing the capacitor microphone;
FIG. 27Y is a cross-sectional view showing a twenty-fifth step for manufacturing the capacitor microphone; and
FIG. 28 is a graph showing the relationship between the internal stress and annealing temperature with respect to a plate and a diaphragm included in the capacitor microphone.

DESCRIPTION OF THE PREFERRED EMBODIMENTS

The present invention will be described in further detail by way of examples with reference to the accompanying drawings.

1. First Embodiment

As shown in FIGS. 1 and 2, a capacitor microphone A of a first embodiment of the present invention includes a ring-shaped support 1, which has circular inner holes and which is formed by laminating a monocrystal silicon substrate 1 a and an oxide film 1b, a back plate (or a fixed electrode) 2, which is formed approximately in a circular shape and is supported by an upper end 1c of the support 1, and a diaphragm 3, which is positioned substantially in parallel with the back plate 2 in proximity to the inner holes of the support 1 and which has an outer circumferential end 3a that is supported and embedded in the oxide film 1b. The capacitor microphone A is equipped with a bias voltage applying device 4 in which one end is connected to the back plate 2 and the other end is connected to the diaphragm 3. The bias voltage applying device 4 includes a bias voltage source 4a and a resistor 4b, which are connected in series.

The support 1 is formed by laminating the monocrystal silicon substrate (hereinafter, simply referred to as a substrate) 1a and the oxide film 1b composed of silicon dioxide ($SiO_2$) in such a way that they are positioned coaxially along an axial line O1 (matching the inner hole of the support 1 and an axial line of the capacitor microphone A). In the support 1, both the substrate 1a and the oxide film 1b are positioned to be identical to each other so that their outer circumferential surfaces and their inner circumferential surfaces respectively match each other in the diameter direction. In the present embodiment, the oxide film 1b is composed of silicon dioxide, which is not a restriction. It is required for the oxide film 1b to have an electrically insulating property; hence, the oxide film 1b can be formed using other materials such as a silicon nitride film ($Si_3N_4$), a silicon oxide nitride film (SiON), an alumina film ($Al_2O_3$). It is required for the ring-shaped support 1 to have a plurality of inner holes, which run through from the upper surface to the lower surface. Each inner hole has a circular shape in plan view from the upper side, and the outer circumferential periphery of each inner hole has a square shape in cross section (see FIG. 2). Of course, it is possible to employ other shapes for the inner holes. For example, each inner hole has a rectangular shape in plan view, and the outer circumferential periphery of each inner hole has a circular shape in cross section.

The back plate 2 is a conductive semiconductor film roughly having a circular shape and composed of polycrystal silicon, wherein the back plate 2 is positioned coaxially along the axial line O1 of the support 1, and an outer circumferential end 2a thereof is fixed to the upper end 1c of the support 1, i.e., the upper surface of the oxide film 1 b. That is, the center portion (or the inner portion in the diameter direction) of the back plate 2 covers the inner holes of the support 1. In addition, a plurality of through holes 2b running from the upper surface to the lower surface are uniformly dispersed in plan view and are formed in the center portion of the back plate 2 covering the inner holes of the support 1.

The diaphragm 3 roughly having a circular shape is formed using a conductive film 10 laminating a polysilicon film (i.e., a tensile stress film or a conductive film) 3b, in which impurities such as phosphorus (P) are doped, and a polysilicon film (i.e., a compressive stress film or a conductive film) 3c, in which substantially no impurity is diffused. In addition, the diaphragm 3 is positioned opposite to the back plate 2 with an air gap H1 therebetween such that the center line (or axial line) thereof coaxially matches the axial line O1 of the support 1. When the bias voltage applying device 4 applies a bias voltage between the back plate 2 and the diaphragm 3, the diaphragm 3 is attracted to the back plate 2 due to electrostatic attraction, wherein the center portion thereof close to the axial line O1 is bent in a circular-arc shape in cross section in proximity to the back plate 2. Due to such an attracted state, it is possible to eliminate internal stress of the diaphragm 3. Incidentally, a polycrystal silicon film 3c, which forms a conductive film 10 of the diaphragm 3 and in which no impurity is doped, can be formed using a non-crystal silicon film (or an amorphous silicon film). When the diaphragm 3 is formed using the non-crystal amorphous silicon film, it is preferable that an in-product structure be subjected to annealing at a prescribed temperature sustaining the amorphous state.

Next, the manufacturing method of the capacitor microphone A (especially, the diaphragm 3) having the aforementioned constitution will be described in detail.

First, as shown in FIG. 3, an insulating silicon dioxide ($SiO_2$) is deposited on the upper surface of a monocrystal silicon substrate 1a by way of CVD (Chemical Vapor Deposition), thus forming the oxide film 1b. Next, as shown in FIG. 4, the polycrystal silicon film 3c (i.e., a compressive stress film or a conductive film), which is composed of phosphorus (P) and in which no impurity is doped, is formed on the oxide film 1b by way of CVD in order to form the diaphragm 3. As shown in FIG. 5, the polycrystal silicon film (i.e., a tensile stress film or a conductive film) 3b, in which impurities such as phosphorus (P) are doped, is formed on the compressive stress film 3c by way of CVD, thus completing the formation of a conductive film 10. In the present embodiment, the tensile stress film 3b is formed such that the thickness ratio thereof is 68% of the total thickness of the conductive film 10. Herein, the tensile stress film 3b can be formed by doping donor impurities or acceptor impurities into a polycrystal silicon formed on the compressive stress film 3c by way of ion implantation. Alternatively, impurities are doped in situ into the polycrystal silicon.

After completion of the formation of the tensile stress film 3b and the compressive stress film 3c, an in-process structure (see FIG. 5) is subjected to annealing at a prescribed temperature ranging from 800°C to 900°C by use of an RTA (Rapid Thermal Annealing) device. This applies a prescribed value of internal stress acting as compressive stress to the compressive stress film 3c, and this also applies a prescribed value of internal stress realizing tensile stress, which is slightly smaller than the compressive stress, to the tensile stress filme 3b. Next, after a resist is applied to the conductive film 10 so as to form a resist film 20 thereon, the corresponding in-process structure (see FIG. 5) is subjected to exposure and development processes; then, the "unnecessary" portion of the resist film 20 is removed such that the planar shape of the conductive film matches the planar shape of the resist film 20.

After completion of the removal of the unnecessary portion of the resist film 20, the conductive film 10 to be exposed is subjected to etching such as RIE (i.e., Reactive Ion etching), thus processing the conductive film 10 to have a prescribed shape as shown in FIG. 6. Then, the resist film 20 is completely removed by use of a resist peeling solution such as NMP (N-methyl-2-porolidone). Thereafter, a new oxide film is formed on the previously-formed oxide film and the conductive film 10 by way of CVD, thus making the conductive film 10 be completely embedded in the laminated oxide film 1b.

Next, as shown in FIG. 7, a conductive film 11 serving as a back plate 2 is formed on the oxide film 1b by way of CVD. A resist film 21 is formed on the conductive film 11; then, the unnecessary portion of the resist film 21 is removed to leave the necessary portion of the resist film 21 whose shape matches the shape of the back plate 2 in plan view. Then, the exposed conductive film 11 is subjected to etching such as RIE, thus processing the conductive film 11 to have a prescribed shape as shown in FIG. 8. At this time, the through holes 2b are formed in the resist film 21 serving as the back plate 2.

Next, as shown in FIG. 9, a resist film 22 is formed beneath the substrate 1a; then, unnecessary portions of the resist film 22, which are positioned just above the inner holes of the substrate 1a (corresponding to the inner holes of the support 1), are removed. The exposed portion of the substrate exposed from the resist film 22 is subjected to etching such as deep RIE such that etching progresses to reach the lower surface of the oxide film 1b formed on the substrate 1a. This accomplishes the formation of the substrate 1a having circular inner holes. Thereafter, a resist film 23 is formed on the conductive film 11 and the oxide film 1b; then, unnecessary portions of the resist film 23 positioned just above the inner holes of the support 1 are removed. That is, the resist film 23 is formed such that the through holes 2b of the back plate 2 are exposed.

An etching solution such as hydrofluoric acid is supplied by way of the through holes 2b and the inner holes of the substrate 1a, thus dissolving the oxide film 1b. Due to the etching solution supplied via the through holes 2b, dissolution progresses such that the oxide film 1b, which is positioned just below the center portion of the back plate 2 having the through holes 2b, reaches the upper surface of the conductive film 10 (serving as the diaphragm 3) thereunder. Due to the etching solution supplied via the inner holes of the substrate 1a, dissolution progresses such that the oxide film 1b positioned beneath the conductive film 10 reaches the lower surface of the conductive film 10. Thus, as shown in FIG. 10, the outer circumferential end 3a of the conductive film 10 is supported by and is embedded in the oxide film 1b, thus allowing the center portion of the diaphragm 3 to be exposed by way of the inner holes.

The present embodiment is characterized in that the diaphragm 3 is formed by combining the tensile stress film 3b applied with tensile stress and the compressive stress film 3c applied with the compressive stress. Due to the dissolution of the oxide film 1b, the center portion of the diaphragm 3 is exposed, and the tensile stress applied to the tensile stress film 3b cancels the compressive stress applied to the compressive stress film 3c. Herein, the tensile stress is adjusted to be slightly lower than the compressive stress; therefore, relatively low compressive stress of about 0.4 MPa, which corresponds to the difference between the tensile stress and compressive stress, is applied to the diaphragm 3.

Lastly, the resist films 22 and 23 are removed; then, the bias voltage applying device 4 is connected between the back plate 2 and the diaphragm 3, thus completing the production of the capacitor microphone A of the present embodiment.

Since the support 1 and the back plate 2 and in particular the diaphragm 3 are composed of silicon materials having superior heat resistance and relatively small deformation in high-temperature environments, the capacitor microphone A is not likely to be deformed at a temperature of about 250°C during reflow packaging, for example. In addition, the diaphragm 3 is inherently applied with internal stress corresponding to a compressive stress of about 0.4 MPa; hence, upon application of a bias voltage between the back plate 2 and the diaphragm 3 by means of the bias voltage applying device 4, the diaphragm 3 is bent in a circular-arc shape in cross section as shown in FIG. 2 due to electrostatic attraction, wherein tensile stress caused by such a curvature of the diaphragm 3 is canceled by the inherently applied compressive stress, thus eliminating the internal stress applied to the diaphragm 3. This reduces the stiffness of the diaphragm 3 that is electrically attracted to the back plate 2. Since the diaphragm 3 is inherently applied with a relatively small value of compressive stress of about 0.4 MPa, the capacitor microphone A of the present embodiment needs a very low bias voltage (which is 5 V or less) to be applied thereto in order to realize electrostatic attraction of the diaphragm 3. That is, the present embodiment does not require a relatively high bias voltage of about 20 V, which is needed for the conventionally-known capacitor microphones.

When sound pressure generated by the exterior propagates to and reaches the diaphragm 3, in which the internal stress is eliminated and the stiffness is reduced, the diaphragm 3 can appropriately vibrate in response to the sound pressure. That is, the diaphragm 3 can vibrate with relatively large amplitude in response to relatively small sound pressure. Thus, electrostatic capacitance of the capacitor microphone A can accurately vary in response to variation of the diaphragm 3; hence, the capacitor microphone A is superior in sensitivity.

According to the present embodiment, compressive stress is applied to the diaphragm 3 in advance so as to eliminate internal stress by way of the deflection of the diaphragm 3 that is bent when approaching the back plate 2 due to electrostatic attraction; hence, it is possible to reduce the stiffness of the diaphragm 3. This improves vibration characteristics and sensitivity of the capacitor microphone A. Since the capacitor microphone A of the present embodiment can be improved in sensitivity upon application of a very low bias voltage in comparison with the conventionally-known capacitor microphones, it is possible to save electric energy and to reduce the manufacturing cost.

The aforementioned compressive stress is inherently applied to the diaphragm 3 by way of annealing; hence, it is possible to control the compressive stress by adjusting the annealing temperature; thus, it is possible to reduce the stiffness of the diaphragm 3 by eliminating the internal stress applied to the diaphragm 3. In addition, the diaphragm 3 is constituted by combining the tensile stress film 3b applied with tensile stress and the compressive stress film 3c applied with compressive stress; hence, it is possible to adjust the ratio between the thickness of the tensile stress film 3b and the thickness of the compressive stress film 3c, and it is possible to adjust the relationship between the tensile stress of the tensile stress film 3b and the compressive stress of the compressive stress film 3c by appropriately adjusting the annealing temperature. This realizes a desired compressive stress to be applied to the diaphragm 3. Thus, it is possible to reliably eliminate the internal stress applied to the diaphragm 3, which is subjected to electrostatic attraction upon application of the bias voltage.

Furthermore, the tensile stress film 3b is a polycrystal silicon film into which impurities are doped, and the compressive stress film 3c is a polycrystal silicon film into which no impurity is doped. Therefore, during reflow packaging of the capacitor microphone A, no deformation occurs due to heat; hence, it is possible to provide the capacitor microphone A with a high sensitivity. Since the capacitor microphone A is manufactured by way of semiconductor manufacturing processes, it is possible to downsize the diaphragm 3 and the capacitor microphone A.

The present embodiment can be varied or modified within the scope of the present invention defined by the appended claims. According to the present embodiment, the diaphragm 3 (corresponding to the conductive film 10) is formed using a single tensile stress film (or conductive film) 3b and a single compressive stress film (or conductive film) 3c in such a way that the thickness ratio of the tensile stress film 3b is set to 68%. This is not a restriction; that is, the diaphragm 3 can be formed using multiple tensile stress films and multiple compressive stress films; alternatively, one of the tensile stress film 3b and the compressive stress film 3c can be multiplied, for example. In such a variation, it is possible to apply a desired compressive stress to the diaphragm 3 in advance by appropriately adjusting the internal stress of the tensile stress film 3b and the internal stress of the compressive stress film 3c or by appropriately adjusting the thickness ratios thereof. The thickness ratio of the tensile stress film 3b is not necessarily limited to 68%. In the diaphragm 3 of the present embodiment, the tensile stress film 3b is formed using a polycrystal silicon film, into which impurities are doped, and the compressive stress film 3c is formed using a polycrystal silicon film, into which no impurity is doped. This is not a restriction.

Of course, the diaphragm 3 can be formed using only the compressive stress film 3c. In this case, it is possible to adjust compressive stress of the compressive stress film 3c by appropriately adjusting the annealing temperature.

In the present embodiment, the polycrystal silicon film (i.e., 3b) into which impurities are doped and the polycrystal silicon film (i.e., 3c) into which no impurity is doped are laminated and combined together, and then, the laminated films are subjected to annealing. This is not a restriction; hence, annealing can be performed independently on the aforementioned polycrystal silicon films 3b and 3c, thus applying a desired compressive stress to the diaphragm 3 in advance.

Next, actual examples of the present embodiment will be described in detail with reference to FIGS. 11 to 13.

In the present embodiment, the diaphragm 3 is actually produced by laminating a phosphorus-doped polycrystal silicon film (serving as the tensile stress film 3b) and a no-impurity-doped polycrystal silicon film (serving as the compressive stress film 3c), whereby desired compressive stress is applied to the diaphragm 3 in advance, and it is possible to improve the sensitivity of the capacitor microphone A including the diaphragm 3. Specifically, the diaphragm 3 is designed in prescribed dimensions such as 700 $\mu$m diameter and 0.66 $\mu$m thickness and is physically separated from the back plate 2 with an air gap of 4 $\mu$m.

FIG. 11 shows the relationship between one example of the diaphragm 3 composed of the tensile stress film 3b only and another example of the diaphragm 3 composed of the compressive stress film 3c only in terms of the annealing temperature and internal stress. In the graph of FIG. 11, the horizontal axis represents the annealing temperature, and the vertical axis represents the internal stress that is measured when the diaphragm 3 is cooled down to room temperature after annealing. Herein, the positive values of the internal stress mean the tensile stress, and negative values of the internal stress mean the compressive stress.

FIG. 11 clearly shows that the diaphragm 3 composed of the tensile stress film 3b, which is subjected to annealing at a prescribed temperature ranging from 600°C to 1000°C exhibits small compressive stress at the annealing temperature of 1000°C, however, it normally exhibits tensile stress, which gradually decreases as the annealing temperature becomes higher. In contrast, the diaphragm 3 composed of the compressive stress film 3c, which is subjected to annealing at a prescribed temperature ranging from 600°C to 1000°C, normally exhibits compressive stress, which gradually decreases as the annealing temperature becomes higher. This clearly proves that the internal stress of the diaphragm 3 (i.e., the tensile stress of the tensile stress film 3b and the compressive stress of the compressive stress film 3c) can be controlled in response to the annealing temperature.

FIG. 12 shows the relationship between examples of the diaphragm 3 composed of the tensile stress film 3b and the compressive stress film 3c in terms of the annealing temperature and internal stress, wherein the thickness ratio of the tensile stress film 3b compared with the total thickness of the diaphragm 3 is changed to 15%, 30%, 45%, 61%, 68%, 76%, 91 %, and 100% in a step-by-step manner so as to present differences of the internal stress of the diaphragm 3.

FIG. 12 clearly shows that the diaphragm 3 including the tensile stress film 3b whose thickness ratio ranges between 15% and 45% exhibits very high compressive stress exceeding 100 MPa. When very high compressive stress is applied to the diaphragm 3 in advance, a very high bias voltage should be necessarily applied to the capacitor microphone A in order to eliminate the internal stress of the diaphragm 3 by way of electrostatic attraction. In addition, it is acknowledged that the diaphragm 3 including the tensile stress film 3b whose thickness ratio ranges between 91% and 100% should be subjected to a very high annealing temperature of 1000°C in order to avoid tensile stress being applied thereto in advance.

It is also acknowledged that the diaphragm 3 including the tensile stress film 3b whose thickness ratio ranges between 61% and 76% exhibits small compressive stress in response to the annealing temperature. In order to apply small compressive stress of about 0.4 MPa to the diaphragm 3 in advance, it is advantageous that small variations of the internal stress of the diaphragm 3 occur in response to the annealing temperature, in other words, curves having relatively small inclinations in FIG. 12 may appropriately work in order to precisely adjust the internal pressure of the diaphragm 3. In light of the above, it can be said that desired compressive stress is easily applied to the diaphragm 3 including the tensile stress film 3b whose thickness ratio is set to 68% and which is subjected to annealing at a prescribed temperature of about 850°C.

FIG. 13 shows the relationships between examples of the capacitor microphone A using the diaphragm 3 composed of the tensile stress film 3b and the compressive stress film 3c in terms of the bias voltage and sensitivity, wherein a first example of the diaphragm 3 exhibits compressive stress of 0.4 MPa, a second example of the diaphragm 3 exhibits no internal stress (i.e., the diaphragm 3 exhibiting no internal stress before application of the bias voltage), and a third example of the diaphragm 3 exhibits tensile stress of 10 MPa.

FIG. 13 clearly shows that the sensitivity can be increased as the bias voltage increases with respect to the third example of the diaphragm 3 exhibiting tensile stress; however, this diaphragm 3 has a relatively low sensitivity in comparison with the other diaphragms 3. It is acknowledged that the second example of the diaphragm 3 exhibiting no internal stress is increased in sensitivity in comparison with the third example of the diaphragm exhibiting tensile stress; however, similar to the third example, the second example is reduced in sensitivity at a low bias voltage.

In contrast, it is acknowledged that the first example of the diaphragm 3 exhibiting compressive stress of 0.4 MPa (which is adapted to the capacitor microphone A of the present embodiment) is highly improved in sensitivity at a low bias voltage of 5V or less, in particular, at low bias voltage ranging between 2V and 3V. This clearly shows that the capacitor microphone A using the diaphragm 3 exhibiting compressive stress in advance produces a high sensitivity, which can be further increased by reducing the bias voltage. That is, it is possible to save electric energy applied to the capacitor microphone A, and it is possible to reduce the manufacturing cost.

## 2. Second Embodiment

FIG. 14A is a cross-sectional view showing the constitution of a capacitor microphone 1001 in accordance with a second embodiment of the present invention. The capacitor microphone 1001 includes a sound sensing portion and a detection portion, which are shown in FIG. 14A.

### (a) Constitution of sound sensing portion

The sound sensing portion of the capacitor microphone 1001 includes a back plate 1010 and a diaphragm 1030 (see FIG. 14B), which are connected to a spacer 1044 at prescribed ends thereof. That is, the back plate 1010 and the diaphragm 1030 are supported in parallel with each other via the spacer 1044, by which a pressure chamber (or an air gap) 1046 is formed therebetween. The back plate 1010 is positioned relative to the diaphragm 1030, which is connected to the circuitry for sensing sound. The back plate 1010 has a plurality of sound holes 1018, i.e., a plurality of through holes allowing sound waves to propagate therethrough toward the diaphragm 1030. A base 1040 having interior side walls 1052 of a pressure buffer 1033 is arranged in the opposite side of the diaphragm 1030 facing the back plate 1010.

The back plate 1010 is basically formed using a disk-like portion that is not fixed to an insulating film 1045 of a conductive film 1022. The diaphragm 1030 is formed using a first disk-like portion, which is not fixed to an insulating film 1043 of a first thin film 1032, and a second disk-like portion, which is not fixed to an insulating film 1045 of a second thin film 1014. Both of the first thin film 1032 and the conductive film 1022 both having the conduction property are composed of polycrystal silicon into which impurities are doped, whereby they form opposite electrodes of a parallel-plate capacitor. The second thin film 1014 is used to adjust internal stress of the diaphragm 1030 and is composed of an insulating material such as $Si_3N_4$. The second thin film 1014 is attached to the first thin film 1032 in proximity to the back plate 1010.

The spacer 1044 is constituted by the insulating film 1045 forming interior side walls 1016 of the pressure chamber 1046 and the first thin film 1032 as well as the exterior portion outside of interior side walls 1016 of the pressure chamber 1046 defined by the second thin film 1014 and the conductive film 1022. The base 1040 is constituted by the insulating film 1043 and a base film 1051. Both of the insulating films 1043 and 1045 are composed of $SiO_2$, for example. The base film 1051 is composed of monocrystal silicon, for example.

The internal stress of the first thin film 1032 is adjusted to zero substantially. A prescribed portion for adjusting internal stress of the second thin film 1014 of the diaphragm 1030 is entirely fixed to the first thin film 1032 of the diaphragm 1030. Small tensile stress remains in the second thin film 1014. The internal stress of the second thin film 1014 can be adjusted by controlling the thickness of the second thin film 1014.

Since the second thin film 1014 of the diaphragm 1030 having insulating property is attached to the first thin film 1032 having conduction property in proximity to the plate 1010, even when dewing occurs between the plate 1010 and the diaphragm 1030 in high-humidity environments, the second thin film 1014 demonstrates an insulating function so as to cause leak currents between the opposite electrodes of a capacitor, thus preventing the sensitivity of the capacitor microphone 1001 from being degraded. Even when a pull-in event occurs between the opposite electrodes, it is possible to avoid the occurrence of short-circuiting because of the intervention of the second thin film 1014. Thus, it is possible to avoid the occurrence of destruction of the circuitry due to the circuit failure caused by short-circuiting and sparking, for example.

### (b) Constitution of detection portion

A lead 1204 that is connected to one end of a resistor 1200 is connected to the first thin film 1032 having insulating property within the diaphragm 1030 serving as one of the opposite electrodes. A lead 1206 being grounded is connected to the conductive film 1022 forming the back plate 1010 serving as the other of the opposite electrodes. The other end of the resistor 1200 is connected to a lead 1208, which is connected to the output terminal of a bias voltage circuit 1202. The resistor 1200 has a relatively high resistance. Specifically, it is preferable that the resistor 1200 has giga-ohm resistance. A lead 1214 that is connected to one end of a capacitor 1212 is connected to an input terminal of a preamplifier 1210. The lead 1204 connecting between the diaphragm 1030 and the resistor 1200 is connected to the other end of the capacitor 1021.

(c) Operation of capacitor microphone

When sound waves transmit through the sound holes 1018 of the back plate 1010 so as to propagate toward the diaphragm 1030, the diaphragm 1030 vibrates in response to the sound waves. Since the distance between the back plate 1010 and the diaphragm 1030 varies due to vibration of the diaphragm 1030, the electrostatic capacitance of the capacitor constituted by the back plate 1010 and the diaphragm 1030 is correspondingly varied. Incidentally, tensile stress is exerted on the diaphragm 1030 upon application of a bias voltage.

Since the diaphragm 1030 is connected to the resistor 1200 having relatively high resistance, even when the electrostatic capacitance of the capacitor varies due to the vibration, electric charge accumulated in the capacitor may not flow through the resistor 1200. That is, it is possible to assume that electric charge accumulated in the capacitor formed by the back plate 1010 and the diaphragm 1030 may not be changed. Therefore, it is possible to detect voltage variations between the back plate 1010 and the diaphragm 1030 as a representation of variations of electrostatic capacitance of the capacitor.

Voltage variations of the diaphragm 1030 compared with a ground potential are amplified by the preamplifier 1210; hence, the capacitor microphone 1001 can output electric signals in response to very small variations of electrostatic capacitance. In short, the capacitor microphone 1001 converts variations of sound pressure applied to the diaphragm 1030 into variations of electrostatic capacitance, which are then converted into voltage variations, thus outputting electric signals in response to variations of sound pressure.

(d) Manufacturing method

Next, a manufacturing method of the capacitor microphone 1001 will be described with reference to FIGS. 15A to 15I.

First, as shown in FIG. 15A, an insulating film 1043 is formed on a base film 1051. Specifically, $SiO_2$ is deposited on the surface of a monocrystal silicon substrate serving as the base film 1051 by way of CVD, thus forming the insulating film 1043. The insulating film 1043 can be formed by performing thermal oxidation on the monocrystal silicon substrate. However, it is preferable that $SiO_2$ be deposited in order to set the same etching rate with respect to an insulating film 1045 composed of $SiO_2$ and the insulating film 1043 composed of $SiO_2$.

Next, as shown in FIG. 15B, a first thin film 1032 is deposited on the surface of the insulating film 1043. Specifically, polycrystal silicon is deposited on the surface of the insulating film 1043 by way of LPCVD. It is possible to dope donor impurities or acceptor impurities into the deposited polycrystal silicon film by way of ion implantation. Alternatively, it is possible to dope impurities into the polycrystal silicon film being deposited in situ.

Next, the first this film 1032 is subjected to annealing so as to reduce and substantially eliminate the internal stress thereof. Specifically, a polycrystal silicon film in which impurities such as phosphorus (P) are doped is heated at a temperature of about 1000°C, thus substantially eliminating the internal stress thereof. Herein, the internal stress cannot be controlled and eliminated at a high precision; hence, an adjustment error (e.g., compressive stress) may occur in the first thin film 1032.

Next, as shown in FIG. 15C, a second thin film 1014 is deposited on the surface of the first thin film 1032. Specifically, $Si_3N_4$ is deposited on the surface of the first thin film 1032 by way of LPCVD. The thickness of the second thin film 1014 is minimized to produce minimum tensile stress that may substantially cancel relatively high compressive stress, which occurs in the first thin film 1032 due to the maximum adjustment error of the internal stress. In order to form a film composed of $Si_3N_4$, it is possible to employ a special measure in which the internal stress is varied in advance by adjusting the flow ratios of $H_2Cl_2$ and $NH_3$ and the heating temperature therefor. Thus, it is possible to substantially eliminate the internal stress of a multilayered structure composed of the first thin film 1032 and the second thin film 1014.

Next, as shown in FIG. 15D, the first thin film 1032 and the second thin film 1014 are subjected to etching so as to produce a prescribed pattern. Specifically, a mask is formed on the surface of the second thin film 1014 by way of lithography; then, the second thin film 1014 and the first thin film 1032 are subjected to etching using a mixed gas composed of $CH_4$ and $CHF_3$ or a mixed gas composed of $Cl_2$ and $O_2$.

Next, as shown in FIG. 15E, an insulating film 1045 is deposited on the surface of the second thin film 1014. Specifically, $SiO_2$ is deposited by way of CVD, for example.

Next, as shown in FIG. 15F, a conductive film 1022 is formed on the surface of the insulating film 1045. Specifically, polycrystal silicon is deposited on the surface of the insulating film 1045 by way of LPCVD, for example. It is possible to dope donor impurities or acceptor impurities into the deposited polycrystal silicon by way of ion implantation. Alternatively, impurities can be doped in situ into a polycrystal silicon being deposited.

Next, as shown in FIG. 15G, sound holes 1018 are formed in the conductive film 1022. Specifically, a mask is formed on the surface of the conductive film 1022 by way of lithography; then, the conductive film 1022 is subjected to etching using a mixed gas composed of $Cl_2$ and $O_2$.

Next, as shown in FIG. 15H, the base film 1051 is etched so as to form a part of a pressure buffer 1033. Specifically, a mask having an opening, which may match the interior side walls 1052 of the pressure chamber 1033, is formed on the surface of the base film 1051 by way of lithography; then, the base film 1051 is subjected to etching using $SF_6$ gas.

Next, as shown in FIG. 15I, the insulating films 1043 and 1045 are etched to form the remaining part of the pressure buffer 1033 and the pressure chamber 1046. Specifically, the insulating films 1043 and 1045 are subjected to etching using HF solution by using the base film 1051 and the conductive film 1022 as a mask. As a result, the disk-like portion of the first thin film 1032 and the disk-like portion of the second thin film 1014 are opened with an air gap therebetween, thus completing the sound sensing portion of the capacitor microphone 1001.

The second embodiment can be varied or modified in a variety of ways; hence, variations of the second embodiment will be described below.

(1) First variation

FIG. 16 shows the constitution of a capacitor microphone 1002 in accordance with a first variation of the second embodiment, wherein parts identical to those shown in FIGS. 14A and 14B are designated by the same reference numerals. That is, the first thin film 1032 having conduction property can be positioned relative to the second thin film 1014 for adjusting the internal stress in proximity to the back plate 1010. In other words, either the first thin film 1032 or the second thin film 1014 can be formed at first. When the first thin film 1032 is positioned relative to the second thin film 1014 in proximity to the back plate 1010 as shown in FIG. 16, the second thin film 1014 does not demonstrate an insulating function exerted between the opposite electrodes of a capacitor.

(2) Second variation

Next, a capacitor microphone 1003 according to a second variation of the second embodiment will be described with reference to FIGS. 17A, 17B, and 17C and FIGS. 18A and 18B, wherein parts identical to those shown in FIGS. 14A and 14B are designated by the same reference numerals.

That is, the second thin film 1014 is fixed to a prescribed part of the first thin film 1032 in the diaphragm 1030.

The second thin film 1014 of the diaphragm 1030 can be varied in shape as shown in FIGS. 17B and 17C, in which the second film 1014 is fragmented so that plural segments of the second tin film 1014 are arranged in a circumferential direction of the diaphragm 1030 with equal spacing therebetween. Alternatively, the second thin film 1014 can be formed in a radial shape as shown in FIG. 18A; or the second thin film 1014 can be formed in a concentric shape compared with the circular shape of the diaphragm 1030 as shown in FIG. 18B.

Incidentally, the diaphragm 1030 can be shaped in plan view in the circular shape shown in FIG. 17B or the rectangular shape shown in FIG. 17C. In other words, each of the pressure chamber 1046 and the pressure buffer 1033 can be shaped in plan view in the circular shape or the rectangular shape.

The capacitor microphone 1003 can be easily produced by partially changing the fourth step of the capacitor microphone 1001 shown in FIG. 15D in such a way that there are provided a first mask for etching the first thin film 1032 and a second mask for etching the second thin film 1014, which differ from each other in shape.

With respect to the diaphragm 1030, the second thin film 1014 is reduced in overall size in comparison with the first thin film 1032; thus, it is possible to optimize the thickness of the second thin film 1014. In other words, the second thin film realizing the diaphragm 1030 having target stress can be appropriately shaped by controlling the thickness thereof to secure high uniformity or high throughput.

(3) Third variation

A capacitor microphone 1004 according to a third variation of the second embodiment will be described with reference to FIGS. 19A and 19B, wherein parts identical to those shown in FIGS. 14A and 14B are designated by the same reference numerals.

That is, the diaphragm 1030 can be partially isolated from the spacer 1044. Specifically, a relatively large area of the first thin film 1032 forming the diaphragm 1030 can be isolated from the first thin film 1032 forming the spacer 1044. This reduces the rigidity of the diaphragm 1030 in its periphery; hence, it is possible to increase the vibration amplitude of the diaphragm 1030, thus increasing the sensitivity of the capacitor microphone 1004.

(4) Fourth variation

In the second embodiment and its variations, after the internal stress of the first thin film 1032 is adjusted, the total internal stress of the diaphragm 1030 is adjusted by means of the second thin film 1014. Of course, it is possible to simultaneously adjust the internal stress of the first thin film 1032 and the internal stress of the second thin film 1014, thus adjusting the total internal stress of the diaphragm 1030.

Specifically, the first thin film 1032 is formed by depositing polycrystal silicon, into which impurities such as phosphorus (P) are doped, by way of LPCVD; then, without performing annealing, polycrystal silicon, into which no impurity is doped, is deposited by way of LPCVD, thus forming the second thin film 1014; then, annealing is performed to simultaneously adjust the internal stress of the first thin film 1032 and the internal stress of the second thin film 1014. As shown in FIG. 20, phosphorus-doped polycrystal silicon, which is deposited by way of LPCVD, has relatively high tensile stress before annealing, wherein the tensile stress decreases as the annealing temperature increases so that the tensile stress is substantially eliminated at a temperature of about 1000°C, whereas compressive stress increases as the annealing temperature further increases. In contrast, no-impurity-doped polycrystal silicon, which is deposited by way of LPCVD, has relatively high compressive stress before annealing, wherein the compressive stress gradually decreases as the annealing temperature increases. In addition, no-impurity-doped non-crystal silicon has relatively high compressive stress before annealing, wherein the compressive stress rapidly decreases as the annealing temperature increases and is then substantially eliminated at a temperature of about 750°C, whereas tensile stress occurs as the annealing temperature further increases.

Incidentally, graphs of FIGS. 20, 21, and 22 are produced based on experimental results, which are measured upon annealing by use of a RTA (Rapid Thermal Annealing) device.

It is possible to reduce the annealing temperature with respect to the laminated structure composed of a phosphorus-doped polycrystal silicon and no-impurity-doped polycrystal silicon. As shown in FIG. 21, with respect to the thickness ratio of 76% set to the phosphorus-doped polycrystal silicon film in comparison with the total thickness, it is possible to substantially eliminate or extremely reduce tensile stress (at 0 MPa to 5 MPa, for example) in the laminated structure at a prescribed annealing temperature ranging from 800°C to 900°C. With respect to the thickness ratio of 68%, it is possible to substantially eliminate or extremely reduce tensile stress in the laminated structure at a prescribed annealing temperature ranging from 590°C to 830°C. In contrast, in order to extremely reduce tensile stress (at 0 MPa to 5 MPa, for example) in the single-layered structure, it is necessary to increase the annealing temperature to 930°C or more.

In the case of the multilayered structure composed of phosphorus-doped polycrystal silicon and no-impurity-doped non-crystal silicon, it is possible to substantially eliminate or extremely reduce the tensile stress in the multilayered structure by appropriately setting the annealing temperature. For example, as shown in FIG. 22, when the annealing temperature exceeds 930°C, it is possible to substantially eliminate or extremely reduce the tensile stress (at 0 MPa to 5 MPa, for example) in the multilayered structure irrespective of the thickness ratio. In the case of the combination of the phosphorus-doped polycrystal silicon and no-impurity-doped non-crystal silicon, it is possible to realize desired internal stress by adjusting the thickness ratio and annealing temperature to a relatively low annealing temperature. Incidentally, it is not preferable to adapt the annealing temperature range between 840°C and 930°C in terms of amorphous crystallization. When the diaphragm 1030 is formed using non-crystal amorphous silicon, it is preferable that the in-product structure be annealed at a prescribed annealing temperature sustaining the amorphous state.

## 3. Third Embodiment

FIG. 23 is a cross-sectional view showing the constitution of a capacitor microphone 2001 in accordance with a third embodiment of the present invention, which is a silicon microphone that is produced by way of semiconductor manufacturing processes. The capacitor microphone 2001 includes a sound sensing portion and a detection portion.

### (a) Constitution of sound sensing portion

The sound sensing portion of the capacitor microphone 2001 includes a diaphragm 2010, a back plate 2030, and a support 2040. The diaphragm 2010 and the back plate 2030 are supported by the support 2040 with an air gap 2050 therebetween. The back plate 2030 has a plurality of through holes 2032. The support 2040 has an opening 2042, which is combined with the diaphragm 2010 so as to form a back cavity. It is possible to rearrange the diaphragm 2010 to be close to a sound source rather than the back plate 2030.

The diaphragm 2010 includes non-fixed portions corresponding to prescribed parts of exterior films 2121 and 2141, which are not fixed to an insulating layer 2180, and a part of a conductive film 2131 fixed to the non-fixed portions. Both of the exterior films 2121 and 2141 are composed of $Si_3N_4$, and the conductive film 2131 is composed of phosphorus-doped polycrystal silicon (hereinafter, polycrystal silicon will be referred to as polysilicon).

In claim language, the non-fixed portion of the exterior film 2121, which is not fixed to the insulating layer 2180, indicates a first coating film, and the non-fixed portion of the exterior film 2141, which is not fixed to the insulating layer 2180, indicates a second coating film. In addition, a prescribed part of the conductive film 2131, which is not fixed to the non-fixed portion, indicates a center layer or a movable electrode. The first coating layer or the second coating layer can be formed using an exterior film, and the center layer can be formed using an insulating film, for example.

The direction of tension applied to the exterior film 2121 and the exterior film 2141 is reverse to the direction of tension applied to the conductive film 2131. The sum of absolute values of tensions applied to the exterior films 2121 and 2141 is substantially identical to an absolute value of tension applied to the conductive film 2131. That is, the tension of the conductive film 2131 is canceled by the tensions of the exterior films 2121 and 2141, thus reducing the total tension applied to the diaphragm 2010. Specifically, negative tension due to compressive stress remains in the conductive film 2131 composed of phosphorus-doped polysilicon. In contrast, positive tension due to tensile stress remains in each of the exterior films 2121 and 2141, both of which are composed of $Si_3N_4$.

Since the tension of the conductive film 2131 is canceled by the tensions of the exterior films 2121 and 2141, the total tension applied to the diaphragm 2010 becomes substantially zero. This indicates that the tension of the diaphragm 2010 is very close to zero as long as the diaphragm 2010 satisfies desired mechanical characteristics. When the direction of the tension applied to the exterior films 2121 and 2141 is reverse to the direction of tension applied to the conductive film 2131, it is not always required that the sum of the absolute values of tensions of the exterior films 2121 and 2141 be substantially identical to the absolute value of tension of the conductive film 2131. In this case, the tension of the diaphragm 2010 becomes smaller than the tension of another diaphragm, which is formed only using a single conductive film.

The tension of the exterior film 2121 is substantially identical to the tension of the exterior film 2141. Therefore, the tensions of the exterior films 2121 and 2141 are similarly exerted on both surfaces of the conductive film 2131. Specifically, both of the exterior films 2121 and 2141 are formed using the same material in the same thickness and are subjected to annealing at the same temperature. As described above, the tensions of the exterior films 2121 and 2141 are similarly exerted on both surfaces of the conductive film 2131; hence, it is possible to prevent the diaphragm 2010 from being unexpectedly deformed due to tension. Incidentally, the tension of the exterior film 2121 can differ from the tension of the exterior film 2141 as long as the diaphragm 2010 satisfies desired characteristics. In this case, the exterior films 2121 and 2141 can be formed using different materials in different thicknesses.

The back plate 2030 is formed using a non-fixed portion of a conductive film 2161, which is not fixed to an insulating layer 2180. The conductive film 2161 is composed of impurities-doped (e.g., phosphorus-doped) polysilicon, for example, wherein it functions as a fixed electrode. Incidentally, the back plate 2030 can be formed using an insulating film and a conductive film, which is formed on the insulating film so as to serve as a movable electrode.

The support 2040 serving as a spacer is constituted by a fixed portion of the conductive film 2161, which is fixed to the insulating layer 2180, fixed portions of the exterior films 2121 and 2141, which are fixed to the insulating layer 2180, and a non-fixed portion of the conductive film 2131, which are not fixed to the non-fixed portions of the exterior films 2121 and 2141, as well as the insulating layer 2180 and a substrate 2100. The insulating layer 2180 is composed of $SiO_2$, and the substrate 2100 is composed of monocrystal silicon, for example. In the above, the conductive film 2131 included in the diaphragm 2010 is fixed to the insulating layer 2180 included in the support 2040. This is not a restriction; that is, the support 2040 can employ any type of constitution guaranteeing electrical insulation between the movable electrode and fixed electrode.

(b) Constitution of detection portion

The diaphragm 2010 is connected to a bias voltage circuit 2200, and the back plate 2030 is grounded via a resistor 2202. The back plate 2030 is connected to a preamplifier 2210 as well. The detection portion of the capacitor microphone 2001 is designed such that the preamplifier 2210 outputs electric signals in relation to the voltage applied between the back plate 2030 and the ground level.

Specifically, a lead 2204 connected to the bias voltage circuit 2200 is connected to the conductive film 2131 and the substrate 2100 in the diaphragm 2010. A lead 2206 connected to one end of the resistor 2202 is connected to the conductive film 2161 in the back plate 2030. A lead 2208, which is grounded via a package of the capacitor microphone 2001, is connected to the other end of the resistor 2202. The resistor 2202 has a relatively high resistance, wherein it is preferable that the resistor 2202 have giga-ohm resistance. The lead 2206 connecting between the back plate 2030 and the resistor 2202 is connected to the input terminal of the preamplifier 2210 as well. It is preferable that the preamplifier 2210 has a relatively high input impedance.

(c) Operation of capacitor microphone

When sound waves transmit through the through holes 2032 of the back plate 2030 and then propagate toward the diaphragm 2010, the diaphragm 2010 vibrates due to the sound waves, so that the distance between the diaphragm 2010 and the back plate 2030 is varied so as to cause variations of electrostatic capacitance of a mike capacitor formed by the diaphragm 2010 and the back plate 2030.

Since the back plate 2030 is connected to the resistor 2202 having a relatively high resistance, even when the electrostatic capacitance of the mike capacitor varies due to the vibration of the diaphragm 2010, electrical charges accumulated in the mike capacitor may not flow through the resistor 2202. That is, it is assumed that electrical charges accumulated in the mike capacitor may not substantially change. Therefore, it is possible to detect variations of voltage applied between the back plate 2030 and the ground level as the representation of variations of the mike capacitor.

As described above, the capacitor microphone 2001 can produce electric signals in response to very small variations of electrostatic capacitance of the mike capacitor. That is, the capacitor microphone 2001 converts variations of sound pressure applied to the diaphragm 2010 into variations of electrostatic capacitance of the mike capacitor, which are then converted into variations of voltage, thus producing electric signals in relation to variations of sound pressure. Since the diaphragm 2010 is adjusted in advance such that the tension thereof becomes substantially zero, the diaphragm 2010 produces a relatively large displacement in response to sound waves. This makes it possible for the diaphragm 2010 to convert variations of the mike capacitor into relatively large variations of electrostatic capacitance. As a result, it is possible to improve the sensitivity of the capacitor microphone 2001.

Incidentally, tensile stress is exerted on the diaphragm 2010 upon application of a bias voltage between the diaphragm 2010 and the back plate 2030.

(d) Manufacturing method

Next, the manufacturing method of the capacitor microphone 2001 will be described with reference to FIGS. 24A to 24K.

First, as shown in FIG. 24A, an insulating film 2110 is formed on a substrate 2100. The insulating film 2110 forms a part of the insulating layer 2180 (see FIG. 23) of the sound sensing portion and is combined together with insulating films 2150 and 2170 so as to form the insulating layer 2180 completely. All of the insulating films 2110, 2150, and 2170 are composed of $SiO_2$, for example.

Specifically, an insulating material is deposited on the surface of the substrate 2100 by way of CVD (Chemical Vapor Deposition), thus forming the insulating film 2110 on the substrate 2100. Incidentally, the insulating films 2110, 2150, and 2170 can be formed using different materials.

Next, as shown in FIG. 24B, a thin film 2120 is formed on the insulating film 2110 by way of CVD. The thin film 2120 is composed of $Si_3N_4$, for example.

Next, a thin film 2130 is formed on the thin film 2120 by way of CVD. The thin film 2130 is composed of phosphorus-doped polysilicon, for example.

Next, a thin film 2140 is formed on the thin film 2130 by way of CVD. The thin film 2140 is composed of $Si_3N_4$, for example.

Next, as shown in FIG. 24C, the thin films 2120, 2130, and 2140 are subjected to patterning, thus forming a structure including an exterior film 2121, a conductive film 2131, and an exterior film 2141 forming the diaphragm 2010 (see FIG. 23). The exterior film 2121, the conductive film 2131, and the exterior film 2141 are respectively optimized in thickness by way of annealing at a prescribed temperature, thus reducing the sum of tensions thereof to substantially zero.

Specifically, the aforementioned structure including the exterior film 2121, the conductive film 2131, and the exterior film 2141 is subjected to patterning as follows:

First, a resist film for exposing unnecessary portions of the thin film 2140 is formed on the thin film 2140 by way of lithography. More specifically, a resist is applied onto the thin film 2140 so as to form the resist film; then, the resist film is subjected to exposure and development processing via a mask having a prescribed shape, thus removing the unnecessary portion of the resist film. Hence, it is possible to form the resist film that is shaped to expose the unnecessary portion of the thin film 2140. Incidentally, the resist film is removed by use of a resist peeling solution such as NMP (N-methyl-2-pirolidone).

The exposed portion of the thin film 2140 exposed from the resist film is subjected to etching such as RIE (Reactive Ion Etching), thus forming the exterior film 2141. More specifically, the thin film 2140 is subjected to etching in a reaction chamber at pressure of 250 mTorr and at RF power of 750 W by use of an etching gas such as $CF_4$, $CHF_3$, and $N_2$ by way of CCP-RIE (Capacitive Coupled Plasma-RIE) and ICP-RIE (Inductive Coupled Plasma-RIE), for example. Herein, the RF power is defined as high-frequency power applied between electrodes, which are positioned opposite to each other with a sample therebetween, in an RIE device.

Next, the exposed portion of the thin film 2130 exposed from the resist film is subjected to etching, thus forming the conductive film 2131. More specifically, the thin film 2130 is subjected to etching in a reaction chamber at a pressure of 2.0 mTorr, at RF power of 50 W, and microwave power of 1400 W by use of an etching gas such as $Cl_2$ and $O_2$ by way of ECR-RIE (Electron Cyclotron Resonance-RIE). Herein, the microwave power is defined as power of microwaves causing electron cyclotron resonance in an ECR-RIE device.

Next, the exposed portion of the thin film 2120 exposed from the resist film is subjected to etching, thus forming the exterior film 2121. More specifically, the thin film 2120 is etched by way of CCP-RIE and ICP-RIE similar to the etching of the thin film 2140, for example. Then, the resist film is removed from the thin film 2140.

As described above, the thin films 2120, 2130, and 2140 are subjected to patterning so as to form the exterior film 2121, the conductive film 2131, and the exterior film 2141, which form the diaphragm 2010.

The aforementioned three thin films can be sequentially etched by use of different etching devices. They can be consecutively etched in situ by use of an etching device of a multi-chamber type. Alternatively, they can be consecutively etched by use of an etching device integrally combined with a resist asher, whereby etching of the thin films and removal of the resist film are consecutively performed without changing the processing device therefor.

Different resist films can be adapted to different thin films subjected to etching, whereby the exterior film 2121, the conductive film 2131, and the exterior film 2141 are formed in different two-dimensional shapes.

Next, as shown in FIG. 24D, an insulating film 2150 whose thickness is larger than the thickness of the structure composed of the exterior film 2121, the conductive film 2131, and the exterior film 2141 are formed on the insulating film 2110 by way of CVD.

Next, as shown in FIG. 24E, the insulating film 2150 is subjected to polishing by way of CMP (Chemical Mechanical Polishing), thus making the insulating film 2150 planar.

In the above, it is possible to form the insulating film 2150 having improved planation by way of SOG (Spin On Glass), by which the aforementioned step can be omitted. Alternatively, an insulating material is embedded in the recess formed by the aforementioned structure and the insulating film 2110 and is deposited on the insulating film 2110, thus forming the insulating film 2150 having improved planation, whereby the aforementioned step can be omitted. In this case, it is preferable to adopt HDP-CVD (High-Density Plasma-CVD) or $O_3$-TEOS-CVD having superior embedment characteristics in the formation of the insulating film 2150. Of course, the insulating film 2150, which is formed by way of SOG, HDP-CVD, or $O_3$-TEOS-CVD, can be subjected to planation by way of CMP. In order to omit the planation step of the insulating film 2150 by way of CMP, the thin films 2120, 2130, and 2140 are subjected to residual removal after patterning, for example. Residual removal is realized by isotropic dry etching in which residuals at shoulder portions of step portions are removed by use of a mixed gas of $CF_4/O_2$.

Next, as shown in FIG. 24F, a conductive film 2160 is formed on the insulating film 2150 by way of CVD.

Next, as shown in FIG. 24G, the conductive film 2160 is subjected to patterning so as to form a conductive film 2161, which forms the back plate 2030.

Next, as shown in FIG. 24H, an insulating film 2170 whose thickness is larger than the thickness of the conductive film 2161 is formed on the insulating film 2150 by way of CVD.

Next, as shown in FIG. 24I, electrode portions for electrically connecting the sound sensing portion and the detection portion are respectively formed on the substrate 2100 and the conductive films 2131 and 2161. The electrode portions are externally exposed from the substrate 2100, the conductive film 2131, and the insulating film 2170 of the conductive film 2161. Specifically, the electrode portions are formed as follows:

First, a resist film for exposing unnecessary portions of the insulating layer 2180 (not shown) is formed on the insulating film 2170. Next, the exposed portion of the insulating film 2170 is subjected to etching such as RIE such that etching progresses to reach the substrate or the conductive film 2161.

Next, as shown in FIG. 24J, an opening 2101 forming the opening 2042 of the support 2040 is formed on the substrate 2100. Specifically, the opening 2101 is formed as follows:

First, a resist film for exposing a prescribed portion forming the opening 2101 of the substrate 2100 is formed by way of lithography. Next, the exposed portion of the substrate 2100 exposed from the resist film is removed by way of deep RIE such that etching progresses to reach the insulating film 2110, thus forming the opening 2101 in the substrate 2100. Then, the resist film is removed.

Next, as shown in FIG. 24K, prescribed portions of the insulating layer 2180 are removed so as to form various sections of the capacitor microphone 2001. Specifically, they are removed as follows:

First, a resist film is formed on the insulating film 2170 so as to cover a prescribed portion that remains as the support 2040. Next, the insulating film is removed by way of wet etching. Herein, an etching solution composed of hydrofluoric acid is used to etch the insulating film composed of $SiO_2$. The etching solution is infiltrated via the through holes 2032 of the conductive film 2161 and the opening 2101 of the substrate 2100 so as to dissolve the insulating film 2150, whereby the air gap 2050 is formed between the diaphragm 2010 and the back plate 2030, and the prescribed parts of the insulating film remain so as to form the support 2040.

Next, the exterior film 2121, the conductive film 2131, and the exterior film 2141 are simultaneously subjected to annealing and are thus adjusted in tension such that the total tension of the diaphragm 2010 becomes substantially zero. Specifically, the annealing is performed to realize the tensions of the thin films forming the diaphragm 2010 so as to satisfy the following equations (1) and (2), wherein $T_1$, $T_2$, and $T_3$ (MPa) designate residual stresses applied to the exterior film 2121, the conductive film 2131, and the exterior film 2141 after the annealing, and $t_1$, $t_2$, and $t_3$ (mm) designate the thicknesses of the exterior films 2121, the conductive film 2131, and the exterior film 2141, and wherein $T_1 \cdot t_1$ indicates the tension of the exterior film 2121, $T_2 \cdot t_2$ indicates the tension of the conductive film 2131, and $T_3 \cdot t_3$ indicates the tension of the exterior film 2141.

$$T_1 \cdot t_1 + T_2 \cdot t_2 + T_3 \cdot t_3 = 0 \quad \ldots (1)$$

$$T_1 \cdot t_1 = T_3 \cdot t_3 \quad \ldots (2)$$

More specifically, the tensions of the thin films forming the diaphragm 2010 are adjusted as follows:

The residual stress of the conductive film 2131 composed of phosphorus-doped polysilicon can be controlled to realize the tensile stress and compressive stress by controlling the annealing temperature to range from 800°C to 1000°C. Both of the residual stresses of the exterior films 2121 and 2141 composed of $Si_3N_4$ correspond to tensile stresses which do not vary by way of the annealing. That is, all of the conductive film 2131 and the exterior films 2121 and 2141 are simultaneously subjected to annealing so as to control the residual stress of the conductive film 2131 to match the compressive stress, thus adjusting the total tension of the diaphragm 2010 to become substantially zero.

Both of the exterior films 2121 and 2141 are composed of the same material and are formed in the same thickness. When the exterior films 2121 and 2141 are simultaneously subjected to annealing, it is possible to realize substantially the same tension to be applied to the exterior films 2121 and 2141.

According to the manufacturing method of the capacitor microphone 2001 described above, the thickness and annealing temperature are appropriately controlled with respect to the conductive film 2131 and the exterior films 2121 and 2141, whereby it is possible to sensitively adjust the total tension of the diaphragm 2010. Thus, it is possible to improve the sensitivity and characteristics of the capacitor microphone 2001.

Incidentally, it is possible to use any types of materials for the conductive film 2131 and the exterior films 2121 and 2141 under the condition in which the total tension of the diaphragm 2010 becomes substantially zero because one of the residual tensions applied to the exterior films 2121 and 2141 and the conductive film 2131 is controllable by way of annealing, and the other is not varied by way of annealing. Herein, the thicknesses of the exterior films 2121 and 2141 and the conductive film 2131 can be appropriately changed. For example, the exterior films 2121 and 2141 can be formed with different thicknesses respectively.

The total tension of the diaphragm 2010 can be adjusted by controlling only the thicknesses of the thin films forming the diaphragm 2010.

All the thin films forming the diaphragm 2010 are not necessarily subjected to simultaneous annealing; hence, the annealing timing can be changed as long as no technological problem occurs on the diaphragm 2010.

The third embodiment can be changed in design in a variety of ways; hence, variations of the third embodiment will be described below.

(1) First variation

A capacitor microphone of a first variation of the third embodiment is basically similar to the capacitor microphone 2001 of the third embodiment shown in FIG. 23 except for materials and manufacturing conditions of a diaphragm. Similar to the diaphragm 2010, the diaphragm of the first variation is formed using a conductive film, an exterior film attached onto the surface of the conductive film, and an exterior film attached onto the backside of the conductive film, which are designated using the same reference numerals shown in FIG. 23 for the sake of convenience.

In the first variation, the conductive film 2131 is composed of phosphorus-doped polysilicon, and both of the exterior films 2121 and 2141 are composed of no-impurity-doped polysilicon (hereinafter, referred to as non-dope polysilicon). Residual stresses of the exterior films 2121 and 2141 composed of non-dope polysilicon are compressive stresses, which are gradually released as the annealing temperature increases. The total tension of the diaphragm of the first variation is adjusted in response to differences of varying ratios between the tensions of the exterior films 2121 and 2141 and the tensions of the conductive film 2131 with respect to the annealing temperature. That is, all of the conductive film 2131 and the exterior films 2121 and 2141 are simultaneously subjected to annealing at a prescribed annealing temperature at which the residual stress of the conductive film 2131 acts as the tensile stress.

Incidentally, it is possible to use any types of materials for the formation of the conductive film 2131 and the exterior films 2121 and 2141 as long as differences lie in the varying ratios between the tensions of the exterior films 2121 and 2141 and the tension of the conductive film 2131 with respect to the annealing temperature, and the total tension of the diaphragm 2010 can be controlled to become substantially zero. Of course, it is possible to form them in any thicknesses.

(2) Second variation

A capacitor microphone of a second variation of the third embodiment is basically similar to the capacitor microphone 2001 of the third embodiment shown in FIG. 23 except for the configuration of a diaphragm.

FIG. 25 shows the configuration of a diaphragm 2310 adapted to the capacitor microphone of the second variation. The diaphragm 2310 is configured by a conductive film 2331 serving as a center layer, a first coating layer 2300, and a second coating layer 2302. The conductive film 2331 serves as a movable electrode. Each of the first coating layer 2300 and the second coating layer 2302 is formed as a multilayered film. The first coating layer 2300 is attached to the surface of the conductive film 2331, and the second coating layer 2302 is attached to the backside of the conductive film 2331. Incidentally, thin films forming the first coating layer 2300 can function as a movable electrode, or thin films forming the second coating layer 2302 can function as a movable electrode.

The direction of the tension applied to the first coating layer 2300 and the second coating layer 2302 is reverse to the direction of the tension applied to the conductive film 2331. The sum of the absolute values of the tensions applied to the first coating layer 2300 and the second coating layer 2302 is substantially identical to the absolute value of the tension applied to the conductive film 2331. A pair of thin films included in the first coating layer 2300 and the second coating layer 2302 sandwiching the conductive film 2331 have substantially the same tension. They are thin films forming the first coating layer 2300 and the second coating layer 2302, which sandwich the conductive film 2331 therebetween, and are arranged symmetrically in plane. That is, the tensions of the first coating layer 2300 and the second coating layer 2302 are distributed symmetrically in plane with respect to the conductive film 2331.

Specifically, the first coating layer 2300 has a two-layered structure consisting of an interior layer 2321 directly attached to the conductive film 2331 and an exterior film 2301, and the second coating layer 2302 has a two-layered structure consisting of an interior film 2341 directly attached to the conductive film 2331 and an exterior film 2303. Both of the interior films 2321 and 2341 are composed of the same material and are formed in the same thickness. Both of the exterior films 2301 and 2303 are composed of the same material and are formed in the same thickness. More specifically, both of the interior films 2321 and 2341 can be composed of the same material selected from among non-dope polysilicon, non-dope amorphous silicon, $Si_3N_4$, SiC, SiON, and $Al_2O_3$. When they are composed of amorphous silicon, it is preferable that they be annealed at a prescribed temperature sustaining the amorphous state. Both of the exterior films 2301 and 2303 are composed of the same material selected from among $Si_3N_4$, SiON, and $Al_2O_3$.

Similar to the third embodiment and its first variation, the tension of the diaphragm 2310 is adjusted by controlling the thicknesses of the thin films thereof and the annealing temperature, thus satisfying the following equations (3) and (4) with respect to the thin films forming the diaphragm 2310, wherein each of the first coating film 2300 and the second coating film 2302 has an N-layered structure (where N is an integer).

$$\sum_{n=1}^{2N+1} Tn \times tn = 0 \qquad \ldots (3)$$

$$T_n \cdot t_n = T_{N-n-1} \cdot t_{N-n-1} \qquad \ldots (4)$$

The capacitor microphone of the second variation is designed to have the diaphragm 2310 including the first coating layer 2300 and the second coating layer 2302, which are formed using thins films having slightly different varying ratios of tensions against the annealing temperature; hence, it is possible to reduce the varying ratio of the total tension of the diaphragm 2310 against the annealing temperature within a target range of tension. This makes it possible to sensitively adjust the total tension of the diaphragm 2310 by controlling the annealing.

The total tension of the diaphragm 2310 can be adjusted by simply controlling the thicknesses of the thin films forming the diaphragm 2310. All the thin films forming the diaphragm 2310 are not necessarily subjected to simultaneous annealing; hence, the annealing timing can be appropriately determined without causing technological problems. In addition, the first coating layer and the second coating layer 2302 are not necessarily arranged symmetrically in plane so as to sandwich the conductive film 2331 therebetween as long as the diaphragm 2310 realizes desired mechanical characteristics. Furthermore, the tensions of the first coating layer 2300 and the second coating layer 2302 are not necessarily distributed symmetrically in plane with respect to the conductive film 2331.

(c) Third variation

A capacitor microphone of a third variation is basically identical to the capacitor microphone 2001 of the third embodiment shown in FIG. 23 except for materials of thin films forming the diaphragm 2010.

In the third variation, both of the exterior films 2121 and 2141 are composed of a prescribed material having high resistance against hydrofluoric acid in comparison with the insulating layer 2180. Specifically, the prescribed material used for forming the exterior films 2121 and 2141 is increased in resistance against hydrofluoric acid in comparison with $SiO_2$ used for forming the insulating layer 2180 and is selected from among non-dope polysilicon, non-dope amorphous silicon, $Si_3N_4$, SiC, SiON, and $Al_2O_3$. When they are composed of amorphous silicon, it is preferable that they be annealed at a prescribed temperature sustaining the amorphous state.

Since both of the exterior films 2121 and 2141 have high resistance against hydrofluoric acid, it is possible to prevent the diaphragm 2010 from being dissolved due to hydrofluoric acid included in an etching solution in the foregoing step for partially removing the insulating film. Similar to the capacitor microphone 2001 of the third embodiment, the capacitor microphone of the third variation can be designed to adjust the tension of the diaphragm 2010 or not to adjust the tension of the diaphragm 2010.

(d) Fourth variation

A capacitor microphone of a fourth variation is basically identical to the capacitor microphone of the second variation except for materials used for the formation of the diaphragm 2310.

In the fourth variation, both of the exterior films 2301 and 2303 forming the diaphragm 2310 are composed of a prescribed material having high resistance against hydrofluoric acid in comparison with the insulating layer 2180. Thus, it is possible to prevent the diaphragm 2310 from being dissolved due to hydrofluoric acid included in an etching solution in the foregoing step (see FIG. 24K) for partially removing the insulating film.

Similar to the capacitor microphone of the second variation, the capacitor microphone of the fourth variation can be designed to adjust the tension of the diaphragm 2310 or not to adjust the tension of the diaphragm 2310. When the tension of the diaphragm 2310 is adjusted, all of the conductive film 2331 and the interior films 2321 and 2341 can be composed of prescribed materials each having low resistance against hydrofluoric acid; hence, it is possible to sensitively adjust the tension of the diaphragm 2310. This may greatly increase the displacement of the diaphragm 2310 in response to sound waves. That is, the capacitor microphone of the fourth variation is improved in terms of the mechanical characteristics of the diaphragm 2310.

When the thin films other than the exterior films 2310 and 2303 forming the diaphragm 2310 are composed of prescribed materials each having low resistance against hydrofluoric acid, it is possible to improve electric characteristics of the diaphragm 2310.

## 4. Fourth Embodiment

Next, a fourth embodiment of the present invention will be described in detail, wherein it is directed to an electrostatic capacitance sensor that is realized by a capacitor microphone 3001. FIG. 26 shows a multilayered laminated structure of thin films forming the capacitor microphone 3001, which is produced by way of semiconductor manufacturing processes.

### (a) Constitution

The capacitor microphone 3001 includes a plate 3033 and a diaphragm 3036, which are formed using conductive films 3012 and 3014 both composed of highly-concentrated-phosphorus-diffused polycrystal silicon. Highly-concentrated-phosphorus-diffused silicon may accumulate high tensile stress (e.g., 200 MPa) therein, whereas the tensile stress of the diaphragm 3036 is adjusted to be 20 MPa or less. The plate 3033 is subjected to special heat treatment, which differs from heat treatment adapted to the diaphragm 3036, so that the internal stress of the plate 3033 is increased to be higher than that of the diaphragm 3036 at about 100 MPa.

The conductive film 3012 joins an insulating film 3011 composed of silicon oxide, which is formed on a substrate 3010 composed of monocrystal silicon. An insulating film 3013 composed of silicon oxide joins between the conductive films 3012 and 3014. The insulating films 3011 and 3013 are subjected to patterning such that an air gap is formed between a prescribed portion of the conductive film 3012 and a prescribed portion of the conductive film 3014, the prescribed portion of the conducive film 3012 is extended in connection with a spacer 3035 formed by a remaining portion of the insulating film 3011, and the prescribed portion of the conductive film 3014 is extended in connection with a remaining portion of the insulating film 3013. The diaphragm 3036 is realized by the conductive film 3012 extended in connection with the remaining portion of the insulating film 3011. The entire portion of the diaphragm 3036 subjected to vibration forms a fixed electrode; however, a fixed electrode can be formed in a limited manner in connection with a part of the diaphragm 3036. For example, the diaphragm 3036 can be formed in a multilayered structure including a conductive film and an insulating film. The plate 3033 is realized by the conductive film 3014, which is extended in connection with a spacer 3032 formed by the remaining portion of the insulating film 3013. The entire portion of the plate 3033 facing the diaphragm 3036 forms a fixed electrode; however, a fixed electrode can be formed in a limited manner in connection with a part of the plate 3033. For example, the plate 3033 can be formed in a multilayered structure including a conductive film and an insulating film. A plurality of through holes are formed on the plate 3033 so as to transmit sound waves toward the diaphragm 3036.

A spacer 3035 is bridged between the prescribed portion of the conductive film 3012 and a remaining portion of the insulating film 3011, and a spacer 3035 is also bridged between the prescribed portion of the conductive film 3014 and a remaining portion of the insulating film 3013.

An electrode 3030 joins the conductive film 3012 so as to establish connection between the diaphragm 3036 and an external signal processing circuit (not shown). An electrode 3038 joins the conductive film 3014 so as to establish connection between the plate and the external signal processing circuit. An electrode 3039 joins a substrate 3010 so as to establish connection between the substrate 301 and a reference voltage terminal (not shown). All of the electrodes 3030, 3038, and 3039 are formed using conductive films composed of aluminum-silicon, for example.

A recess 3101 is formed just below the diaphragm 3036 in the substrate 3010. The opening of the recess 3101 is closed by a board in packaging. The recess 3101 forms a back cavity 3037 just below the diaphragm 3036. The back cavity 3037 communicates with an open air space via a plurality of through holes 3031 formed in the conductive film 3012. The spacer 3035 for supporting the diaphragm 3036 is divided in a circumferential direction of the diaphragm 3036, thus forming a channel (or channels) establishing communication between the back cavity 303 and the open air space.

### (b) Operation

The capacitor microphone 3001 is affixed to a board in packaging (not shown), wherein it operates upon application of a bias voltage between the diaphragm 3036 and the plate 3033. The diaphragm 3036 vibrates due to sound waves, which are transmitted through the through holes 3034 so as to reach the diaphragm 3036. Since the sound waves simply transmit through the plate 3033 via the through holes 3034, the plate 3033 is substantially held in a fixed state. That is, when the diaphragm 3036 vibrates relative to the plate 3033, variations occur on the capacitance of a capacitor formed between the diaphragm 3036 and the plate 3033. Such capacitance variations are converted into electric signals by means of the external signal processing circuit connected to the electrodes 3030, 3038, and 3039.

The diaphragm 3036 is formed using the conductive film 3012 whose internal stress is adjusted to 20 MPa or less and is thus extended over the spacer 3035 with relatively small tension. By reducing the tension of the diaphragm 3036 as described above, it is possible to increase the sensitivity of the capacitor microphone 3001.

When the diaphragm 3036 approaches the plate 3033, electrostatic attraction exerted between the diaphragm 3036 and the plate 3033 increases. When the diaphragm 3036 approaches close to the plate 3033 due to electrostatic attraction, the plate 3033 may be deflected so as to cause a pull-in event in which the diaphragm 3036 is absorbed by the plate 3033. The present embodiment increases the tension of the plate 3033 extended over the spacer 3032, wherein the internal stress of the conductive film 3014 forming the plate 3033 is adjusted at 100 MPa, which is higher than the internal stress of the conductive film 3012 forming the diaphragm 3036. By increasing the tension of the plate 3033, it is possible to avoid the occurrence of a pull-in event.

(c) Manufacturing method

Next, a manufacturing method of the capacitor microphone 3001 will be described in detail with reference to FIGS. 27A to 27Y

First, as shown in FIG. 27A, silicon oxide is deposited on the surface of a momocrystal silicon wafer serving as a substrate 3010 by way of CVD, thus forming an insulating film 3011. The insulating film 3011 is used for forming a spacer 3035 supporting a diaphragm 3036 and for insulating a conductive film 3012 from the substrate 3010.

Next, as shown in FIG. 27B, the conductive film 3012 serving as the diaphragm 3036 is deposited on the surface of the insulating film 3011 by way of decompression CVD. As described above, the conductive film 3012 is composed of highly-concentrated-phosphorus-doped polycrystal silicon. It is formed in situ by which dopant is introduced into the film simultaneously with deposition of the film, for example. Material gas is composed of $PH_3/SiH_4$ having a mole ratio of 0.155. Herein, relatively high tensile stress is accumulated in the conductive film 3012.

Next, as shown in FIG. 27C, a photoresist mask 3017 is formed to realize patterning of the conductive film 3012.

Next, as shown in FIG. 27D, unnecessary portions of the conductive film 3012 are removed using the photoresist mask 3017 by way of anisotropic dry etching. Thus, it is possible to form a plurality of through holes 3031 of the diaphragm 3036 and wirings for establishing connections between the diaphragm 3036 and the electrodes 3030, 3038, and 3039.

Crystal defects may inherently exist in the conductive film 3012, which is formed by way of deposition, and bring internal stress in the conductive film 3012. Since crystal defects can be repaired by heating, it is possible to control the internal stress of the conductive film 3012 by controlling the heating temperature and heating time.

As shown in FIG 27E, an in-product structure in which the photoresist mask 3017 is removed is subjected to first annealing so as to reduce the internal stress of the conductive film 3012 serving as the diaphragm 3036. Herein, annealing conductions are determined such that residual stress, which remains in the diaphragm 3036, is not adjusted in the first annealing, but final residual stress of the diaphragm 3036 is adjusted in second annealing, details of which will be described later. Suppose that the final residual stress of the diaphragm 3036 is about 20 MPa, wherein it is required that the diaphragm 3036 be heated at a prescribed temperature ranging from 900°C to 925°C (see FIG. 28) by performing lamp annealing one time. In light of a reduction of the internal stress of the diaphragm 3036 in the second annealing, lamp annealing is performed in the first annealing so as to heat the diaphragm 3036 for five to fifteen seconds at a prescribed temperature ranging from 850°C to 900°C.

Next, as shown in FIG. 27F, an air gap is formed between the diaphragm 303 and the plate 3033, and an insulating film 3013 is formed on the conductive film 3012 so as to insulate the conductive film 3012 (serving as the diaphragm 3036) from the conductive film 3014 (serving as the plate 3033). As described above, the insulating film 3013 is composed of silicon oxide and is formed by way of CVD using low-temperature gas, which does not affect the internal stress of the diaphragm 3036, for example.

Next, as shown in FIG. 27G, the conductive film 3014 serving as the plate 3033 is deposited on the surface of the insulating film 3013. The conductive film 3014 is composed of highly-concentrated-phosphorus-diffused polycrystal silicon, wherein it is formed in situ by which dopant is introduced into the film simultaneously with the deposition of the film. Material gas is composed of $PH_3/SiH_4$ whose mole ratio ranges from 0.1 to 0.5. Heating temperature for the formation of the conductive film 3014 ranges from 550°C to 650°C. At this time, relatively high tensile stress is accumulated in the conductive film 3014. Since the mole ratio of $PH_3/SiH_4$ is placed in $10^{-1}$ order realizing high concentration, it is expected to reduce the internal stress due to annealing.

Next, as shown in FIG. 27H, a photoresist mask 3015 is formed to realize patterning of the conductive film 3014.

Next, as shown in FIG. 27I, unnecessary portions of the conductive film 3014 are removed by way of anisotropic dry etching using the photoresist mask 3015. Thus, it is possible to form a plurality of through holes 3034 of the plate 3033 and wiring for establishing connection between the plate 3033 and the electrode 3038.

Next, as shown in FIG. 27J, the photoresist mask 3015 is removed.

Next, as shown in FIG. 27K, an insulating film 3016 is formed on the entire surface of an in-product structure (or a work) so as to cover the insulating film 3013 (composed of silicon oxide) and the conductive film 3014. The insulating film 3016 is formed by way of CVD using low-temperature gas, which does not affect the internal stress of the plate 3033 and the internal stress of the diaphragm 3036, for example. Specifically, the insulating film 3016 is formed by way of plasma CVD, which ensures the formation of the film in an atmosphere whose temperature is 400°C or less.

Next, as shown in FIG. 27L, a photoresist mask 3018 is formed so as to realize patterning of the insulating film 3016.

Next, as shown in FIG. 27M, wet etching and/or dry etching is performed using the photoresist film 3018 so as to form connection holes 163, 161, and 162 for establishing connections between the electrodes 3030, 3038, and 3039 and the substrate 3010, the conductive film 3012 (serving as the diaphragm 3036), and the conductive film 3012 (serving as the plate 3033) respectively.

Next, as shown in FIG. 27N, scribing lines (not shown) are formed on an in-product structure, in which the photoresist film 3018 is removed, so as to realize chip separation. Thus, channels are formed on the substrate 3010; hence, the insulating films 3011, 3013, and 3016 (which are laminated on the substrate 3010) are divided into individual chips.

Crystal defects may inherently exist in the conductive film 3014, which is formed by way of deposition, so as to cause internal stress in the conductive film 3014. Since crystal defects can be repaired by way of heating, it is possible to control the internal stress of the film by controlling the heating temperature and heating time.

After the formation of the scribing lines and before the formation of the electrodes 3030, 3038, and 3039, second annealing is performed so as to adjust the internal stress of the diaphragm 3036 and the internal stress of the plate 3033. The reasons the second annealing is performed at this timing are as follows:

When a silicon oxide film (e.g., the insulating film 3013) is heated at a high temperature, the internal stress thereof is changed from the tensile stress to the compressive stress. The first reason is that when a wafer (serving as the substrate 3010) is entirely covered with a gap-less silicon oxide film, cracks may likely occur due to the compressive stress. The second reason is that once the electrodes 3030, 3038, and 3039 are completely formed using low-melting-point materials, they cannot be heated at a high temperature.

The second annealing is performed to adjust the internal stress of the diaphragm 3036 to a final target value and to reduce the internal stress of the plate 3033. In order to leave a relatively high internal stress in the plate 3033 in comparison with the diaphragm 3036, the second annealing is performed at a relatively low temperature that is lower than the annealing temperature of the first annealing. Specifically, the first annealing is performed at a temperature ranging from 850°C to 900°C, while the second annealing is performed for five to fifteen seconds at a temperature of about 850°C. Due to such temperature setting, tensile stress of about 100 MPa remains in the plate 3033, and tensile stress of about 20 MPa remains in the diaphragam 3036.

Next, as shown in FIG. 27O, a conductive film 3019 is deposited on the entire surface of an in-product structure (or a work) so as to form the electrodes 3030, 3038, and 3039. The conductive film 3019 is composed of aluminum-silicon, for example.

Next, as shown in FIG. 27P, a photoresist film 3020 is formed to realize patterning of the conductive film 3019.

Next, as shown in FIG. 27Q, wet etching is performed using the photoresist mask 3020 so as to remove unnecessary portions of the conductive film 3019. Thus, it is possible to form the electrodes 3030, 3038, and 3039.

Next, as shown in FIG. 27R, the photoresist film 3020 is removed.

Next, as shown in FIG. 27S, the conductive films 3012 and 3014 deposited on the backside of the substrate 3010 are removed by way of polishing.

Next, as shown in FIG. 27T, a photoresist mask 3021 is formed to form a recess 3101 in the substrate 3010.

Next, as shown in FIG. 27U, anisotropic dry etching is performed using the photoresist mask 3021 so as to form the recess 3101 in the substrate 3010.

Next, as shown in FIG. 27V, the photoresist mask 3021 is removed.

Next, as shown in FIG. 27W, a photoresist mask 3022 is formed to realize patterning of the insulating film 3016. Wet etching is performed using the photoresist mask 3022 so as to remove a prescribed portion of the insulating film 3016, thus partially exposing the insulating film 3013 in an area between the conductive film 3014 (serving as the plate 3033) and the conductive film 3012 (serving as the diaphragm 3036).

Next, as shown in FIG. 27X, wet etching is performed using buffered hydrofluoric acid so as to remove an unnecessary portion of the insulating film 3013, which is exposed between the photoresist mask 3022 and the conductive film 3014 and via the through holes 3034, and an unnecessary portion of the insulating film 3011, which is exposed via the recess 3101. Thus, it is possible to form the spacers 3035 and 3032 and to form an air gap between the diaphragm 3036 and the plate 3033.

Lastly, as shown in FIG. 27Y, the photoresist mask 3022 is removed; then, the substrate 3010 is divided along scribing lines (not shown), thus completely producing the capacitor microphone 3001.

The fourth embodiment can be further varied within the scope of the invention. For example, the diaphragm 3036 and the plate 3033 can be composed of other materials such as germanium (Ge) and carbon other than polycrystal silicon (or polysilicon). It is possible to use boron (B) and arsenic (Ar) as impurities diffused into the diaphragm 3036 and the plate 3033.

The fourth embodiment is not necessarily applied to the capacitor microphone 3001 but is applicable to a pressure sensor and the like.

Lastly, the present invention is not necessarily limited to the aforementioned embodiments and variations, which are illustrative and not restrictive; hence, further embodiments and variations can be created within the scope of the invention defined by the appended claims.

## Claims

1. A capacitor microphone comprising:

   a fixed electrode that is positioned to cover a plurality of inner holes of a ring-shaped support; and
   a diaphragm that is positioned opposite to the fixed electrode with a prescribed air gap therebetween,
   wherein due to electrostatic attraction caused by applying a bias voltage between the fixed electrode and the diaphragm, tensile stress occurs on the diaphragm, which is thus deflected to approach the fixed electrode.

2. A diaphragm that is positioned opposite to a fixed electrode for covering a plurality of inner holes of a ring-shaped support with a prescribed air gap therebetween in a capacitor microphone, wherein compressive stress is applied to the diaphragm in advance, so that when the diaphragm is deflected to approach the fixed electrode due to electrostatic attraction caused by applying a bias voltage between the fixed electrode and the diaphragm, internal stress that occurs on the diaphragm is eliminated.

3. A diaphragm according to claim 2, which is formed by laminating a tensile stress film having tensile stress and a compressive stress film having compressive stress.

4. A diaphragm according to claim 3, wherein the tensile stress film is composed of a polycrystal silicon film, into which impurities are doped, and the compressive stress film is composed of a polycrystal silicon film or a non-crystal silicon film, into which no impurity is doped.

5. A diaphragm according to claim 3, wherein the compressive stress film is composed of a non-crystal amorphous silicon film, which is subjected to annealing at a prescribed temperature sustaining an amorphous state.

6. A manufacturing method for a capacitor microphone in which a diaphragm is positioned opposite to a fixed electrode for covering a plurality of inner holes of a ring-shaped support with a prescribed air gap therebetween, said manufacturing method comprising the steps of:

   annealing a conductive film serving as the diaphragm; and
   applying compressive stress to the diaphragm in advance,
   whereby when the diaphragm is deflected to approach the fixed electrode due to electrostatic attraction caused by applying a bias voltage between the fixed electrode and the diaphragm, internal stress that occurs on the diaphragm is eliminated.

7. The manufacturing method for a capacitor microphone according to claim 6, wherein the diaphragm is formed by laminating an impurities-doped polycrystal silicon film and a no-impurity-doped polycrystal silicon film or a no-impurity-doped non-crystal silicon film, and wherein annealing is performed independently on the impurities-doped polycrystal silicon film and is performed independently on the no-impurity-doped polycrystal silicon film or the no-impurity-doped non-crystal silicon film.

8. The manufacturing method for a capacitor microphone according to claim 6, wherein the diaphragm is formed by laminating an impurities-doped polycrystal silicon film and a no-impurity-doped polycrystal silicon film or a no-impurity-doped non-crystal silicon film, and wherein annealing is performed on a laminated structure composed of the impurities-doped polycrystal silicon film and the no-impurity-doped polycrystal silicon film or the no-impurity-doped non-crystal silicon film.

9. A capacitor microphone comprising:

   a fixed electrode for covering a plurality of inner holes of a ring-shaped support; and
   a diaphragm that is positioned opposite to the fixed electrode with a prescribed air gap therebetween,
   wherein compressive stress is applied to the diaphragm in advance, so that when the diaphragm is deflected to approach the fixed electrode due to electrostatic attraction caused by applying a bias voltage between the fixed electrode and the diaphragm, internal stress that occurs on the diaphragm is eliminated.

10. A capacitor microphone according to claim 9, wherein the diaphragm is formed by laminating a tensile stress film having tensile stress and a compressive stress film having compressive stress.

**11.** A capacitor microphone according to claim 10, wherein the tensile stress film is composed of a polycrystal silicon film, into which impurities are doped, and the compressive stress film is composed of a polycrystal silicon film or a non-crystal silicon film, into which no impurity is doped.

**12.** A capacitor microphone according to claim 10, wherein the compressive stress film is composed of a non-crystal amorphous silicon film, which is subjected to annealing at a prescribed temperature sustaining an amorphous state.

**13.** A manufacturing method for a diaphragm, comprising the steps of:

forming a first thin film by way of deposition; and
forming a second thin film whose internal stress differs from internal stress of the first thin film,
wherein a multilayered structure is formed by combining the first thin film and the second thin film, thus adjusting total internal stress.

**14.** The manufacturing method for a diaphragm according to claim 13, wherein the first thin film is subjected to annealing so as to reduce the internal stress thereof, and wherein the total internal stress of the multilayered structure is adjusted by controlling thickness of the second thin film deposited on a surface of the first thin film.

**15.** The manufacturing method for a diaphragm according to claim 13, wherein the first thin film is subjected to annealing so as to reduce the internal stress thereof, and wherein a part of the second thin film deposited on a surface of the first thin film is subjected to etching, thus adjusting the total internal stress of the multilayered structure.

**16.** The manufacturing method for a diaphragm according to claim 13, wherein the second thin film is deposited on a surface of the first thin film, and wherein both of the first thin film and the second thin film are simultaneously subjected to annealing, thus adjusting the total internal stress of the multilayered structure.

**17.** A diaphragm comprising:

a first thin film; and
a second thin film that is attached onto a surface of the first thin film and whose internal stress differs from internal stress of the first thin film,
wherein a multilayered structure whose periphery is completely fixed is formed using the first thin film and the second thin film.

**18.** A diaphragm according to claim 17, wherein the second thin film is narrower than the first thin film and is shaped in a radial manner.

**19.** A diaphragm according to claim 17, wherein the first thin film is composed of polycrystal silicon, and the second thin film is composed of an insulating material.

**20.** A diaphragm according to claim 17, wherein the first thin film is composed of impurities-doped polycrystal silicon, and the second thin film is composed of no-impurity-doped polysilicon or no-impurity-doped non-crystal silicon.

**21.** A capacitor microphone comprising:

a plate having a fixed electrode and a plurality of through holes;
a diaphragm having a movable electrode, which vibrates in response to sound waves; and
a spacer for supporting the plate and the diaphragm to be insulated from each other, thus forming an air gap between the fixed electrode and the movable electrode,
wherein the diaphragm includes a first thin film and a second thin film that is attached onto a surface of the first thin film and whose internal stress differs from internal stress of the first thin film, and wherein a multilayered structure whose periphery is completely fixed is formed using the first thin film and the second thin film.

**22.** A capacitor microphone according to claim 21, wherein the second thin film is narrower than the first thin film and is shaped in a radial manner.

**23.** A capacitor microphone according to claim 21, wherein the first thin film is composed of polycrystal silicon, and the second thin film is composed of an insulating material.

**24.** A capacitor microphone according to claim 21, wherein the first thin film is composed of impurities-doped polycrystal silicon, and the second thin film is composed of no-impurity-doped polysilicon or no-impurity-doped non-crystal silicon.

**25.** A capacitor microphone comprising:

a plate having a fixed electrode and a plurality of through holes;
a diaphragm having a movable electrode, which vibrates in response to sound waves; and
a spacer for supporting the plate and the diaphragm to be insulated from each other, thus forming an air gap between the fixed electrode and the movable electrode,

wherein the diaphragm is formed in a multilayered structure including a first thin film having conduction property and a second thin film, which is composed of an insulating material or no-impurity-doped polycrystal silicon or no-impurity-doped non-crystal silicon, and
wherein the second thin film is attached to the first thin film in proximity to the plate.

**26.** A capacitor microphone according to claim 21 or 25, wherein the second thin film is composed of a non-crystal amorphous silicon film, which is subjected to annealing at a prescribed temperature sustaining an amorphous state.

**27.** A diaphragm comprising:

a center layer having a single-layered structure;
a first coating layer attached to a surface of the center layer; and
a second coating layer attached to a backside of the center layer.

**28.** A diaphragm according to claim 27, wherein a direction of tension applied to each of the first coating layer and the second coating layer is reverse to a direction of tension applied to the center layer.

**29.** A diaphragm according to claim 28, wherein a sum of absolute values of tensions applied to the first coating layer and the second coating layer respectively is substantially identical to an absolute value of tension applied to the center layer.

**30.** A diaphragm according to claim 28, wherein each of the first coating layer and the second coating layer differs from the center layer in terms of composition.

**31.** A diaphragm according to claim 28, wherein both of the first coating layer and the second coating layer have a same composition.

**32.** A diaphragm according to claim 27, wherein each of the first coating layer and the second coating layer has a single-layered structure.

**33.** A diaphragm according to claim 32, wherein each of the first coating layer and the second coating layer has resistance against hydrofluoric acid.

**34.** A diaphragm according to claim 27, wherein each of the first coating layer and the second coating layer has a multilayered structure.

**35.** A diaphragm according to claim 34, wherein both of exterior films forming the first coating layer and the second coating layer on either side of the center layer have resistance against hydrofluoric acid.

**36.** A capacitor microphone comprising:

a plate having a fixed electrode and a plurality of through holes;
a diaphragm having a movable electrode, which vibrates due to sound waves; and
a spacer for supporting the plate and the diaphragm with an air gap between the fixed electrode and the movable electrode,
wherein the diaphragm includes
a center layer having a single-layered structure,
a first coating layer attached to a surface of the center layer, and
a second coating layer attached to a backside of the center layer.

**37.** A capacitor microphone according to claim 36, wherein a direction of tension applied to each of the first coating layer and the second coating layer is reverse to a direction of tension applied to the center layer.

**38.** A capacitor microphone according to claim 37, wherein a sum of absolute values of tensions applied to the first coating layer and the second coating layer respectively is substantially identical to an absolute value of tension applied to the center layer.

**39.** A capacitor microphone according to claim 36, wherein each of the first coating layer and the second coating layer has resistance against hydrofluoric acid.

**40.** A manufacturing method for a diaphragm, comprising the steps of:

forming a first coating layer by way of deposition;
forming a center layer, which has a single-layered structure and in which a direction of tension applied thereto is reverse to a direction of tension applied to the first coating layer, on the first coating layer;
forming a second coating layer, in which a direction of tension applied thereto is reverse to a direction of tension applied to the center layer, on the center layer,
wherein total tension is adjusted by the first coating layer and the second coating layer sandwiching the center layer.

**41.** The manufacturing method for a diaphragm according to claim 40, wherein each of the center layer, the first coating layer, and the second coating layer is controlled in thickness so as to adjust total tension.

**42.** The manufacturing method for a diaphragm according to claim 40, wherein a sum of absolute values of tensions applied to the first coating layer and the second coating layer respectively is substantially identical to an absolute value of tension applied to the center layer.

**43.** The manufacturing method for a diaphragm according to claim 40, wherein each of the first coating layer and the second coating layer differs from the center layer in terms of composition.

**44.** The manufacturing method for a diaphragm according to claim 40, wherein both of the first coating layer and the second coating layer have a same composition.

**45.** The manufacturing method for a diaphragm according to claim 40 further comprising the step of:

simultaneously annealing the center layer, the first coating layer, and the second coating layer, thus adjusting total tension.

**46.** A manufacturing method for an electrostatic capacitance sensor, comprising the steps of:

depositing a first film serving as a diaphragm having a movable electrode;
annealing the first film at a first temperature; and
depositing a second film serving as a plate having a fixed electrode, which is positioned opposite to the movable electrode.

**47.** The manufacturing method for an electrostatic capacitance sensor according to claim 46 further comprising the step of:

after completion of deposition of the second film serving as the plate, annealing the first film and the second film at a second temperature.

**48.** The manufacturing method for an electrostatic capacitance sensor according to claim 47, wherein the second temperature is lower than the first temperature.

**49.** The manufacturing method for an electrostatic capacitance sensor according to claim 46 further comprising the steps of:

forming a silicon oxide film between the first film and the second film;
dividing the silicon oxide film into individual chips; and
annealing the first film and the second film at a second temperature, which is lower than the first temperature.

**50.** The manufacturing method for an electrostatic capacitance sensor according to claim 49, wherein the silicon oxide film is processed at a third temperature, which is lower than the first temperature and the second temperature.

**51.** The manufacturing method for an electrostatic capacitance sensor according to claim 46, wherein both of the first film and the second film have a same composition.

**52.** The manufacturing method for an electrostatic capacitance sensor according to claim 46, wherein both of the first film and the second film are composed of impurities-diffused polycrystal silicon.

**53.** The manufacturing method for an electrostatic capacitance sensor according to claim 46, wherein both of the first film and the second film are composed of phosphorus-doped polycrystal silicon.

**54.** An electrostatic capacitance sensor comprising:

a diaphragm having a movable electrode, which is formed by way of deposition of a first film; and
a plate having a fixed electrode positioned opposite to the movable electrode, wherein the plate is formed by way of deposition of a second film,
wherein the diaphragm and the plate are subjected to different heat treatments and are thus adjusted in internal stresses respectively.

FIG. 1

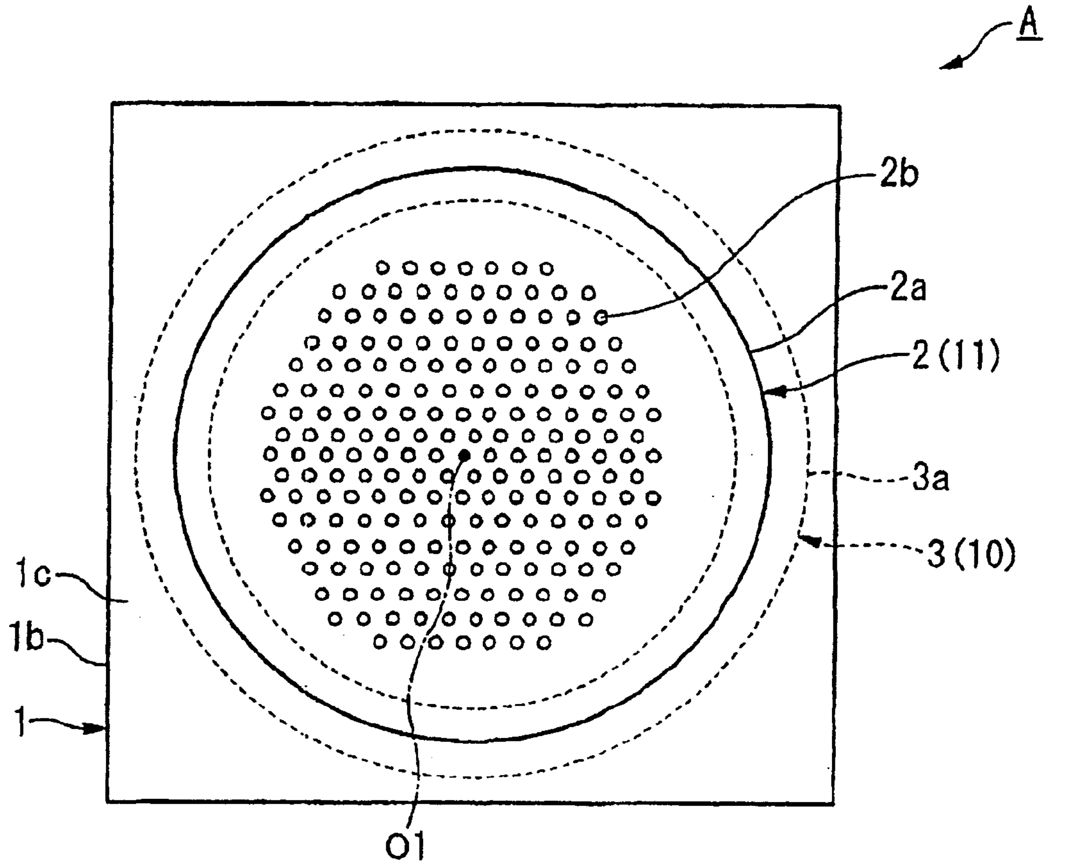
A
2b
2a
2 (11)
3a
3 (10)
1c
1b
1
O1

FIG. 2

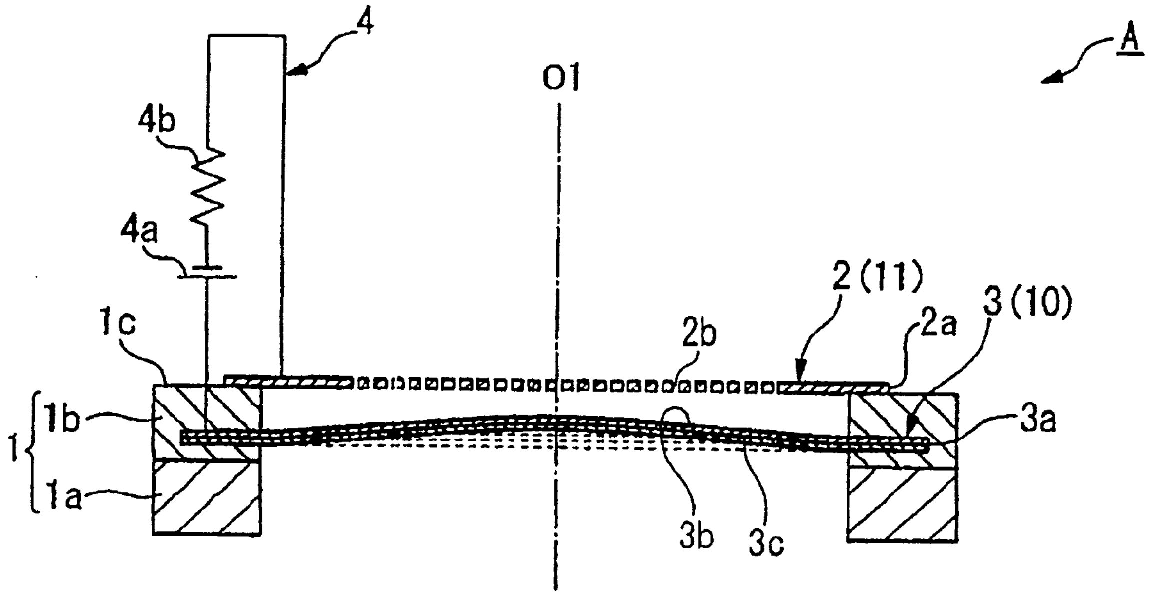
4
A
O1
4b
4a
2 (11)
3 (10)
1c
2b
2a
1b
3a
1
1a
3b
3c

FIG. 3

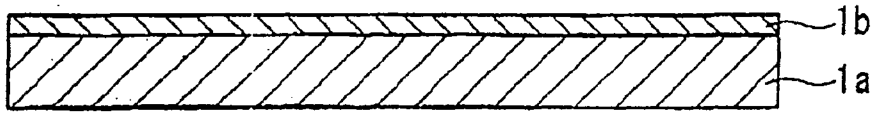


FIG. 4

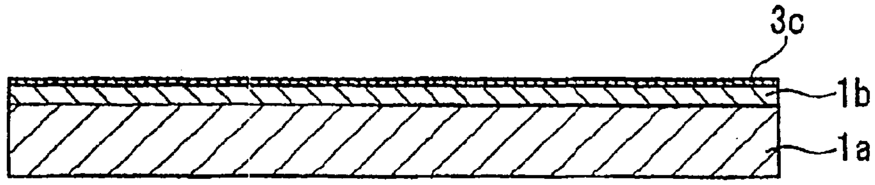


FIG. 5

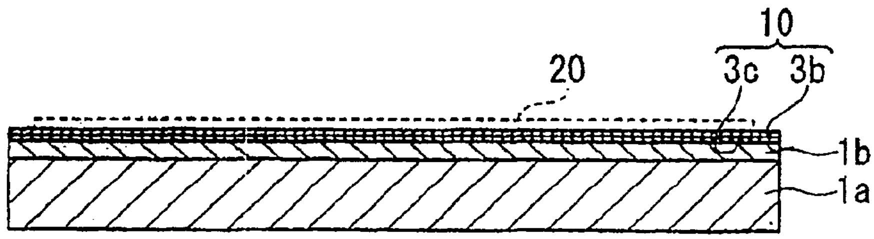


FIG. 6

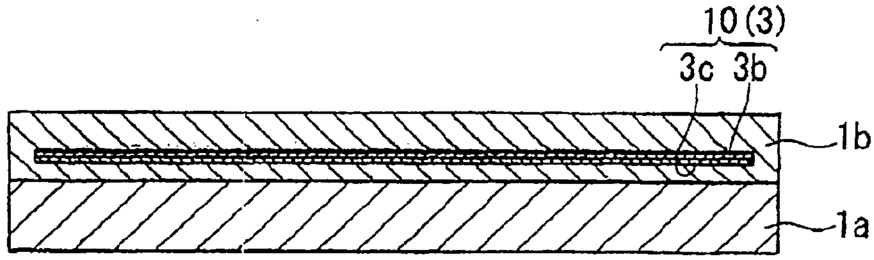


FIG. 7

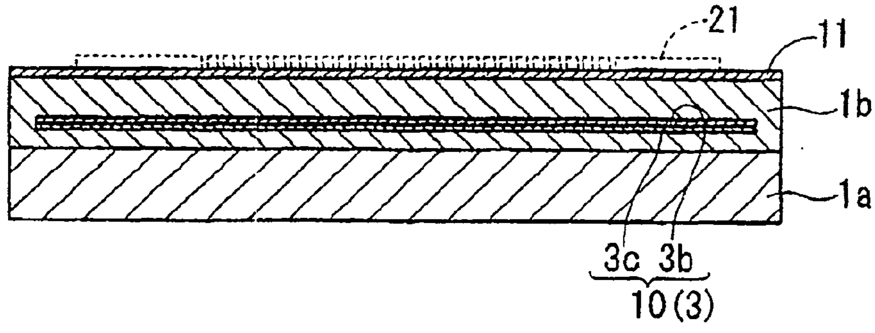

FIG. 8

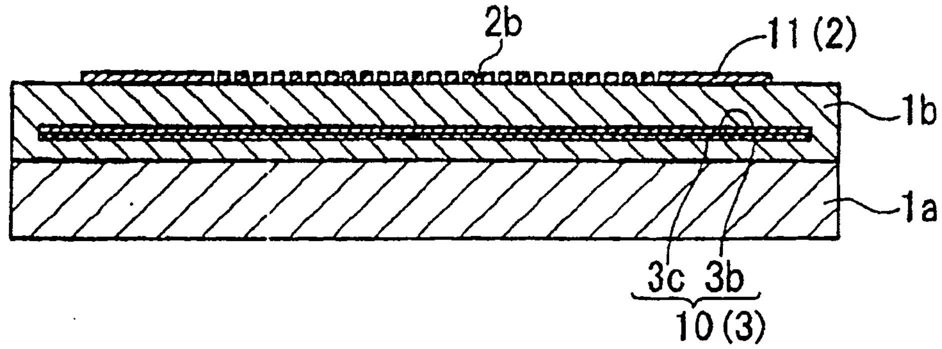


FIG. 9

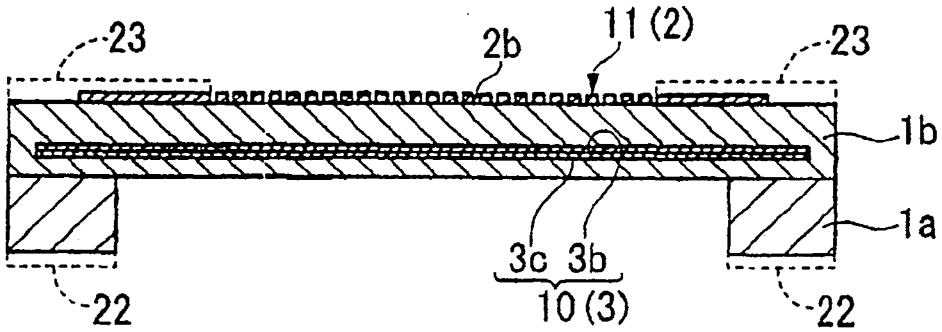


FIG. 10

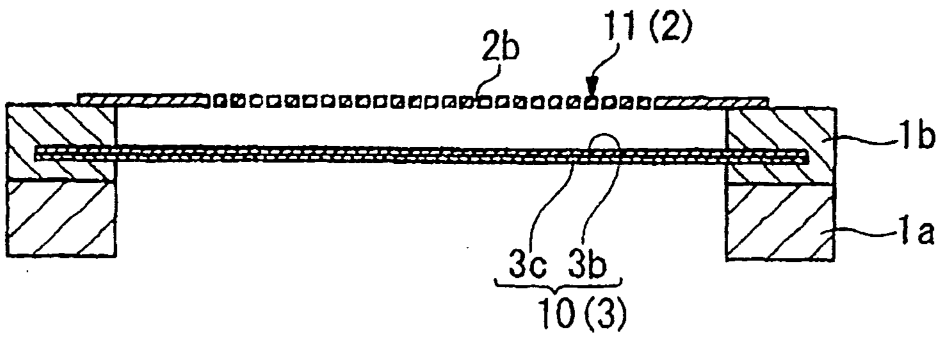

FIG. 11

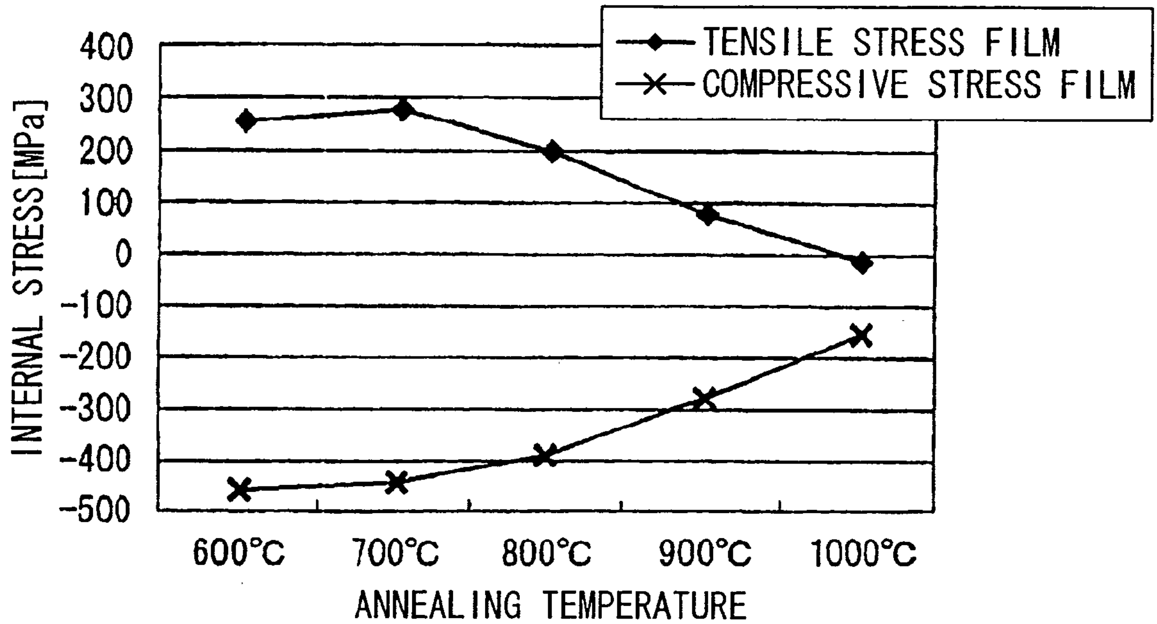
TENSILE STRESS FILM
COMPRESSIVE STRESS FILM
400
300
200
100
0
-100
-200
-300
-400
-500
INTERNAL STRESS [MPa]
600°C
700°C
800°C
900°C
1000°C
ANNEALING TEMPERATURE

FIG. 12

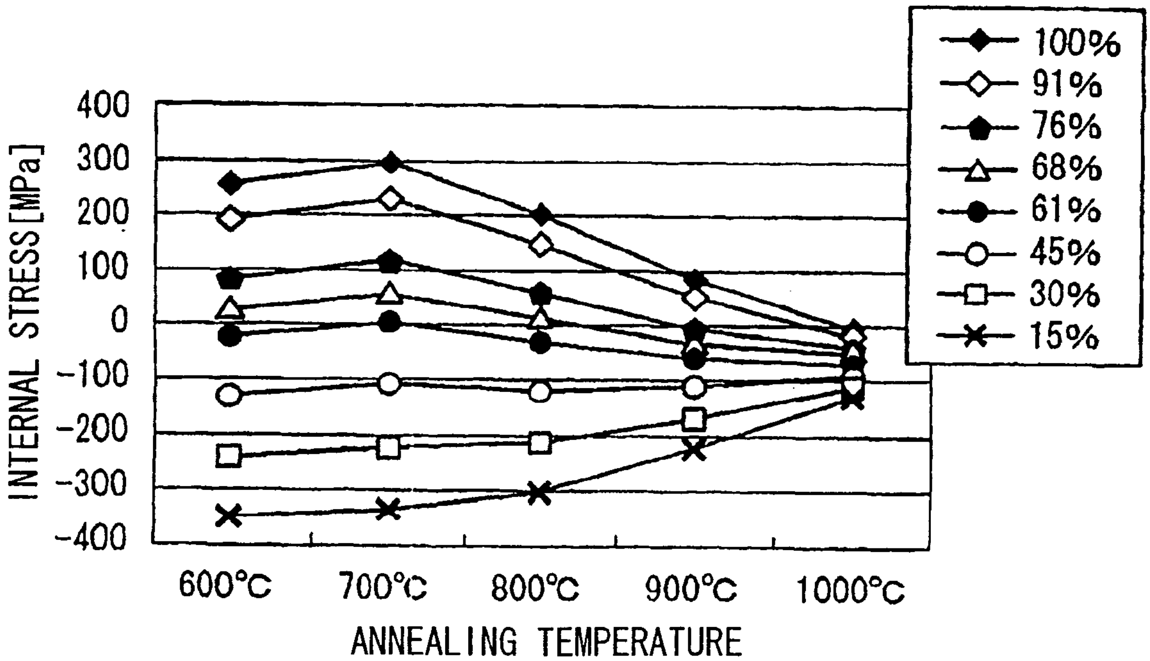
100%
91%
76%
68%
61%
45%
30%
15%
400
300
200
100
0
-100
-200
-300
-400
INTERNAL STRESS [MPa]
600°C
700°C
800°C
900°C
1000°C
ANNEALING TEMPERATURE

FIG. 13

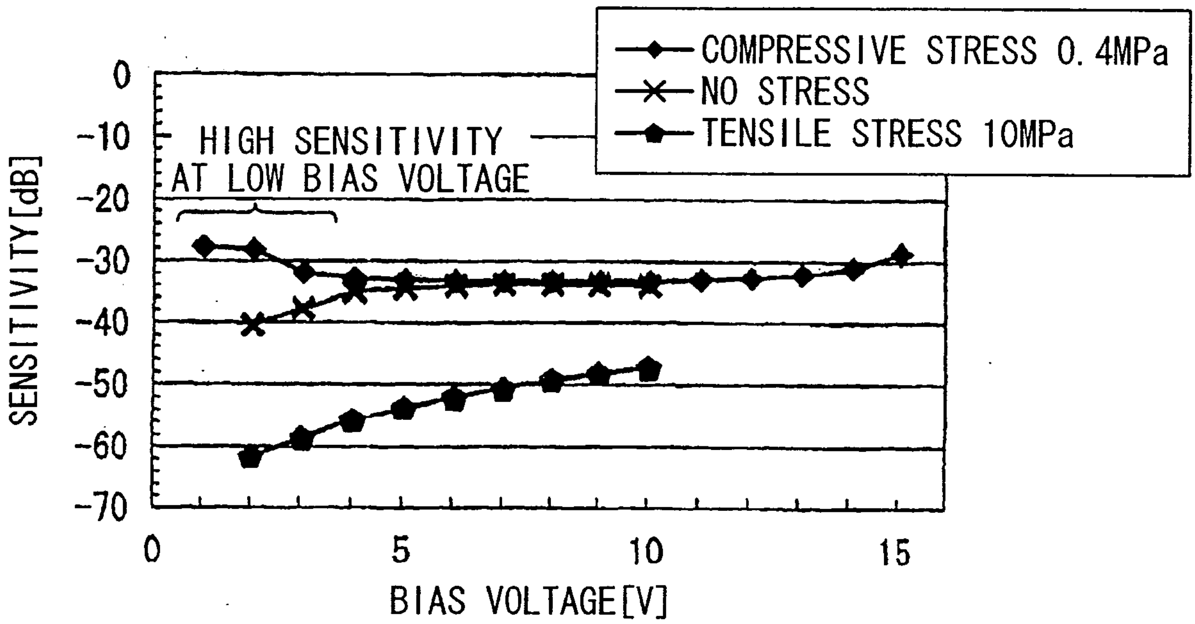
COMPRESSIVE STRESS 0.4MPa
NO STRESS
TENSILE STRESS 10MPa
HIGH SENSITIVITY
AT LOW BIAS VOLTAGE
SENSITIVITY[dB]
0
-10
-20
-30
-40
-50
-60
-70
0
5
10
15
BIAS VOLTAGE[V]

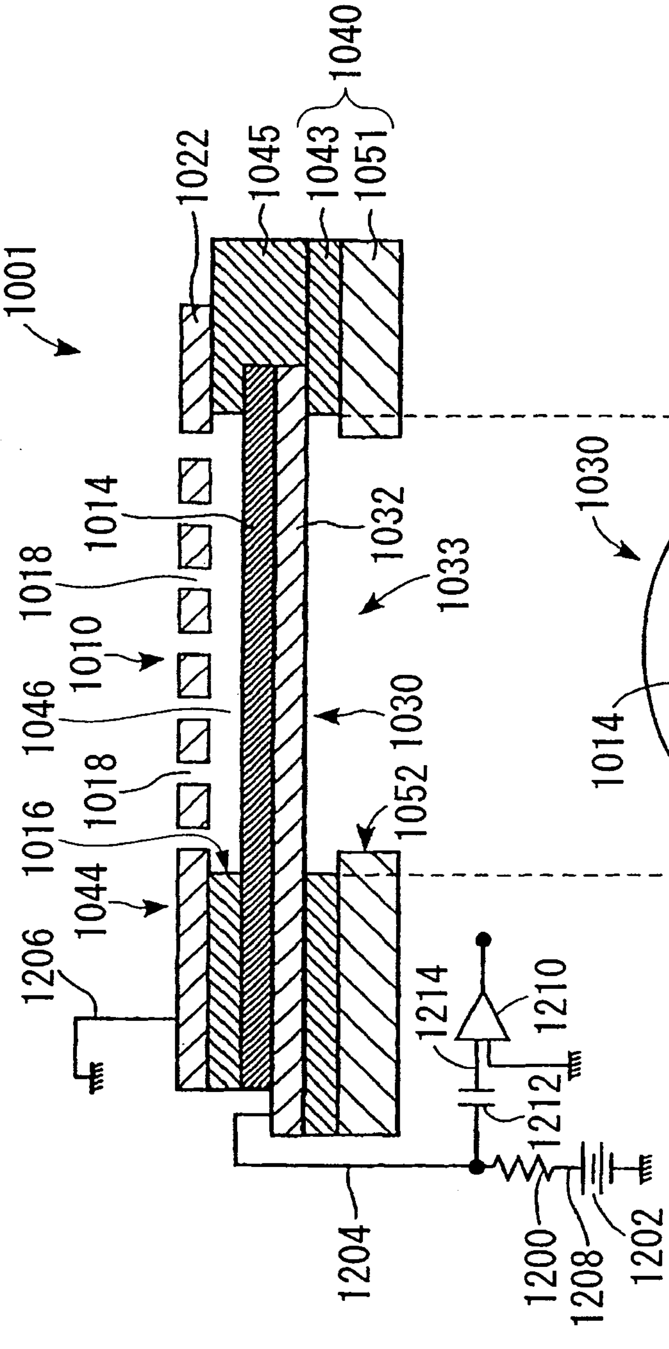


FIG. 14A

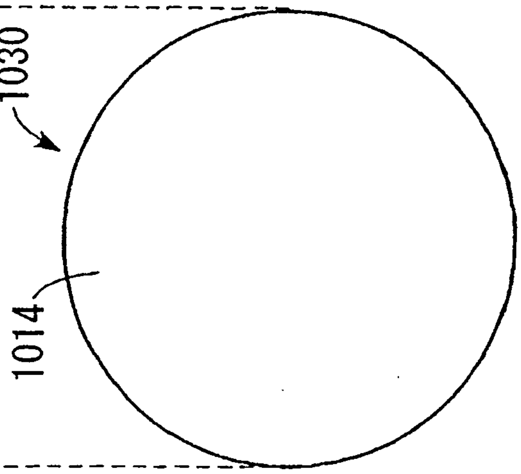


FIG. 14B

FIG. 15A

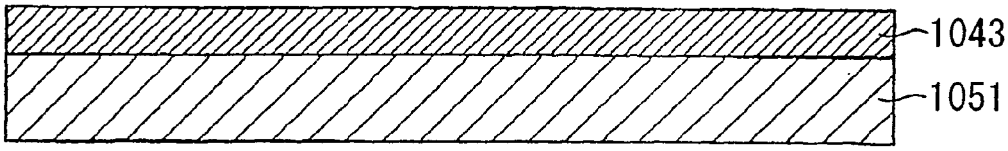


FIG. 15B

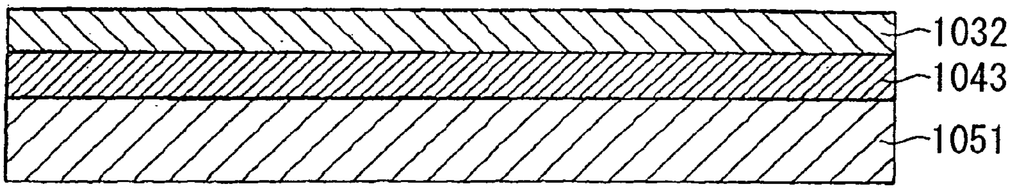


FIG. 15C

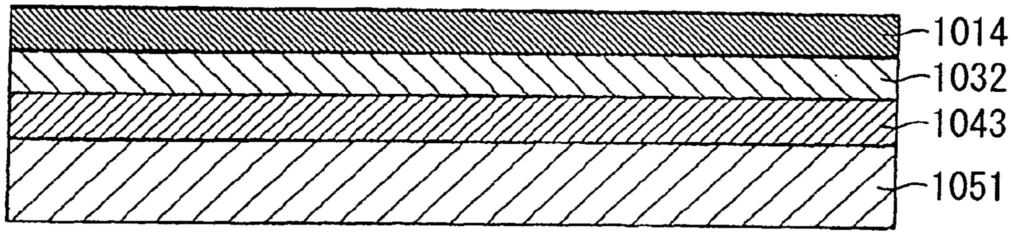


FIG. 15D

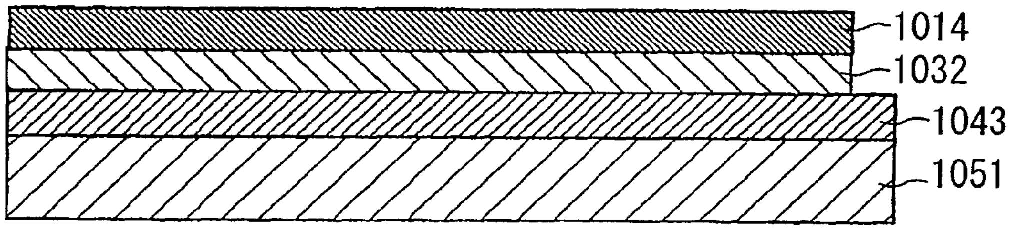


FIG. 15E

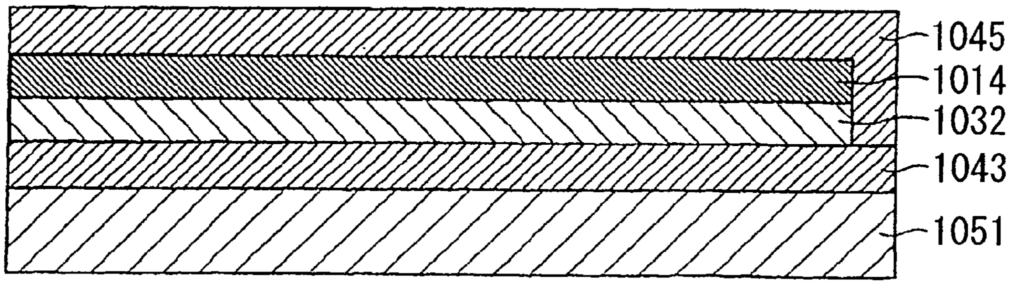

FIG. 15F

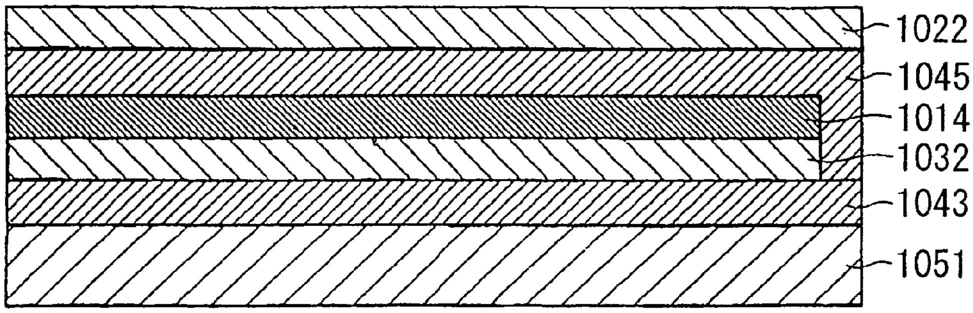


FIG. 15G

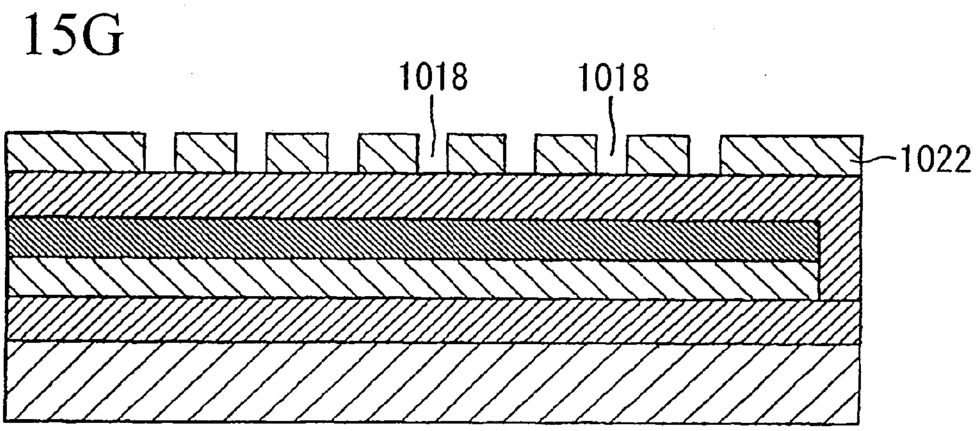


FIG. 15H

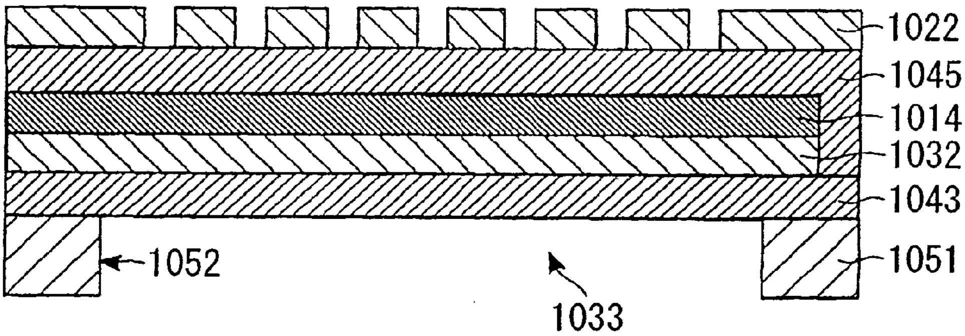


FIG. 15I

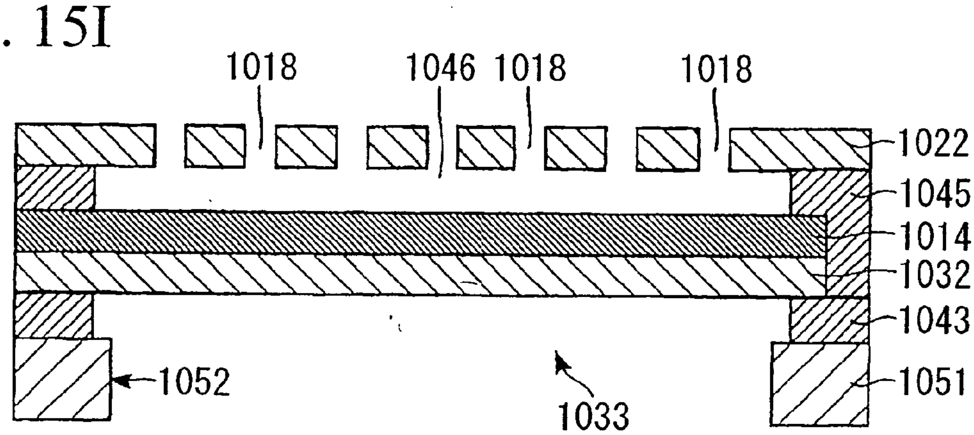

FIG. 16

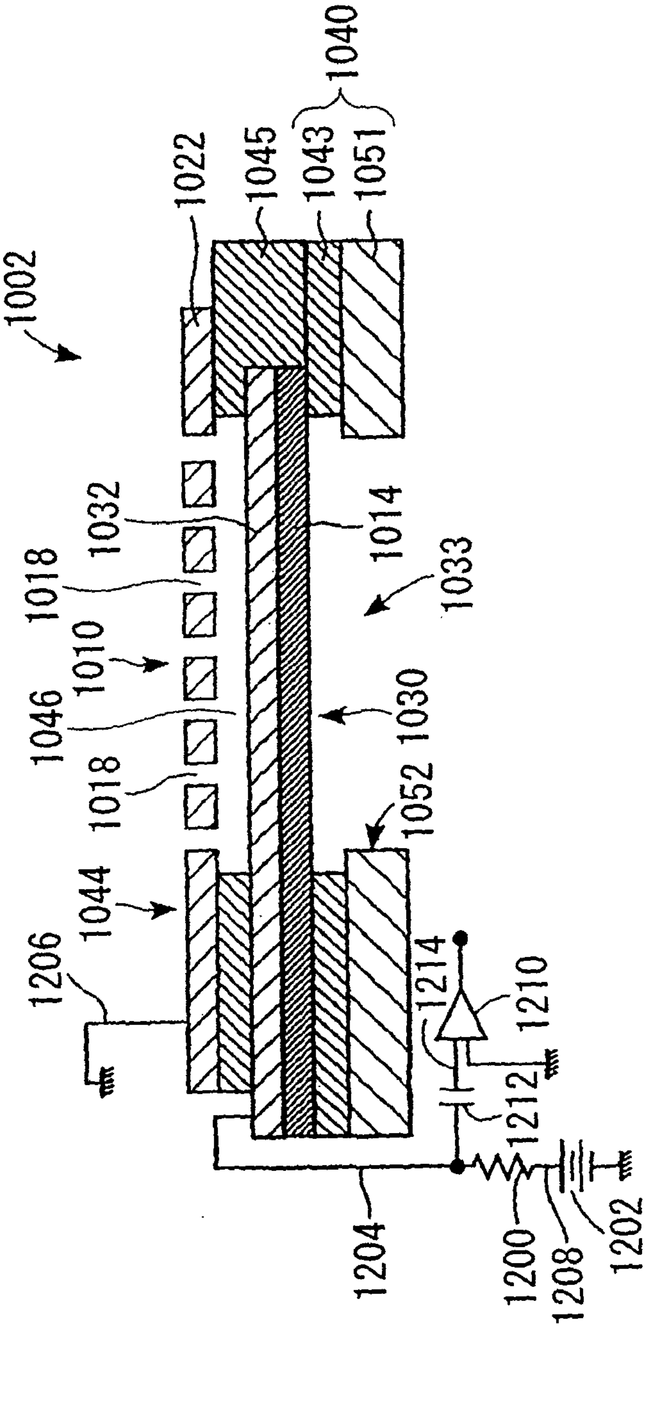
1002
1022
1045
1043
1051
1040
1032
1014
1033
1018
1010
1046
1030
1018
1052
1044
1206
1214
1210
1212
1204
1200
1208
1202

FIG. 17A

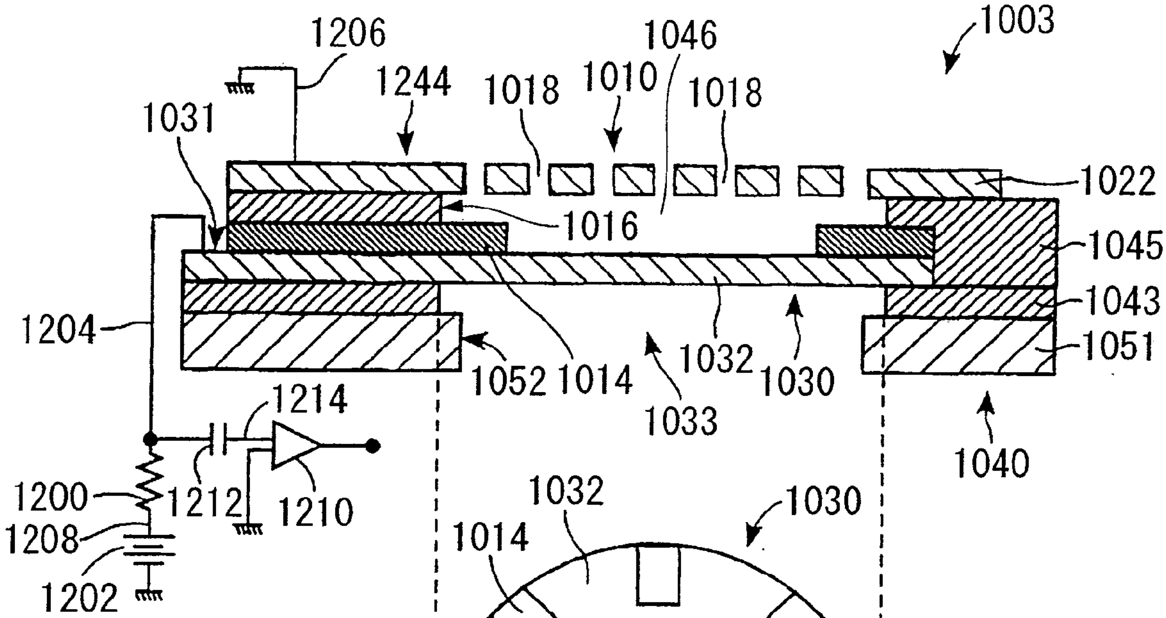


FIG. 17B

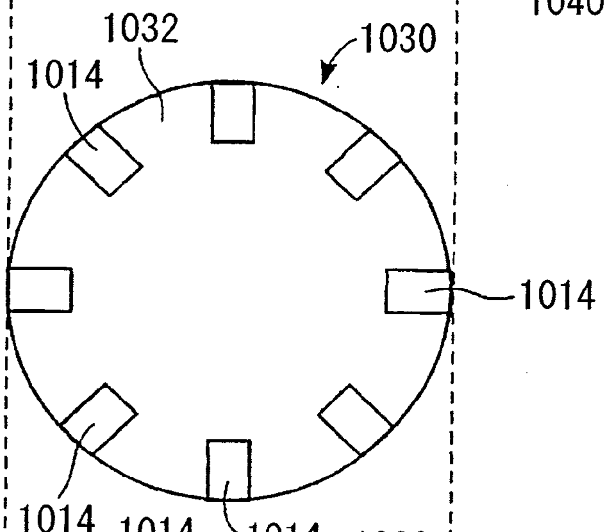


FIG. 17C

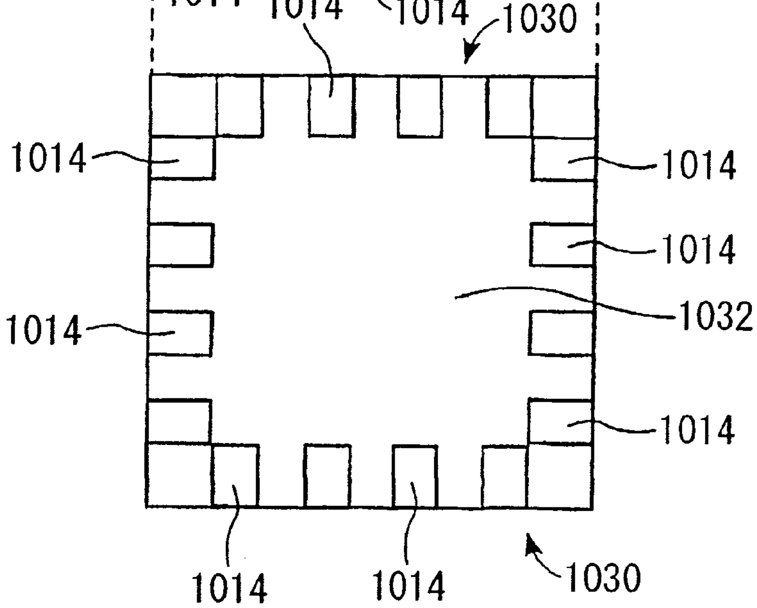

FIG. 18A

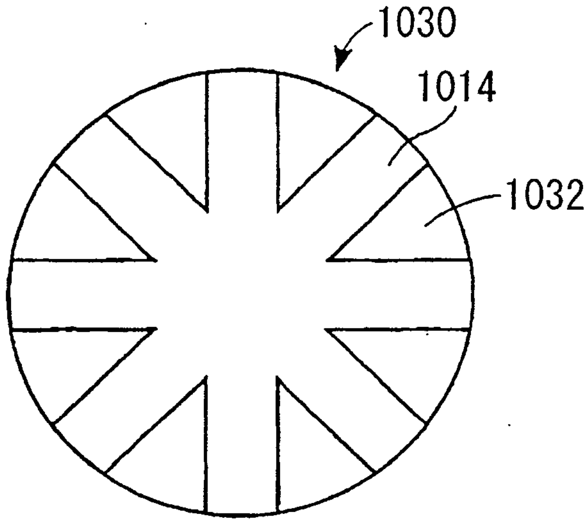


FIG. 18B

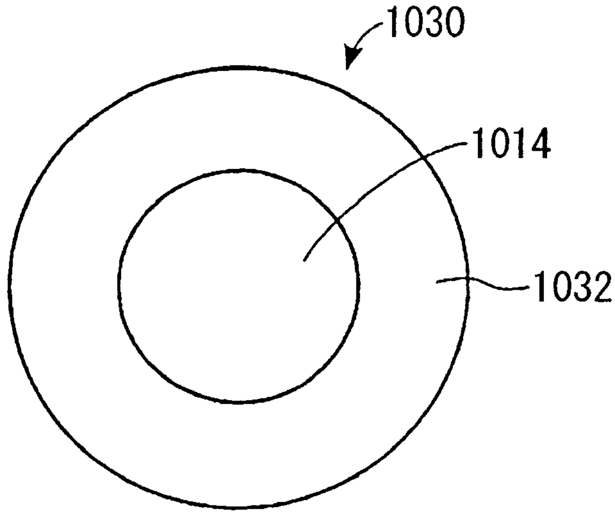

FIG. 19A

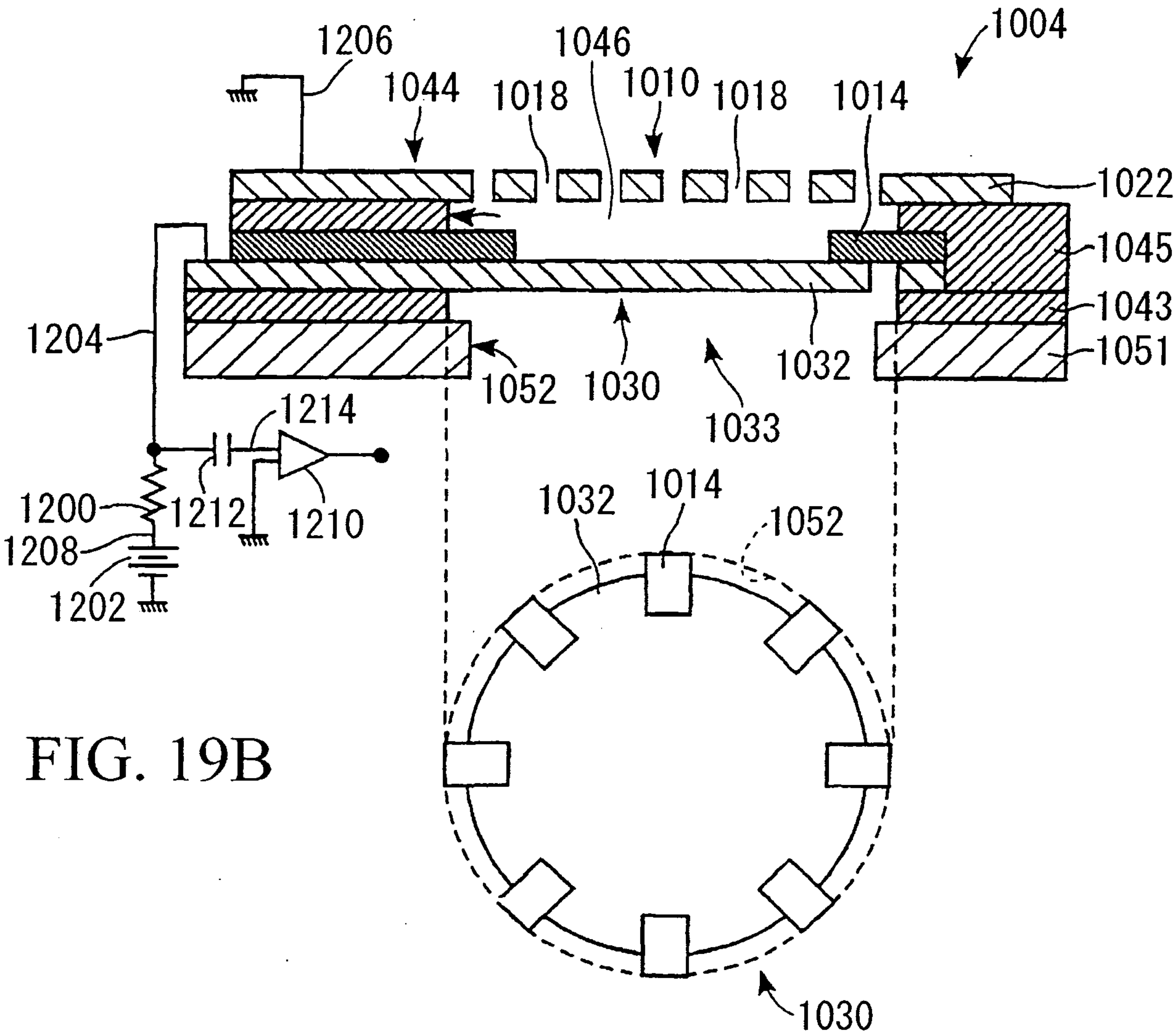


FIG. 19B

FIG. 20

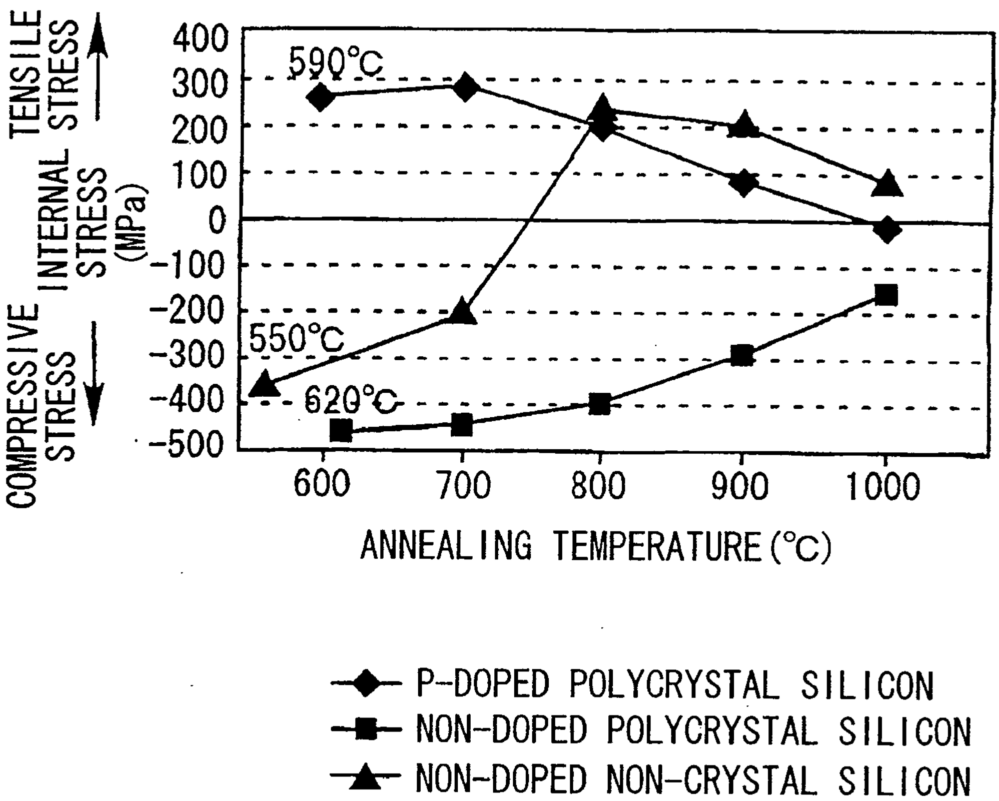
TENSILE STRESS
INTERNAL STRESS (MPa)
COMPRESSIVE STRESS
400
300
200
100
0
-100
-200
-300
-400
-500
590°C
550°C
620°C
600
700
800
900
1000
ANNEALING TEMPERATURE (°C)
P-DOPED POLYCRYSTAL SILICON
NON-DOPED POLYCRYSTAL SILICON
NON-DOPED NON-CRYSTAL SILICON

FIG. 21

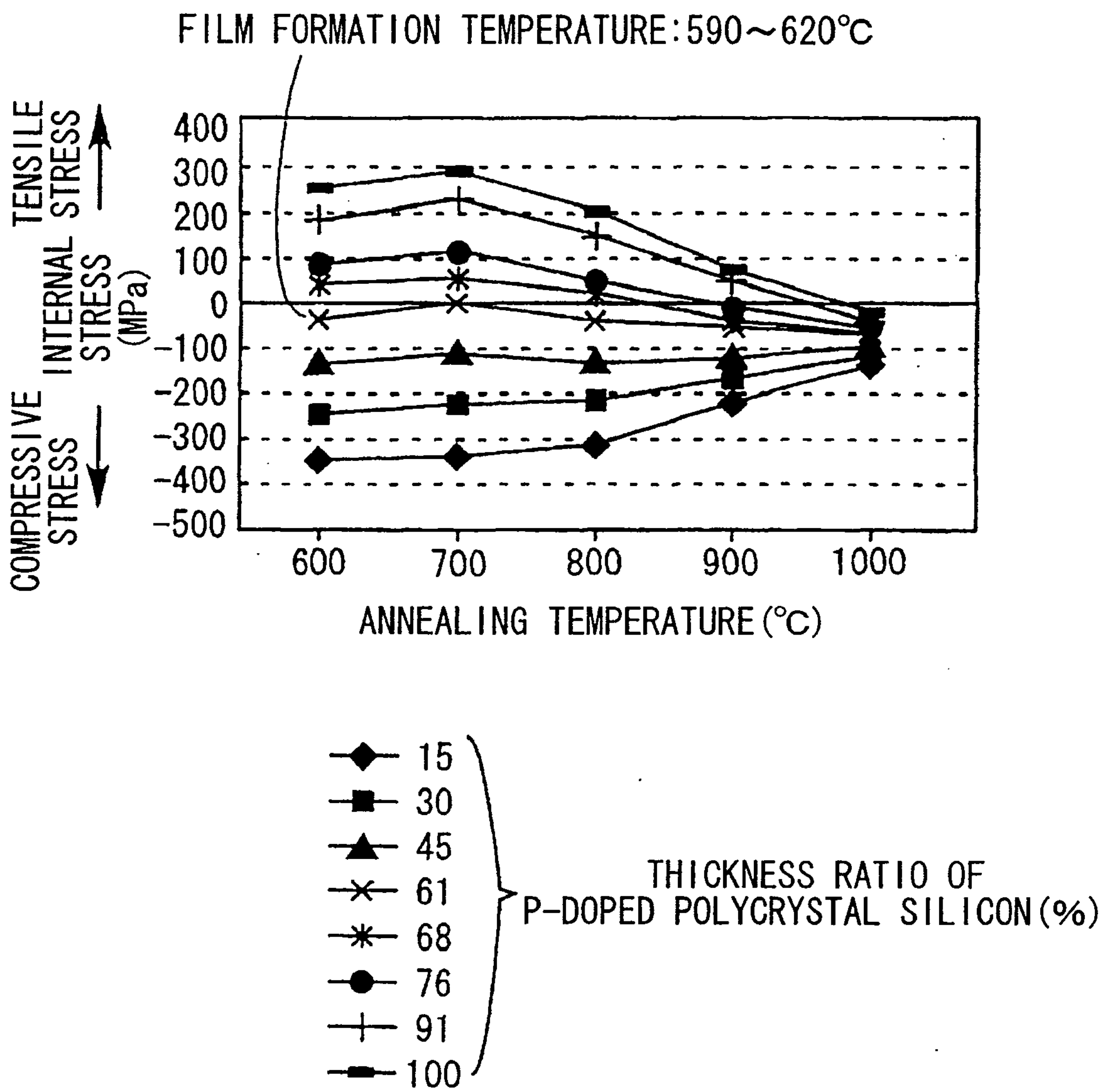
FILM FORMATION TEMPERATURE:590～620℃
TENSILE STRESS
INTERNAL STRESS (MPa)
COMPRESSIVE STRESS
400
300
200
100
0
-100
-200
-300
-400
-500
600
700
800
900
1000
ANNEALING TEMPERATURE(℃)
15
30
45
61
68
76
91
100
THICKNESS RATIO OF P-DOPED POLYCRYSTAL SILICON(%)

FIG. 22

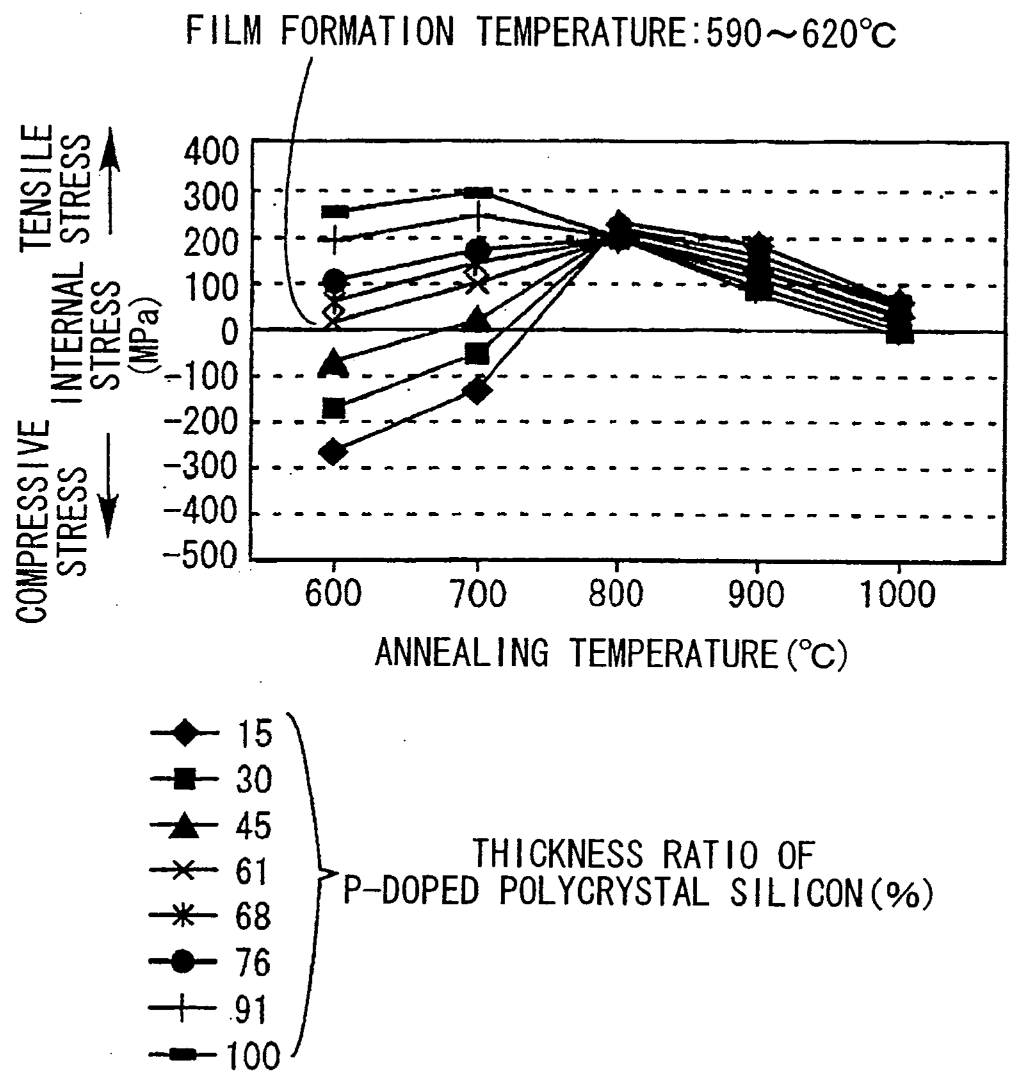
FILM FORMATION TEMPERATURE:590~620°C
TENSILE STRESS
INTERNAL STRESS (MPa)
COMPRESSIVE STRESS
400
300
200
100
0
-100
-200
-300
-400
-500
600
700
800
900
1000
ANNEALING TEMPERATURE (°C)
15
30
45
61
68
76
91
100
THICKNESS RATIO OF
P-DOPED POLYCRYSTAL SILICON(%)

FIG. 23

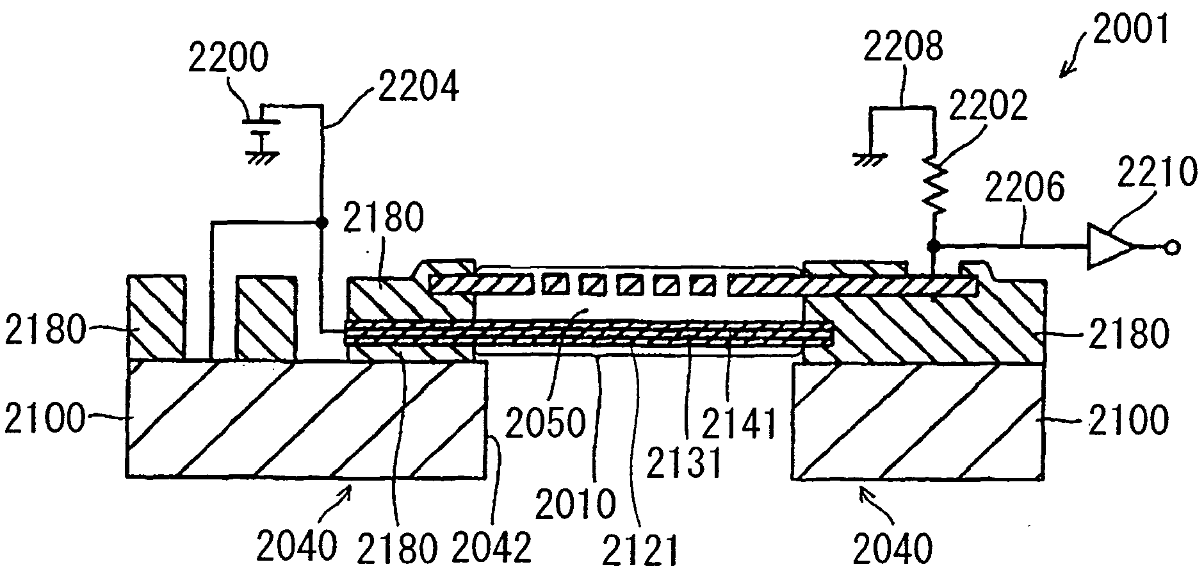
2200
2204
2208
2001
2202
2206
2210
2180
2180
2180
2100
2100
2050
2141
2131
2010
2121
2040
2180
2042
2040

FIG. 24A

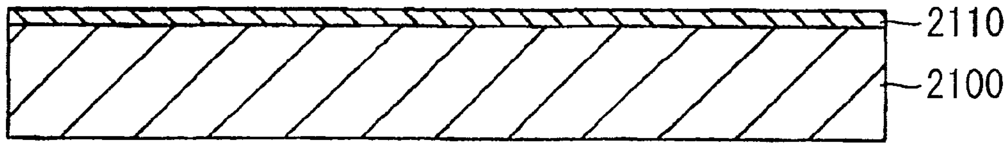


FIG. 24B

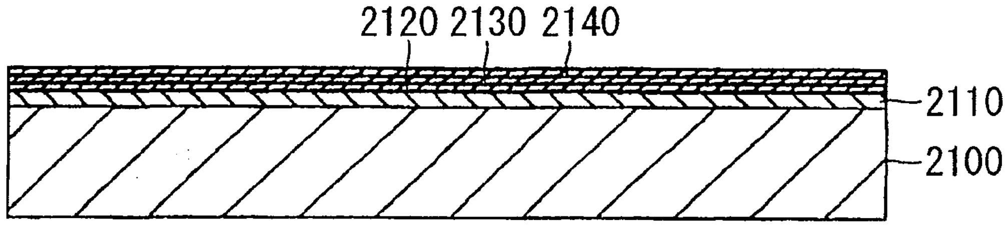


FIG. 24C

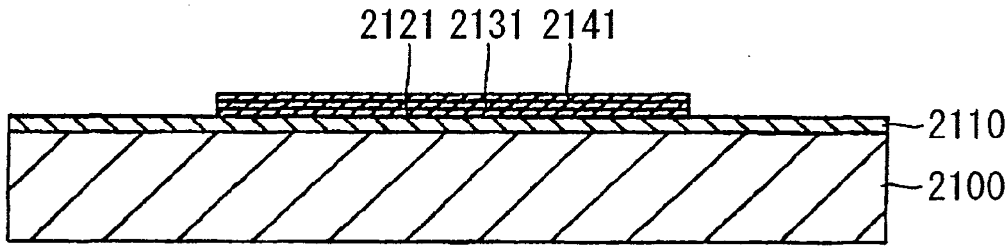


FIG. 24D

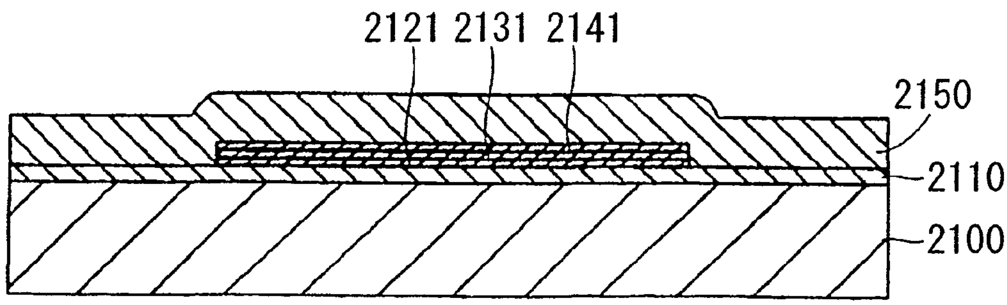

FIG. 24E

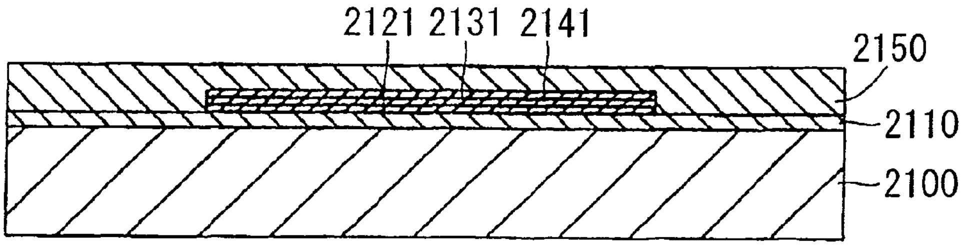


FIG. 24F

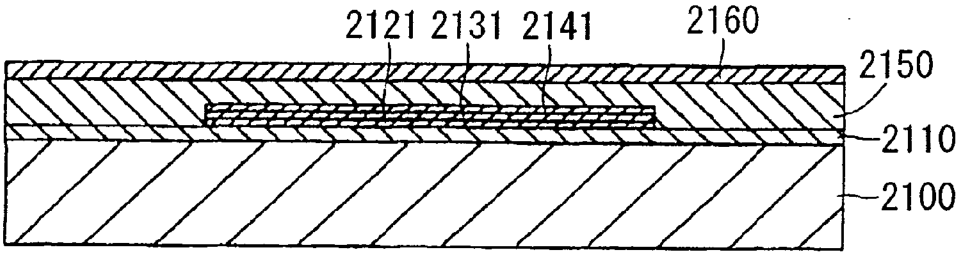


FIG. 24G

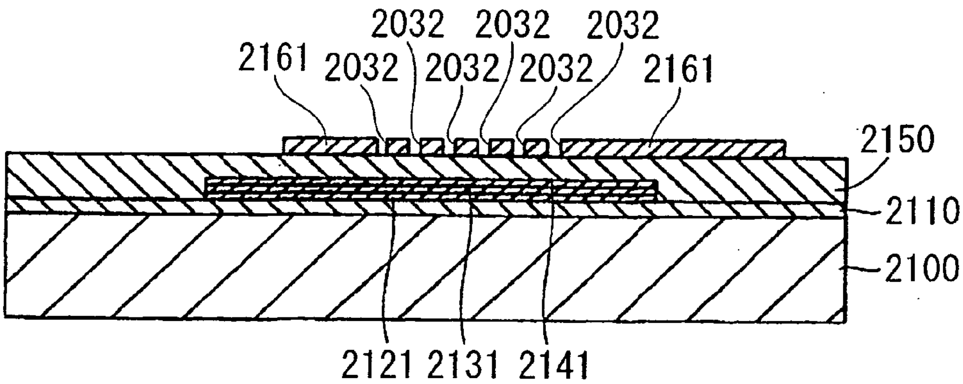


FIG. 24H

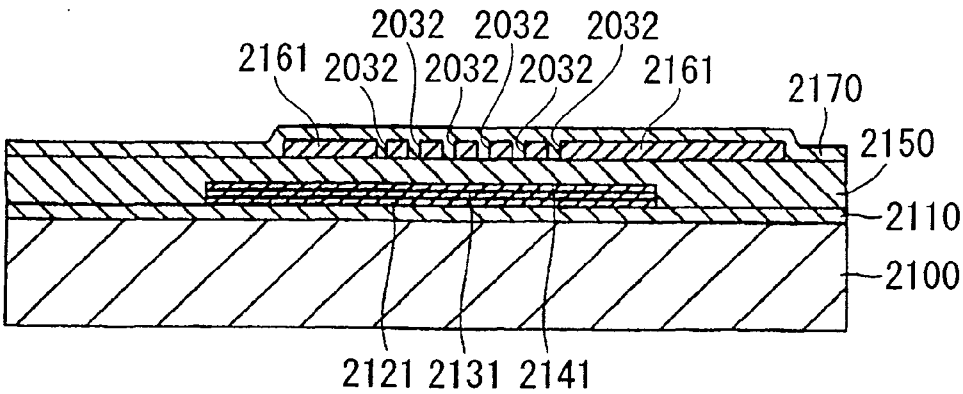

FIG. 24I

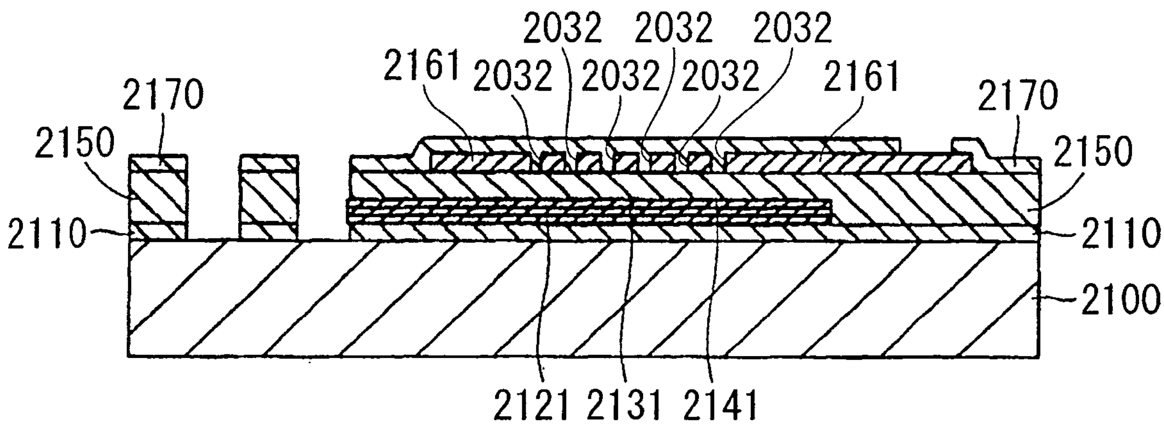


FIG. 24J

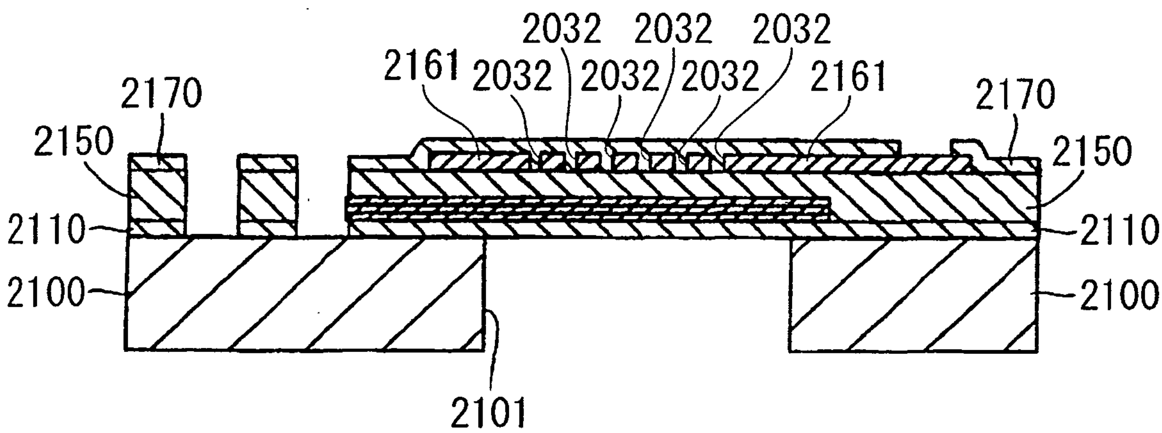


FIG. 24K

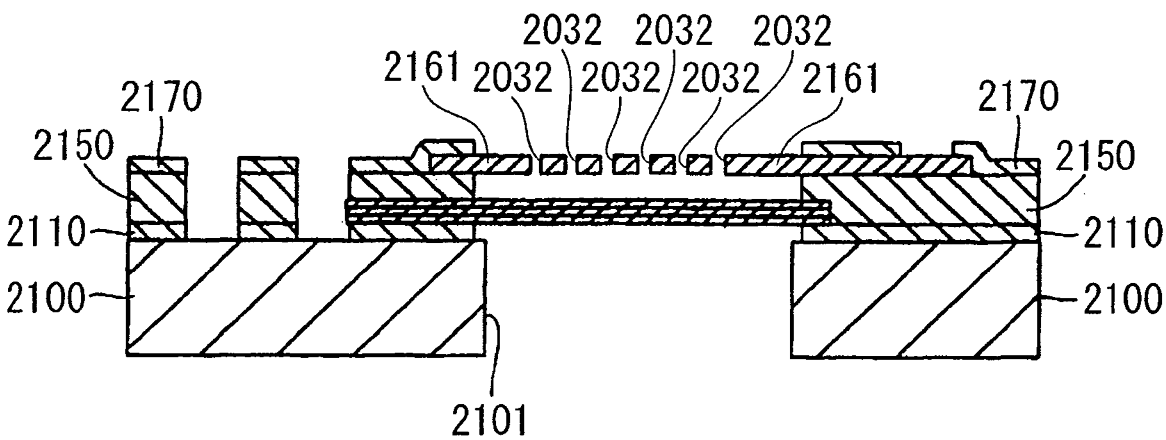

FIG. 25

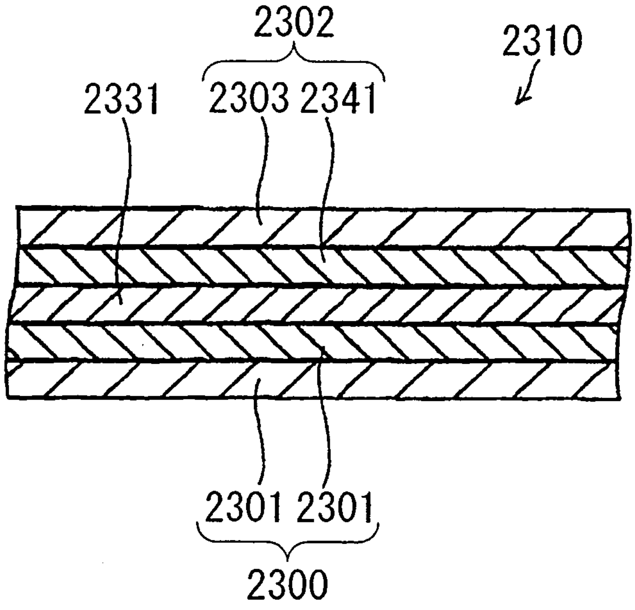
2302
2310
2331
2303 2341
2301 2301
2300

FIG. 26

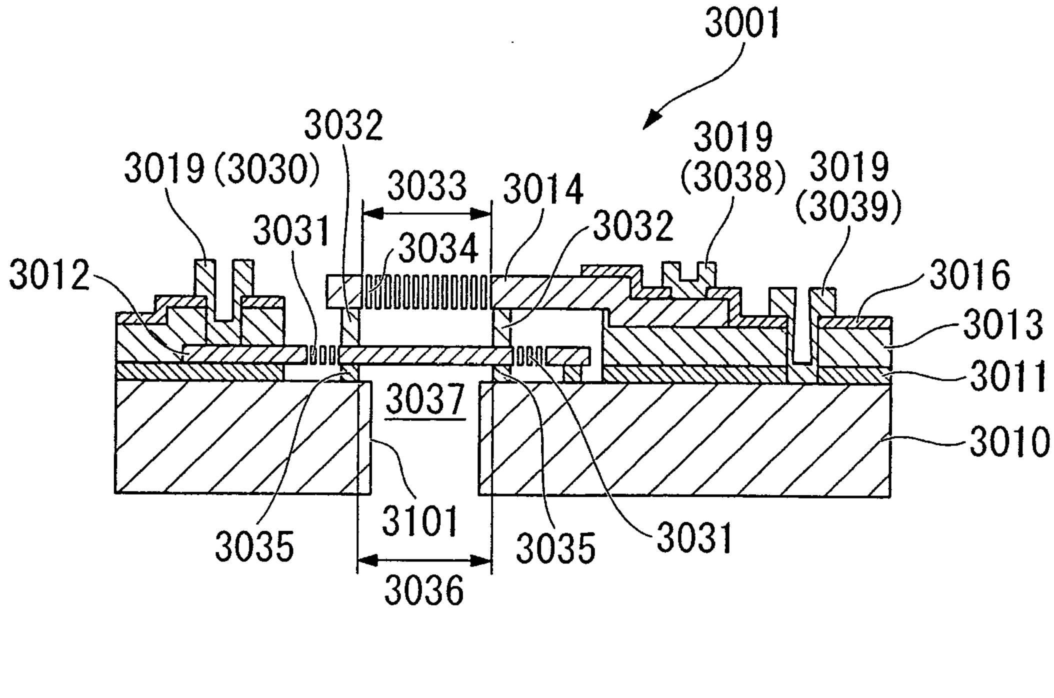
3001
3032
3019 (3030)
3033
3014
3019
(3038)
3019
(3039)
3031
3034
3032
3012
3016
3013
3011
3037
3010
3101
3035
3035
3031
3036

FIG. 27A

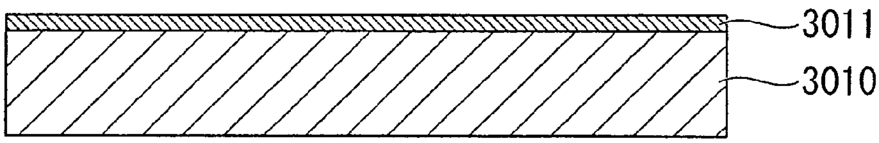


FIG. 27B

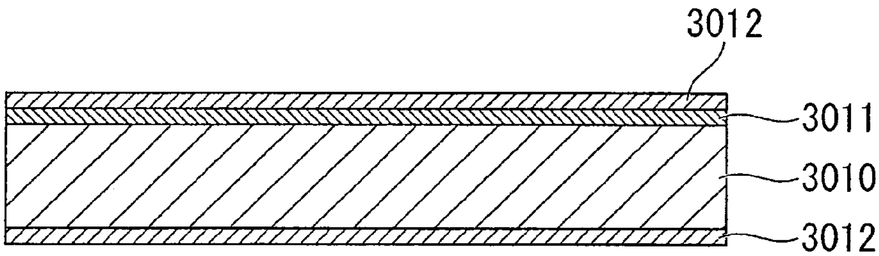


FIG. 27C

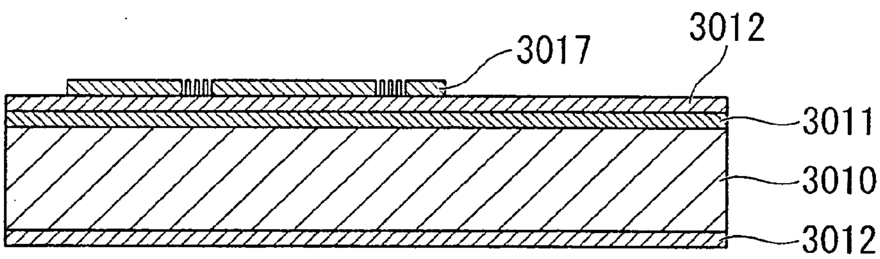


FIG. 27D

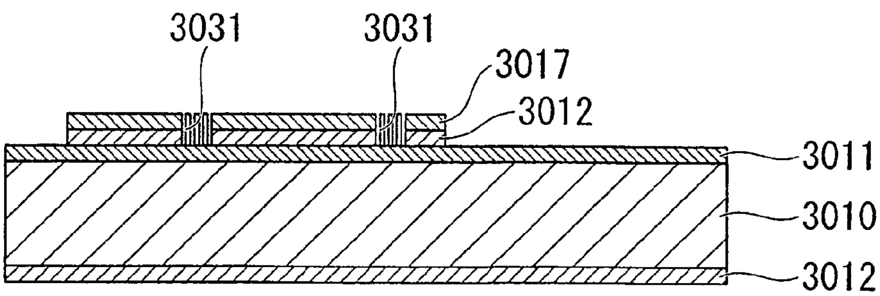

FIG. 27E

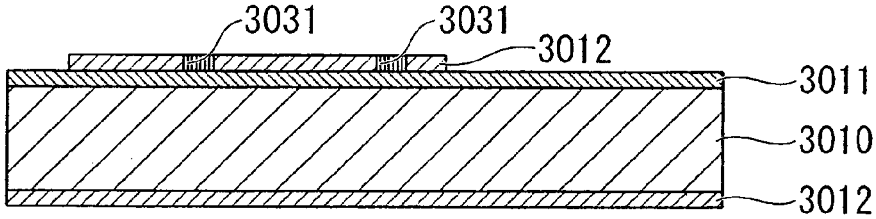


FIG. 27F

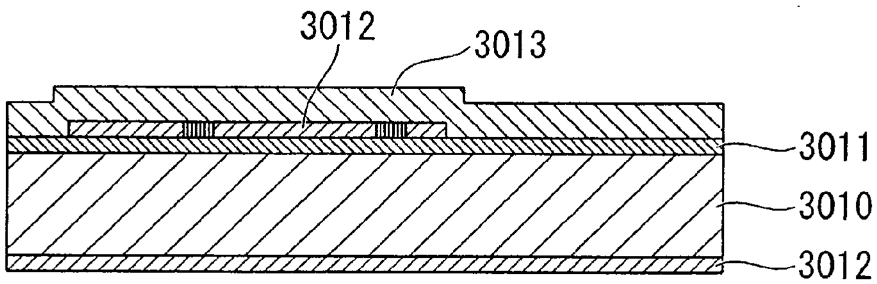


FIG. 27G

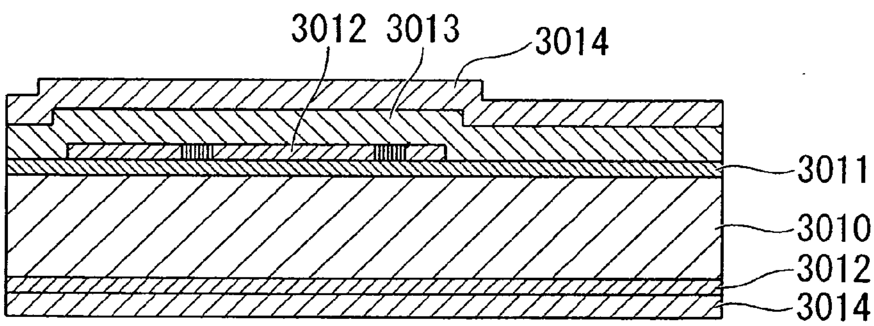


FIG. 27H

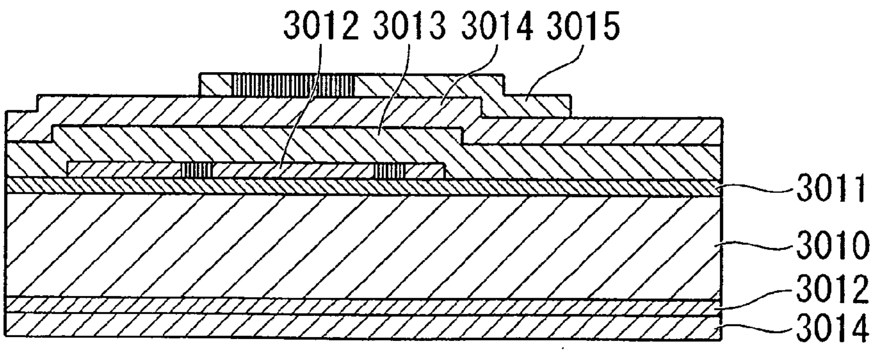

FIG. 27I

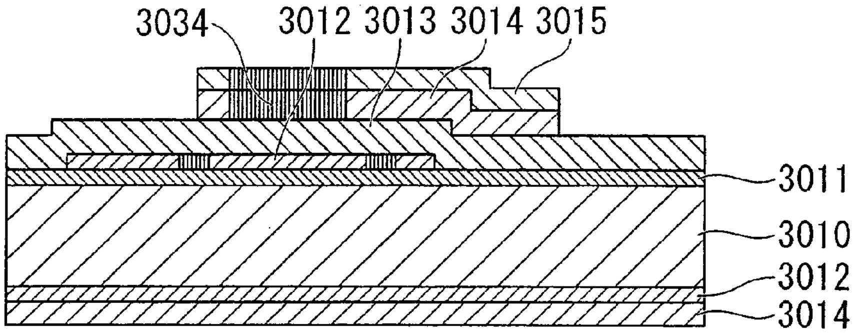


FIG. 27J

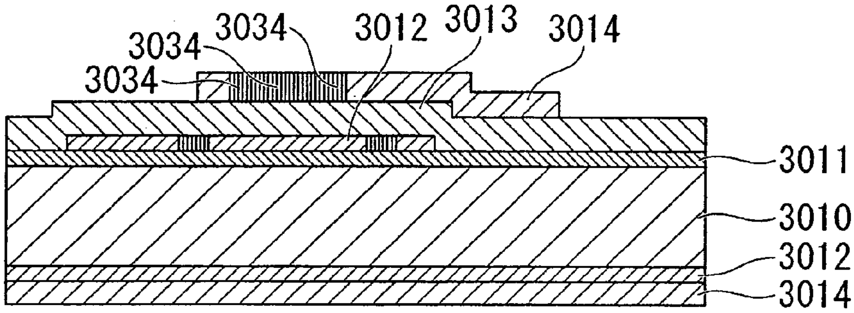


FIG. 27K

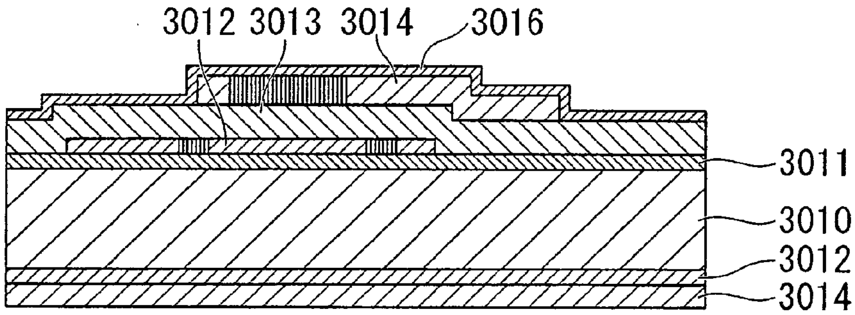


FIG. 27L

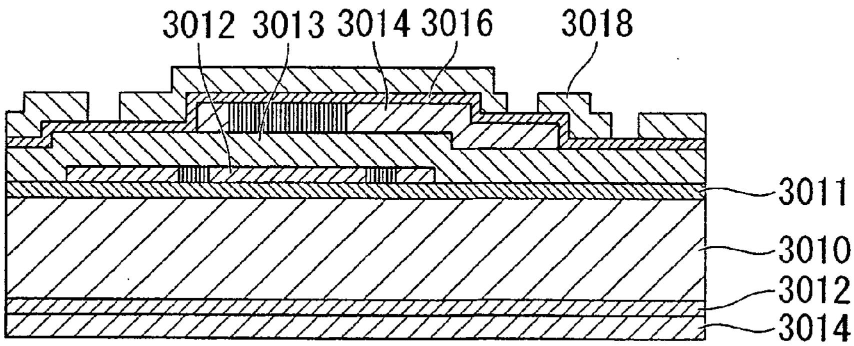

FIG. 27M

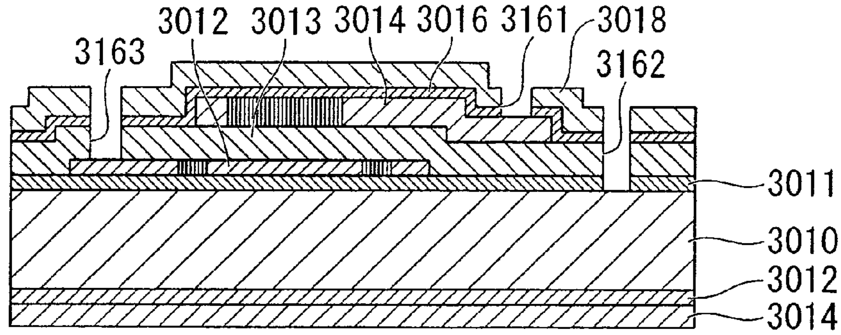


FIG. 27N

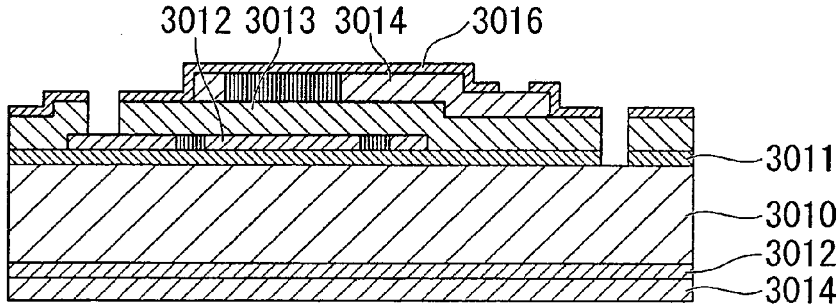


FIG. 27O

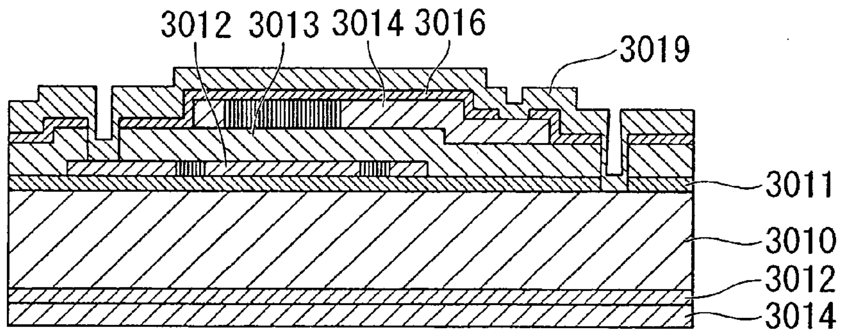


FIG. 27P

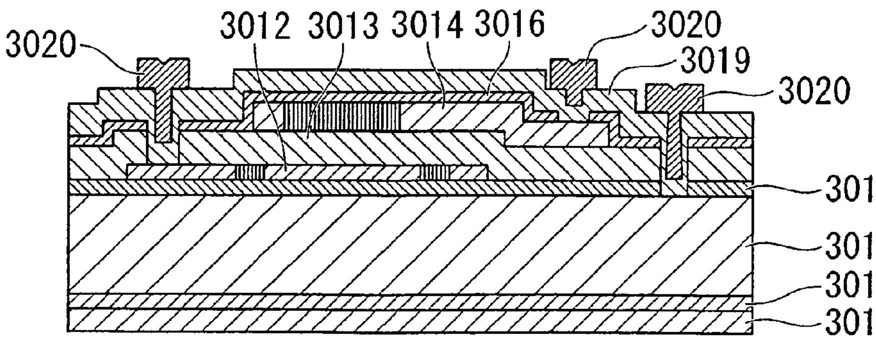

# FIG. 27Q

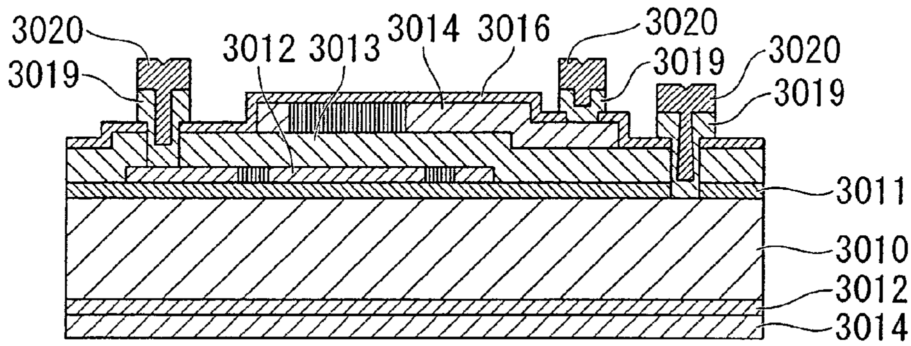


# FIG. 27R

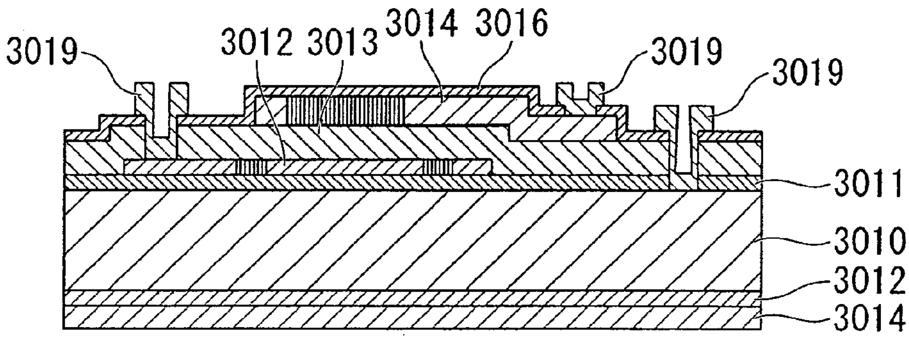


# FIG. 27S

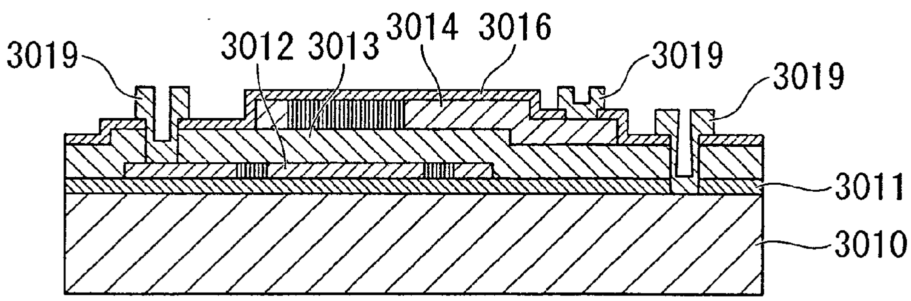


# FIG. 27T

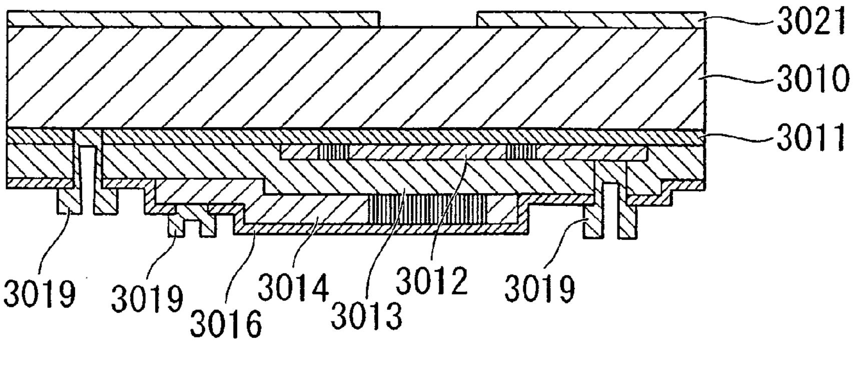

FIG. 27U

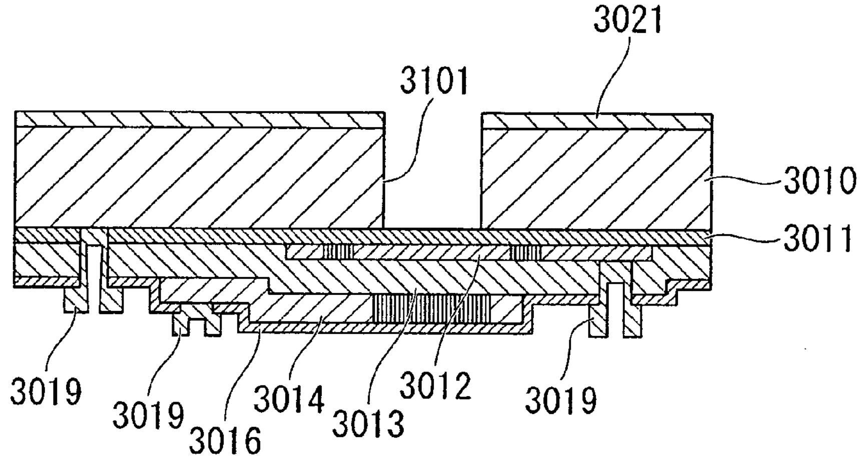


FIG. 27V

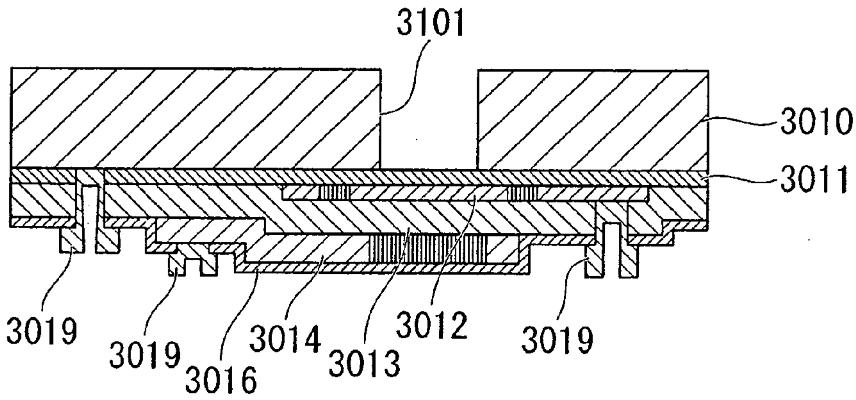


FIG. 27W

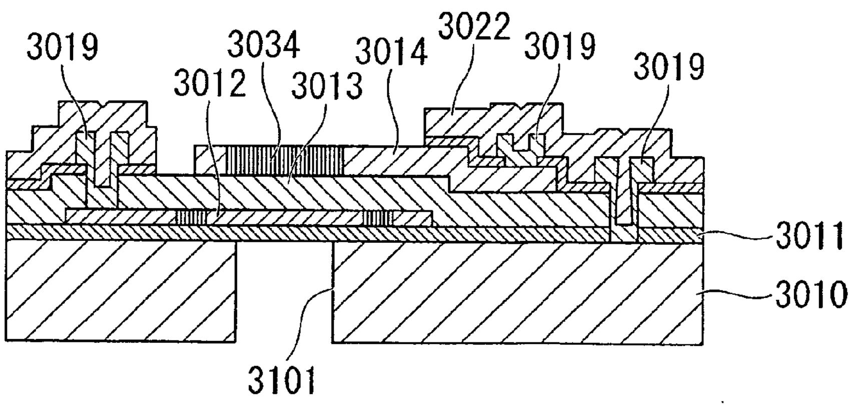

FIG. 27X

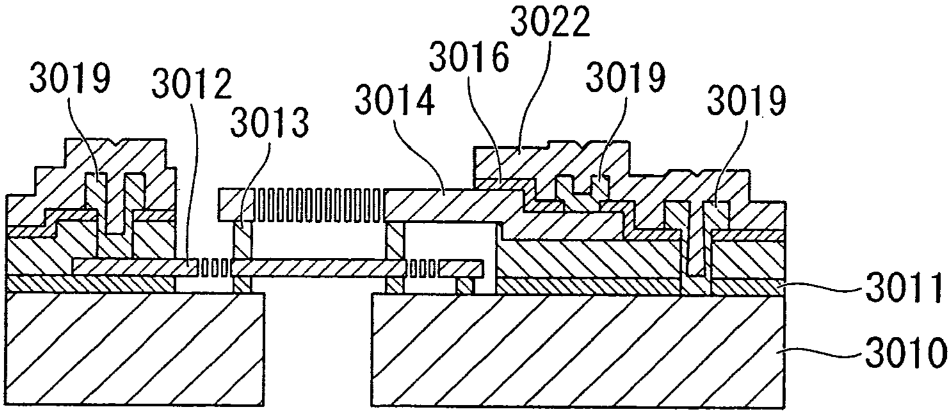


FIG. 27Y

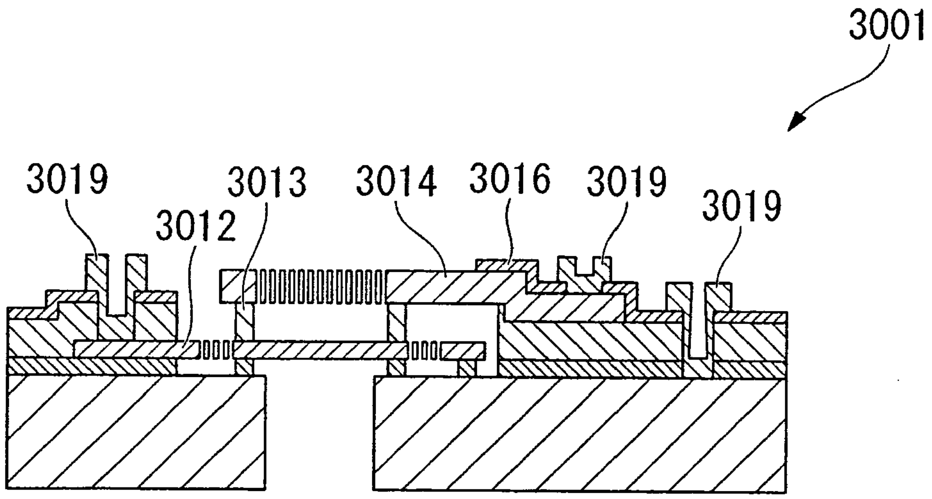

FIG. 28

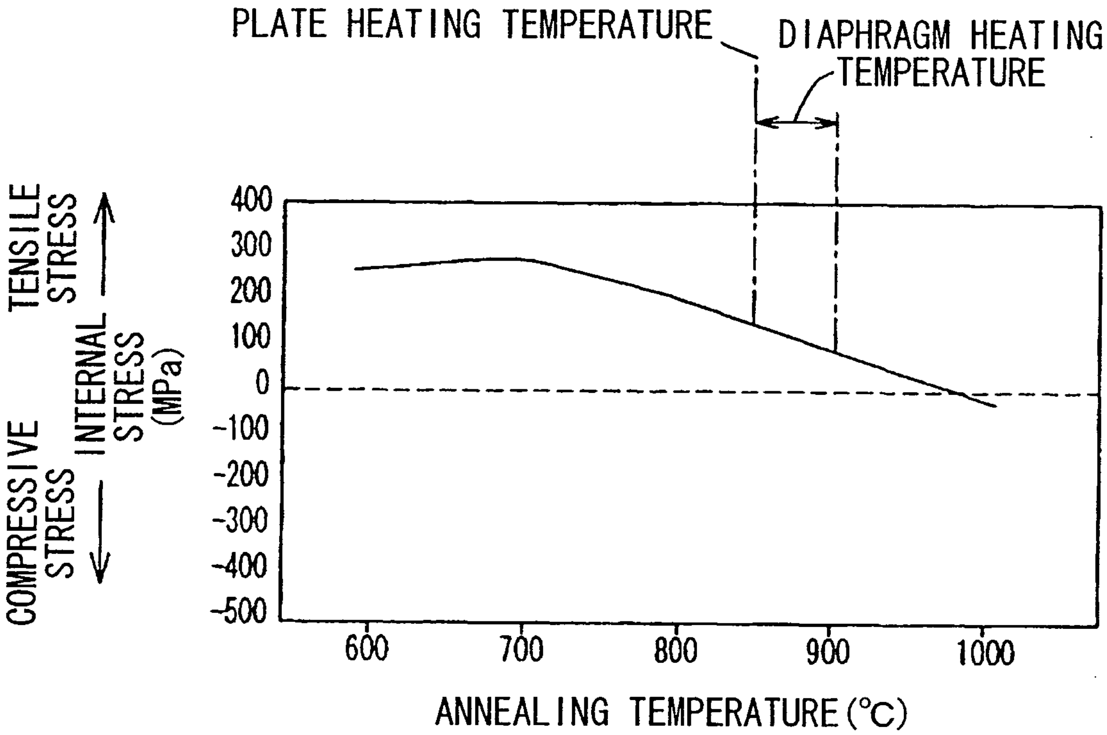
PLATE HEATING TEMPERATURE
DIAPHRAGM HEATING TEMPERATURE
TENSILE STRESS
COMPRESSIVE STRESS
INTERNAL STRESS (MPa)
400
300
200
100
0
-100
-200
-300
-400
-500
600
700
800
900
1000
ANNEALING TEMPERATURE(°C)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006089680 A
- JP 2005277377 A
- JP 2006028439 A
- JP 2006094414 A
- JP 2006224978 A
- JP 2004506394 A
- US 5452268 A
- JP 2002325298 A
- JP 2002518913 A

### Non-patent literature cited in the description

- MSS-01-34. Institute of Electric Engineers